# EUROPÄISCHE PATENTSCHRIFT

(11) **EP 4 744 465 B1**
(45) Veröffentlichungstag und Bekanntmachung des Hinweises auf die Patenterteilung: **18.11.2026**
(21) Anmeldenummer: 25720009.7
(22) Anmeldetag: 11.04.2025
(51) Int. Cl.: H10P 72/00, B23Q 7/14, B23Q 11/08, H10P 72/30

(54) **PLANARANTRIEBSSYSTEM UND VERFAHREN ZUM BETRIEB EINES PLANARANTRIEBSSYSTEMS**
PLANAR DRIVE SYSTEM AND METHOD FOR OPERATING A PLANAR DRIVE SYSTEM
SYSTÈME D'ENTRAÎNEMENT PLANAIRE ET PROCÉDÉ POUR FAIRE FONCTIONNER UN SYSTÈME D'ENTRAÎNEMENT PLANAIRE

(30) Priorität: 17.04.2024 DE 102024110738
(43) Veröffentlichungstag der Anmeldung: 20.05.2026
(73) Patentinhaber: Beckhoff Automation GmbH, 33415 Verl (DE)
(72) Erfinder: GOLZ, Daniel, 33449 Langenberg (DE); GOLZ, Michael, 33617 Bielefeld (DE)
(74) Vertreter: Patentanwaltskanzlei WILHELM & BECK
(86) Internationale Anmeldenummer: PCT/EP2025/060108
(87) Internationale Veröffentlichungsnummer: WO 2025/219278

(56) Entgegenhaltungen:
- EP-A1- 3 486 046
- EP-B1- 3 973 623
- DE-A1- 102014 109 495
- DE-A1- 102021 112 269
- US-A1- 2023 282 503

## Beschreibung

Die Erfindung betrifft ein Planarantriebssystem mit einer Planarmotorantriebseinrichtung und einer Bearbeitungsstation sowie ein Verfahren zum Betrieb des Planarantriebssystems.

Die Patentanmeldung beansprucht die Priorität der deutschen Patentanmeldung 10 2024 110 738.3.

Aus der DE 10 2021 112 269 A1 ist ein Planarantriebssystem mit einem Läufer und einer Vakuumschleuse bekannt. Das Statormodul weist eine Statoreinheit mit wenigstens einer Spulenanordnung auf, wobei die Spulenanordnung bestromt werden kann und eingerichtet ist, aufgrund der Bestromung ein Statormagnetfeld oberhalb einer Statorfläche zu erzeugen. Der Läufer und das Statormagnetfeld stehen in einer magnetischen Wechselwirkung und der Läufer wird oberhalb der Statorfläche bewegt. Die Vakuumschleuse weist mehrere Vakuumkammern auf, wobei zwischen den Vakuumkammern jeweils ein Tor angeordnet ist, das die Vakuumkammer abdichtet. Das Tor wird zwischen einer ersten Position und einer zweiten Position bewegt, wobei in der zweiten Position das Tor zwischen zwei Statormodule eingreift. In der ersten Position ist das Tor weit beabstandet zu der Statorfläche angeordnet, um eine Durchfahrt des Läufers unter dem Tor zu ermöglichen.

Aus US 2023 / 0 170 239 A1 ist eine Vorrichtung zum Überführen eines Substrats in eine Substratverarbeitungskammer bekannt.

Aus DE 10 2014 109 495 A1 ist eine Vorrichtung zum Bereitstellen eines Übergangs zwischen einem ersten Bereich und einem mit Hilfe einer Wand von dem ersten Bereich hermetisch abgegrenzten zweiten Bereich bekannt.

Aus EP 3 973 623 B1 ist ferner eine Anordnung von Statormodulen für ein Planarantriebssystem bekannt.

Des Weiteren ist aus EP 3 486 046 A1 eine Werkstück-Schleuse für eine Vorrichtung zum Handhaben und/oder Bearbeiten von Werkstücken bekannt.

Aus US 2023/282503 A1 ist ein in Substrat-Verarbeitungssystem mit mehreren Modulen mit Bearbeitungskammern, einer Transferkammer, einem zweigliedrigen Substrat-Transfergerät, das jedes Glied unabhängig linear verschieben und schwenken kann, sowie einem Controller bekannt, der beide Glieder gleichzeitig parallel bewegt, sodass ein Substrat von einem Modul zum anderen ausgetauscht werden kann.

Es ist Aufgabe der Erfindung, ein verbessertes Planarantriebssystem und ein verbessertes Verfahren zum Betrieb des Planarantriebssystems bereitzustellen.

Diese Aufgabe wird mittels eines Planarantriebssystems gemäß Patentanspruch 1 und mittels eines Verfahrens gemäß Patentanspruch 11 zum Betrieb des Planarantriebssystems gelöst. Vorteilhafte Ausführungsformen sind in den abhängigen Ansprüchen angegeben.

Es wurde erkannt, dass ein verbessertes Planarantriebssystem dadurch bereitgestellt werden kann, dass das Planarantriebssystem eine Planarmotorantriebseinrichtung und eine Bearbeitungsstation aufweist. Die Planarmotorantriebseinrichtung weist eine Statormodulanordnung mit wenigstens einem ersten Statormodul und wenigstens einer an der Statormodulanordnung angeordneten und durch die Statormodulanordnung antreibbaren ersten Fördereinrichtung auf. Die Bearbeitungsstation weist wenigstens ein Gehäuse, wenigstens eine erste Schleuseneinheit sowie eine Bearbeitungseinheit auf. Die Bearbeitungsstation ist an der Statormodulanordnung angeordnet und die Statormodulanordnung und die Bearbeitungsstation umschließen einen gegenüber einem Transportbereich abgetrennten Arbeitsraum, wobei die erste Schleuseneinheit ein erstes Schleusengehäuse und eine in dem ersten Schleusengehäuse um eine erste Drehachse drehbar gelagerte erste Schleusenglocke aufweist. Das erste Schleusengehäuse weist eine dem Transportbereich zugewandte erste Gehäuseöffnung und eine dem Arbeitsraum zugewandte und beabstandet zu der ersten Gehäuseöffnung angeordnete zweite Gehäuseöffnung auf. Die erste Schleusenglocke umschließt innenseitig einen ersten Schleusenraum zumindest abschnittsweise, in dem die Fördereinrichtung vollständig anordenbar ist, und weist eine einseitig angeordnete erste Schleusenöffnung auf. Die erste Schleusenglocke ist zwischen einem ersten Positionsbereich und einem in Umfangsrichtung um die erste Drehachse verdrehten zweiten Positionsbereich verdrehbar, wobei in dem ersten Positionsbereich der ersten Schleusenglocke die erste Schleusenöffnung der ersten Gehäuseöffnung zugewandt ist und der erste Schleusenraum ausschließlich über die erste Gehäuseöffnung zum Transportbereich hin geöffnet ist. In dem zweiten Positionsbereich der ersten Schleusenglocke ist die erste Schleusenöffnung der zweiten Gehäuseöffnung zugewandt und der erste Schleusenraum ausschließlich über die zweite Gehäuseöffnung zum Arbeitsraum hin geöffnet, wobei eine erste Position innerhalb des ersten Positionsbereichs und eine zweite Position innerhalb des zweiten Positionsbereich angeordnet ist, wobei in der ersten Position die erste Fördereinrichtung zwischen dem ersten Schleusenraum und dem Transportbereich bewegbar ist. In der zweiten Position ist die erste Fördereinrichtung zwischen dem ersten Schleusenraum und dem Arbeitsraum bewegbar. Unabhängig von einer Ausrichtung der ersten Schleusenglocke in Umfangsrichtung um die erste Drehachse trennt die erste Schleusenglocke den Arbeitsraum vom Transportbereich ab.

Diese Ausgestaltung hat den Vorteil, dass beispielsweise Emissionen, die in dem Arbeitsraum entstehen können, an einem Austritt aus dem Arbeitsraum in den Transportbereich durch die erste Schleusenglocke gehindert werden. Dadurch wird eine weitere Verschmutzung der Statoranordnung im Transportbereich vermieden.

Da der Austritt von Emissionen bauartbedingt unabhängig von der Ausrichtung der ersten Schleusenglocke, insbesondere der ersten Schleusenöffnung um die Drehachse sichergestellt ist, kann auf eine aufwändige Sensorik an der Schleuseneinheit verzichtet werden. Dadurch ist erste Schleuseneinheit besonders einfach aufgebaut.

Ferner kann durch die zwischen der ersten Drehachse und dem ersten Positionsbereich und dem zweiten Positionsbereich verdrehbare Schleusenglocke sichergestellt werden, dass die Schleusenglocke sehr verschleißarm zwischen den beiden Positionen und/oder Positionsbereichen verstellt werden kann. Dadurch können lange Wartezeiten an der ersten Schleuseneinheit vermieden werden.

Ferner kann auf ein Aufsitzen der ersten Schleusenglocke direkt auf der Statormodulanordnung verzichtet werden, sodass eine Beschädigung der Statormodulanordnung durch beispielsweise ein Reiben der Schleusenglocke an der Statormodulanordnung vermieden werden kann.

In einer weiteren Ausführungsform weist die Bearbeitungseinheit wenigstens ein Bearbeitungsmodul auf, das zumindest abschnittsweise in dem Arbeitsraum angeordnet ist, wobei das Bearbeitungsmodul ausgebildet ist, ein mittels der ersten Fördereinrichtung transportiertes Werkstück zu bearbeiten, wobei die erste Schleuseneinheit und das Gehäuse ausgebildet sind, bei der Bearbeitung entstehende Emissionen zumindest teilweise in dem Arbeitsraum unabhängig von der Ausrichtung der ersten Schleusenglocke um die erste Drehachse zu halten. Dadurch eignet sich das Planarantriebssystem besonders im Einsatz in einer Umgebung mit hohen Anforderungen an die dort herrschende Atmosphäre, wie beispielsweise im Reinraum oder in der Lebensmittelproduktion.

In einer weiteren Ausführungsform weist das Bearbeitungsmodul wenigstens ein Sendemodul zur Aussendung hochenergetischer elektromagnetischer Strahlung, insbesondere Laserstrahlung, auf. Die Bearbeitungseinheit ist ausgebildet, ein an der ersten Fördereinrichtung anordenbares Werkstück mit der elektromagnetischen Strahlung zu bearbeiten. Die erste Schleusenglocke blockiert sowohl in der ersten Position als auch in der zweiten Position einen Austritt der elektromagnetischen Strahlung hin zum Transportbereich. Insbesondere kann dadurch eine Lasersicherheit erzielt werden, ohne dass dabei eine Sensorik einzusetzen ist, bei der geprüft wird, ob die Bearbeitungseinheit gegenüber dem Transportbereich und somit der Arbeitsraum gegenüber dem Transportbereich abgeschottet ist. Die Ausgestaltung der ersten Schleuseneinheit stellt dies in jeglichem Zustand bzw. in jeder Position der Schleusenglocke sicher. Selbst bei einer Fehlfunktion der ersten Schleuseneinheit, beispielsweise einem Blockieren der ersten Schleusenglocke, wird der Austritt der elektromagnetischen Strahlung aus dem Arbeitsraum in den Transportbereich durch die (defekte) erste Schleusenglocke blockiert.

In einer weiteren Ausführungsform weist das erste Schleusengehäuse eine Unterseite auf, wobei die Unterseite an der Statormodulanordnung anliegt. Zwischen der Unterseite und der ersten Gehäuseöffnung weist das Gehäuse einen ersten Gehäusesteg auf. Der erste Gehäusesteg begrenzt auf der zur Unterseite zugewandten Seite die erste Gehäuseöffnung. Zusätzlich oder alternativ kann das Gehäuse zwischen der Unterseite und der zweiten Gehäuseöffnung einen zweiten Gehäusesteg aufweisen, wobei der zweite Gehäusesteg auf der zur Unterseite zugewandten Seite die zweite Gehäuseöffnung begrenzt. Der erste Gehäusesteg und der zweite Gehäusesteg haben den Vorteil, dass das Gehäuse auf der zur Statormodulanordnung zugewandten Seite stabil ausgebildet ist und eine definierte Anlagefläche zur Anlage des Gehäuses an der Statormodulanordnung sichergestellt ist. Die definierte Anlagefläche verhindert einen Austritt der elektromagnetischen Strahlung zwischen der Unterseite und der Statormodulanordnung, sodass auch an dieser Seite beispielsweise die Lasersicherheit sichergestellt ist.

Ferner hat diese Ausgestaltung den Vorteil, dass in demontiertem Zustand der ersten Schleuseneinheit das Gehäuse steif ausgebildet ist und eine ungewollte Beschädigung des Gehäuses und/oder der im Gehäuse angeordneten ersten Schleusenglocke vermieden wird.

In einer weiteren Ausführungsform weist das erste Schleusengehäuse eine erste Führungsnut auf, wobei sich die erste Führungsnut auf einer Kreisbahn um die erste Drehachse erstreckt. Die erste Führungsnut ist auf der der ersten Schleusenglocke zugewandten Seite offen ausgebildet, wobei die erste Schleusenglocke abschnittsweise in die erste Führungsnut eingreift. Im Bereich des Eingriffs bildet die erste Schleusenglocke zusammen mit der ersten Führungsnut eine Art Labyrinthdichtung aus, die sowohl als Dichtung für die elektromagnetische Strahlung als auch zusätzlich als fluidische Abdichtung des Arbeitsraums gegenüber dem Transportbereich im Bereich der Schleusenglocke wirkt. Zusätzlich kann ein Kippen der ersten Schleusenglocke um eine Achse senkrecht zur ersten Drehachse durch ein umfangsseitiges Anschlagen der ersten Schleusenglocke in der ersten Führungsnut vermieden werden. Dadurch kann eine ungewollte Beschädigung beispielsweise beim Transport einer Lagerung der Schleusenglocke vermieden werden. Ferner kann die Lagerung der ersten Schleusenglocke konstruktiv besonders einfach ausgebildet sein und beispielsweise durch ein einreihiges Kugellager ausgebildet sein.

Dabei ist von besonderem Vorteil, wenn sich die erste Führungsnut zumindest abschnittsweise entlang des ersten Gehäusestegs auf einer zur ersten Gehäuseöffnung zugewandten Seite des ersten Gehäusestegs erstreckt. Zusätzlich oder alternativ kann sich die erste Führungsnut ferner auch entlang des zweiten Gehäusestegs auf einer der zweiten Gehäuseöffnung zugewandten Seite des zweiten Gehäusestegs erstrecken. Dabei wird der Eintritt der elektromagnetischen Strahlung insbesondere im Bereich der ersten Gehäuseöffnung bzw. der zweiten Gehäuseöffnung durch den Eingriff eines Teilabschnitts der ersten Schleusenglocke in die erste Führungsnut und der Ausbildung der Labyrinthdichtung vermieden.

In einer weiteren Ausführungsform weist die Bearbeitungsstation eine zweite Schleuseneinheit auf, wobei die zweite Schleuseneinheit versetzt zu der ersten Schleuseneinheit angeordnet ist. Die zweite Schleuseneinheit weist ein zweites Schleusengehäuse und eine in dem zweiten Schleusengehäuse um eine zweite Drehachse drehbar gelagerte zweite Schleusenglocke auf. Das zweite Schleusengehäuse weist eine dem Transportbereich zugewandte dritte Gehäuseöffnung und eine dem Arbeitsraum zugewandte und beabstandet zu der dritten Gehäuseöffnung angeordnete vierte Gehäuseöffnung auf. Die zweite Schleusenglocke umschließt innenseitig einen zweiten Schleusenraum zumindest abschnittsweise, in dem die erste Fördereinrichtung vollständig anordenbar ist, und weist eine einseitig angeordnete zweite Schleusenöffnung auf. Die zweite Schleusenglocke ist zwischen einem dritten Positionsbereich und einem in Umfangsrichtung um die zweite Drehachse verdrehten vierten Positionsbereich verdrehbar, wobei in dem dritten Positionsbereich der zweiten Schleusenglocke die zweite Schleusenöffnung der dritten Gehäuseöffnung zugewandt ist und der zweite Schleusenraum ausschließlich über die dritte Gehäuseöffnung zum Transportbereich hin geöffnet ist.

In dem vierten Positionsbereich der zweiten Schleusenglocke ist die zweite Schleusenöffnung der vierten Gehäuseöffnung zugewandt und der zweite Schleusenraum ausschließlich über die vierte Gehäuseöffnung zum Arbeitsraum hin geöffnet, wobei eine dritte Position innerhalb des dritten Positionsbereichs und eine vierte Position innerhalb des vierten Positionsbereichs angeordnet ist. In der dritten Position ist die erste Fördereinrichtung zwischen dem zweiten Schleusenraum und dem Transportbereich bewegbar, wobei in der vierten Position die erste Fördereinrichtung zwischen dem zweiten Schleusenraum und dem Arbeitsraum bewegbar ist. Unabhängig von einer Ausrichtung der zweiten Schleusenglocke in Umfangsrichtung um die zweite Drehachse trennt die zweite Schleusenglocke den Arbeitsraum vom Transportbereich ab. Diese Ausgestaltung hat den Vorteil, dass auch bei zwei Schleuseneinheiten der Austritt von Emissionen aus dem Arbeitsraum durch die jeweilige Schleusenglocke verhindert wird. Ferner kann die erste Schleuseneinheit beispielsweise zum Einschleusen der ersten Fördereinrichtung und die zweite Schleuseneinheit zum Ausschleusen der ersten Fördereinrichtung verwendet werden, sodass eine hohe Stückzahl pro Zeiteinheit in der Bearbeitungsstation sichergestellt ist.

In einer weiteren Ausführungsform sind die erste Schleuseneinheit und die zweite Schleuseneinheit nebeneinander angeordnet, wobei der Arbeitsraum in einen ersten Wartebereich und einen versetzt zum ersten Wartebereich angeordneten ersten Arbeitsbereich unterteilt ist. Der erste Wartebereich ist anschließend an die erste Schleuseneinheit und der erste Arbeitsbereich ist an der Bearbeitungseinheit angeordnet. Durch die Verwendung von zwei Schleuseneinheiten kann in Art einer Schleife die erste Fördereinrichtung durch die Bearbeitungsstation geführt werden, wobei zum Beispiel über die erste Schleuseneinheit die erste Fördereinrichtung hin zu dem ersten Wartebereich und vom ersten Wartebereich über den ersten Arbeitsbereich geführt wird. Dadurch dass der erste Wartebereich vorgesehen ist, kann die erste Fördereinrichtung bereits im Arbeitsraum vorgehalten werden und die erste Fördereinrichtung kann bis zur möglichen Bearbeitung des Werkstücks im ersten Arbeitsbereich beabstandet zu der Bearbeitungseinheit die notwendige Zeit abwarten. Durch die Ausschleusung der ersten Fördereinrichtung über die zweite Schleuseneinheit kann eine Taktrate erhöht werden und die Bearbeitungseinheit besonders effektiv zur Bearbeitung der mittels der ersten Fördereinrichtung zugeführten Werkstücke genutzt werden.

Von besonderem Vorteil ist ferner, wenn die erste Schleuseneinheit eine Kamera aufweist. Beispielsweise kann die Kamera auf der zum ersten Schleusenraum zugewandten Seite der ersten Schleusenglocke angeordnet sein. Ein Erfassungsbereich der Kamera ist in Richtung des ersten Schleusenraums gerichtet. Diese Ausgestaltung hat den Vorteil, dass beispielsweise eine Ausrichtung des Werkstücks in der ersten Schleuseneinheit und/oder ein Ergebnis der Bearbeitung mittels der Bearbeitungseinheit beim Ein- oder Ausschleusen überprüft werden kann.

In einer weiteren Ausführungsform weist die erste Schleuseneinheit wenigstens eine Dichtung auf, wobei die Dichtung in einem Spalt zwischen der ersten Schleusenglocke und dem ersten Schleusengehäuse angeordnet ist. Die Dichtung ist ausgebildet, den Arbeitsraum gegenüber dem Transportbereich zumindest abschnittsweise fluidisch abzudichten. Dabei kann vorzugsweise die Dichtung aufblasbar ausgebildet sein, um ein besonders gutes Anliegen der Dichtung an der ersten Schleusenglocke zu ermöglichen. Dadurch kann der Arbeitsbereich besonders gut abgedichtet werden, sodass beispielsweise der Arbeitsraum vakuumiert oder mit einem Unterdruck beaufschlagt werden kann, ohne dass über die erste Schleuseneinheit ein zu großer Volumenstrom eines Gases aus dem Transportbereich nachströmt.

In einer weiteren Ausführungsform ist die erste Schleusenglocke in einen Zwischenpositionsbereich zwischen dem ersten Positionsbereich und dem zweiten Positionsbereich um die erste Drehachse verdrehbar, wobei in dem Zwischenpositionsbereich die erste Schleusenglocke auf der zum Arbeitsraum zugewandten Seite den ersten Schleusenraum gegenüber dem Arbeitsraum und auf der zum Transportbereich zugewandten Seite den ersten Schleusenraum gegenüber dem Transportbereich verschließt. Diese Ausgestaltung hat den Vorteil, dass auch in der Zwischenposition ein Austritt der elektromagnetischen Strahlung über die erste und zweite Gehäuseöffnung durch die Schleusenglocke blockiert ist. Ferner kann in der Zwischenposition beispielsweise ohne Einfluss beispielsweise der elektromagnetischen Strahlung die Kamera auch das Werkstück erfassen und beispielsweise störungsfrei auswerten.

Ein verbessertes Verfahren zum Betrieb des Planarantriebssystems kann dadurch bereitgestellt werden, dass das oben beschriebene Planarantriebssystem bereitgestellt wird. Das erste Statormodul wird bestromt und magnetisch mit der ersten Fördereinrichtung zum Antrieb der ersten Fördereinrichtung gekoppelt. Die erste Fördereinrichtung wird im Transportbereich angeordnet und mit einem Werkstück bestückt. Die erste Schleusenglocke wird um die erste Drehachse in die erste Position gedreht. Die erste Fördereinrichtung wird in der ersten Position aus dem Transportbereich in den ersten Schleusenraum bewegt. Die erste Schleusenglocke wird um die erste Drehachse in die zweite Position gedreht, wobei die erste Fördereinrichtung aus dem ersten Schleusenraum in den Arbeitsraum und an die Bearbeitungseinheit bewegt wird. Die Bearbeitungseinheit bearbeitet das Werkstück. Diese Ausgestaltung hat den Vorteil, dass während der Bearbeitung des Werkstücks auch in der zweiten Position der ersten Schleusenglocke keine elektromagnetische Strahlung aus dem Arbeitsraum in den Transportbereich dringt. Ferner hat die Verdrehung der ersten Schleuseneinheit den Vorteil, dass die erste Schleuseneinheit besonders schnell verstellt werden kann.

In einer weiteren Ausführungsform wird das Bearbeitungsmodul aktiviert und das Werkstück bearbeitet, wobei die erste Schleuseneinheit unabhängig von der Verdrehung der ersten Schleusenglocke um die erste Drehachse bei der Bearbeitung des Werkstücks anfallende Emissionen zumindest teilweise an einem Austreten, insbesondere einem direkten Austreten, aus dem Arbeitsraum in den Transportbereich hindert.

In einer weiteren Ausführungsform wird die Bearbeitungseinheit aktiviert und das Sendemodul sendet hochenergetische elektromagnetische Strahlung aus. Die hochenergetische elektromagnetische Strahlung wird auf das Werkstück zur Bearbeitung gerichtet, wobei insbesondere das Werkstück mit der hochenergetischen elektromagnetischen Strahlung graviert und/oder verschweißt und/oder verlötet wird. Diese Ausgestaltung hat den Vorteil, dass bei der Bearbeitung entstehende Emissionen aus dem Arbeitsraum einfach abgesaugt werden können und die Schleuseneinheit in beiden Positionen fluidisch den Arbeitsraum vom Transportbereich abtrennt.

In einer weiteren Ausführungsform wird die magnetische Kopplung zwischen dem ersten Statormodul und der ersten Fördereinrichtung derart ausgebildet, dass die erste Fördereinrichtung berührungslos schwebend an der Statormodulanordnung bewegt wird. Beim Eintritt der ersten Fördereinrichtung in den ersten Schleusenraum wird die erste Fördereinrichtung an dem ersten Gehäusesteg oder dem zweiten Gehäusesteg berührungslos schwebend vorbeibewegt. Gegebenenfalls kann hierzu durch eine entsprechende Ansteuerung der Statormodulanordnung die erste Fördereinrichtung zusätzlich etwas weiter angehoben werden, um sicherzustellen, dass eine Berührung der ersten Fördereinrichtung und des ersten Gehäusestegs oder des zweiten Gehäusestegs vermieden wird. Das berührungslose Vorbeibewegen im Schweben der ersten Fördereinrichtung hat den Vorteil, dass eine mechanische Beschädigung und/oder eine Erzeugung von Partikeln beim Entlangreiben der Fördereinrichtung am ersten Gehäusesteg und/oder am zweiten Gehäusesteg vermieden werden kann.

In einer weiteren Ausführungsform wird die erste Fördereinrichtung nach Ausfahrt aus dem ersten Schleusenraum entlang einer ersten Richtung in den ersten Wartebereich bewegt. Die erste Fördereinrichtung wird in dem ersten Wartebereich bewegt, vorzugsweise gestoppt, und/oder eine Bewegungsrichtung der ersten Fördereinrichtung wird im ersten Wartebereich geändert und/oder die erste Fördereinrichtung wird im ersten Wartebereich gedreht. Danach wird die erste Fördereinrichtung von dem ersten Wartebereich zu dem ersten Arbeitsbereich bewegt. In dem ersten Arbeitsbereich wird das Werkstück bearbeitet. Die zweite Schleusenglocke wird um die zweite Drehachse in die vierte Position gedreht. Die erste Fördereinrichtung wird nach Abschluss der Bearbeitung des Werkstücks in den zweiten Schleusenraum bewegt. Die zweite Schleusenglocke wird um die zweite Drehachse aus der vierten Position in die dritte Position gedreht. Die erste Fördereinrichtung wird aus dem zweiten Schleusenraum über die dritte Gehäuseöffnung in den Transportbereich bewegt. Diese Ausgestaltung hat den Vorteil, dass durch die beiden Schleuseneinheiten die erste Fördereinrichtung jeweils pro Durchgang nur einmal durchfährt und dadurch mehrere hintereinander sich bewegende Fördereinrichtungen durch die Bearbeitungsstation geführt werden, ohne dass diese sich gegenseitig im Weg stehen.

In einer weiteren Ausführungsform wird die Dichtung mit einem Druckfluid druckbeaufschlagt befüllt, sodass die Dichtung an der ersten Schleusenglocke anliegt. Zeitlich vor Verdrehen der ersten Schleusenglocke wird das Druckfluid zumindest teilweise aus der Dichtung entlassen, sodass die Dichtung entlastet ist. Vorzugweise wird in entlastetem Zustand ein Spalt zwischen der ersten Schleusenglocke und der Dichtung ausgebildet. Zeitlich nach Entlastung der Dichtung wird die erste Schleusenglocke zwischen der ersten Position und der zweiten Position verdreht, wobei nach Erreichen der ersten Position oder der zweiten Position die Dichtung erneut mit Druckfluid druckbeaufschlagt befüllt wird, sodass die Dichtung an der ersten Schleusenglocke anliegt. Dadurch kann der Arbeitsraum besonders gut fluidisch gegenüber dem Transportbereich abgedichtet werden.

### Zusammenfassung der Erfindung

Die vorliegende Erfindung offenbart ein Planarantriebssystem gemäß Anspruch 1, sowie ein Verfahren zum Betrieb eines Planarantriebssystems gemäß Anspruch 11. Weitere Ausführungsformen werden in den abhängigen Ansprüchen offenbart.

Nachfolgend wird die Erfindung anhand von Figuren näher erläutert. Dabei zeigen:
- Figur 1: eine schematische Draufsicht auf ein Planarantriebssystem gemäß einer ersten Ausführungsform;
- Figur 2: eine schematische Darstellung der in Figur 1 gezeigten Bearbeitungsstation;
- Figur 3: die in Figur 2 gezeigte Bearbeitungsstation;
- Figur 4: eine schematische Darstellung der in den Figuren 1 bis 3 gezeigten Bearbeitungsstation;
- Figur 5: ein Ablaufdiagramm eines Verfahrens zum Betrieb des in Figur 1 gezeigten Planarantriebssystems;
- Figur 6: einen Ausschnitt des in Figur 1 gezeigten Planarantriebssystems nach einem zweiten Verfahrensschritt;
- Figur 7: einen Ausschnitt des in Figur 1 gezeigten Planarantriebssystems nach einem dritten Verfahrensschritt;
- Figur 8: einen Ausschnitt des in Figur 1 gezeigten Planarantriebssystems nach einem vierten Verfahrensschritt;
- Figur 9: einen Ausschnitt des in Figur 1 gezeigten Planarantriebssystems nach einem fünften Verfahrensschritt;
- Figur 10: einen Ausschnitt des in Figur 1 gezeigten Planarantriebssystems nach einem sechsten Verfahrensschritt;
- Figur 11: einen Ausschnitt des in Figur 1 gezeigten Planarantriebssystems nach einem elften Verfahrensschritt;
- Figur 12: einen Ausschnitt des in Figur 1 gezeigten Planarantriebssystems nach einem dreizehnten Verfahrensschritt;
- Figur 13: das in Figur 1 gezeigte Planarantriebssystem nach einem vierzehnten Verfahrensschritt;
- Figur 14: das in Figur 1 gezeigte Planarantriebssystem nach einem fünfzehnten Verfahrensschritt;
- Figur 15: eine perspektivische Darstellung eines Planarantriebssystems gemäß einer zweiten Ausführungsform;
- Figur 16A: eine perspektivische Darstellung der ersten Schleuseneinheit und der zweiten Schleuseneinheit des in Figur 15 gezeigten Planarantriebssystems;
- Figur 16B: eine weitere perspektivische Darstellung des in Figur 16A gezeigten Planarantriebssystems aus einer in Figur 16A gezeigten Blickrichtung A;
- Figur 17: eine Schnittansicht entlang einer in Figur 16 gezeigten Schnittebene B-B durch das in Figur 16 gezeigte erste und zweite Schleusengehäuse;
- Figur 18: eine perspektivische Darstellung der ersten Schleusenglocke und der zweiten Schleusenglocke;
- Figur 19: eine perspektivische Ansicht der in Figur 18 gezeigten ersten Schleusenglocke und der zweiten Schleusenglocke;
- Figur 20: eine Schnittansicht entlang der in Figur 16B gezeigten Schnittebene B-B durch die erste Schleuseneinheit bzw. zweite Schleuseneinheit;
- Figur 21: eine perspektivische Darstellung des Schleusengehäuseteils mit Blickrichtung auf die Unterseite des Schleusengehäusebodens der ersten Schleuseneinheit und/oder der zweiten Schleuseneinheit;
- Figur 22: eine Schnittansicht entlang einer in Figur 16B gezeigten Schnittebene C-C durch die erste Schleuseneinheit bzw. die zweite Schleuseneinheit;
- Figur 23: einen in Figur 15 markierten Ausschnitt D;
- Figur 24: eine schematische Darstellung eines Planarantriebssystems gemäß einer dritten Ausführungsform;
- Figur 25: eine vergrößerte Darstellung der Bearbeitungsstation des in Figur 24 gezeigten Planarantriebssystems;
- Figur 26: einen Ausschnitt des in Figur 24 gezeigten Planarantriebssystems;
- Figur 27: einen Ausschnitt des in Figur 24 gezeigten Planarantriebssystems zeitlich kurz nach dem in Figur 26 gezeigten Ausschnitt;
- Figur 28: eine perspektivische Darstellung eines Planarantriebssystems gemäß einer vierten Ausführungsform;
- Figur 29: eine perspektivische Darstellung des in Figur 28 gezeigten Planarantriebssystems; und
- Figur 30: einen Ausschnitt einer zweiten Schleuseneinheit eines Planarantriebssystems gemäß einer fünften Ausführungsform.

In den nachfolgenden Figuren wird auf ein Koordinatensystem Bezug genommen. Das Koordinatensystem weist eine x-Achse (Längsrichtung), eine y-Achse (Querrichtung) und eine z-Achse (Höhenrichtung) auf. Das Koordinatensystem ist beispielhaft als Rechtssystem ausgebildet und dient zum erleichternden Verständnis der in den folgenden Figuren gezeigten Ausführungsformen eines Planarantriebssystems 10.

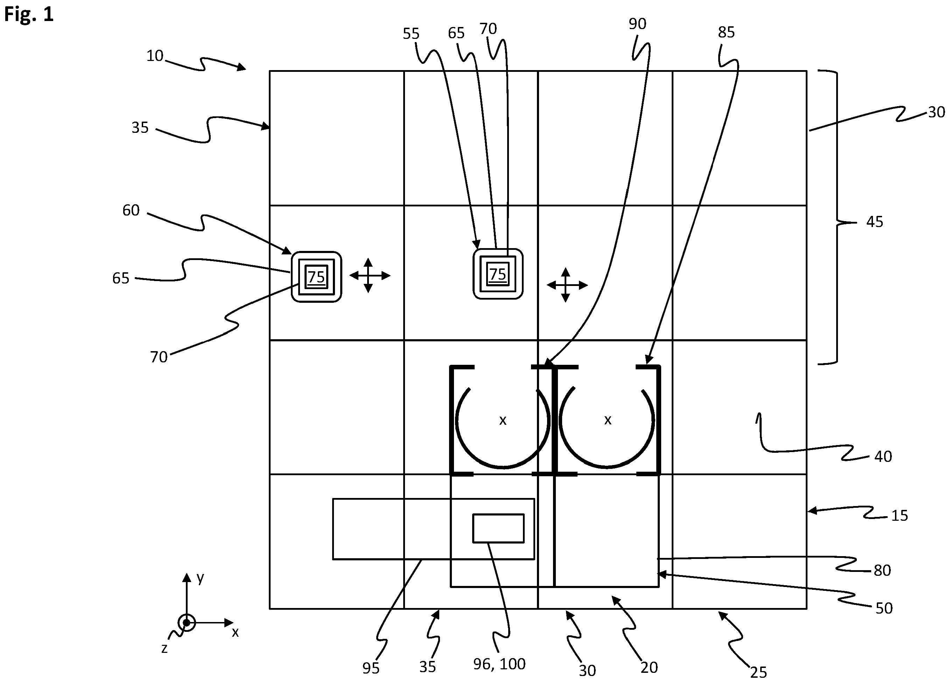

Figur 1 zeigt eine schematische Draufsicht auf ein Planarantriebssystem 10 gemäß einer ersten Ausführungsform.

Das Planarantriebssystem 10 weist eine Planarmotorantriebseinrichtung 15 und eine Bearbeitungsstation 20 auf. Die Planarmotorantriebseinrichtung 15 weist eine Statormodulanordnung 25 mit wenigstens einem ersten Statormodul 30 auf. Zusätzlich kann die Statormodulanordnung 25 ferner wenigstens ein zweites Statormodul 35 aufweisen, wobei das zweite Statormodul 35 direkt angrenzend neben dem ersten Statormodul 30 angeordnet ist.

In der Ausführungsform weist die Statormodulanordnung 25 mehrere erste Statormodule 30 und zweite Statormodule 35 auf, die direkt nebeneinander angeordnet sind. Die Anzahl und/oder ein Anordnungsmuster der ersten Statormodule 30 und der zweiten Statormodule 35 zueinander ist frei wählbar.

Die Statormodulanordnung 25 weist ferner eine dem Betrachter zugewandte Moduloberseite 40 auf, wobei die Moduloberseite 40 sich in der Ausführungsform über das erste und zweite Statormodul 30, 35 hinweg erstreckt. Dabei kann die Moduloberseite 40 im Wesentlichen plan ausgebildet sein und sich in einer xy-Ebene erstrecken. Die Moduloberseite 40 erstreckt sich vorzugsweise im Wesentlichen über eine gesamte Oberseite der Statormodulanordnung 25.

Auf der Moduloberseite 40 der Statormodulanordnung 25 ist die Bearbeitungsstation 20 aufgesetzt und angeordnet. In der Ausführungsform kann die Bearbeitungseinheit 20 unabhängig ihrer geometrischen Ausgestaltung, insbesondere unabhängig der Ausgestaltung der ersten Schleuseneinheit 85 und/oder der zweiten Schleuseneinheit 90 relativ zu dem ersten Statormodul 30 und/oder dem zweiten Statormodul 35 an der Statormodulanordnung 25 positioniert sein.

Die Bearbeitungsstation 20 kann mit der Moduloberseite 40 mechanisch verbunden sein, beispielsweise verklebt sein, um ein ungewolltes Verrutschen der Bearbeitungsstation 20 entlang der Moduloberseite 40 zu verhindern. Die Bearbeitungsstation 20 greift nicht zwischen das erste Statormodul 30 und das zweite Statormodul 35 ein, sodass das erste Statormodul 30 und das zweite Statormodul 35 direkt aneinander anliegen können, sodass die Moduloberseite 40 im Wesentlichen spaltfrei ausgebildet sein kann. Die Bearbeitungsstation 20 kann derart auf der Moduloberseite 40 aufgesetzt sein, dass sich die Bearbeitungsstation 20 über wenigstens die Moduloberseite 40 des ersten Statormoduls 30 und des zweiten Statormoduls 35 hinweg erstreckt.

Das Planarantriebssystem 10 weist einen Transportbereich 45 und einen Arbeitsraum 50 auf, wobei der Arbeitsraum 50 durch die Bearbeitungsstation 20 umschlossen wird. Der Transportbereich 45 ist vorzugsweise außerhalb der Bearbeitungsstation 20, insbesondere vor der Bearbeitungsstation 20 und oberhalb der Moduloberseite 40 angeordnet. Der Transportbereich 45 ist in Figur 1 frei zugänglich und einsehbar, während hingegen der Arbeitsraum 50 durch die Bearbeitungsstation 20 umfangsseitig umschlossen ist.

Ferner weist die Planarmotorantriebseinrichtung 15 wenigstens eine erste Fördereinrichtung 55 auf. Zusätzlich kann das die Planarmotorantriebseinrichtung 15 zu der ersten Fördereinrichtung 55 ferner wenigstens eine zweite Fördereinrichtung 60 aufweisen. Eine Anzahl der ersten Fördereinrichtungen 55 und zweiten Fördereinrichtungen 60 ist im Wesentlichen frei wählbar und wird vor allen durch den oberhalb der Moduloberseite 40 zur Verfügung stehenden Platz limitiert, wobei aus Anschaulichkeitsgründen im Folgenden nur auf die erste Fördereinrichtung 55 und die zweite Fördereinrichtung 60 eingegangen wird.

Die erste Fördereinrichtung 55 und die zweite Fördereinrichtung 60 sind in der Ausführungsform im Wesentlichen identisch zueinander ausgebildet, sodass das im Folgenden für die erste Fördereinrichtung 55 Beschriebene auch für die zweite und ggf. weitere Fördereinrichtungen 60 gilt. Ebenso gilt das im Folgenden für das erste Statormodul 30 Beschriebene ebenso für das zweite Statormodul 35 und, sofern vorgesehen, für die weiteren ersten Statormodule 30 und/oder zweiten Statormodule 35 der Statormodulanordnung 25.

Unterhalb der Moduloberseite 40 schließt sich das erste Statormodul 30 oder das zweite Statormodul 35 an. Das erste Statormodul 30 und/oder das zweite Statormodul 35 sind flach ausgebildet, sodass eine Erstreckung in z-Richtung deutlich kleiner ist als eine Erstreckung des ersten Statormoduls 30 in x-Richtung oder in y-Richtung. Selbiges gilt auch für das zweite Statormodul 35.

Auf der zur Moduloberseite 40 abgewandten Seite kann die Statormodulanordnung 25 mit nicht dargestellten Trägerelementen an einem Maschinenbett 695 (in Figur 1 verdeckt) befestigt sein.

Jedes der Statormodule 30, 35 weist wenigstens einen mit einem Antriebsstrom beaufschlagbaren Spulenleiter auf. Der Spulenleiter ist in dem ersten Statormodul 30 und/oder dem zweiten Statormodul 35 unterseitig der Moduloberseite 40 angeordnet. Mittels des Antriebsstroms in dem Spulenleiter kann ein Magnetfeld erzeugt werden.

Die erste Fördereinrichtung 55 und/oder die zweite Fördereinrichtung 60 weisen jeweils eine Basiseinheit 65 und einen an der Basiseinheit 65 angeordneten Werkstückträger 70 auf. Der Werkstückträger 70 ist mit der Basiseinheit 65 verbunden. Der Werkstückträger 70 kann ein Werkstück 75 oberhalb beabstandet zu der Basiseinheit 65 tragen und mechanisch fixieren. Das Werkstück 75 ist frei wählbar und kann beispielsweise eine I/O-Klemme sein. Eine am Werkstück 75 zu bearbeitende Seite ist beispielsweise auf einer der Bearbeitungseinheit 95 und somit der Moduloberseite 40 abgewandten Seite angeordnet.

In der Basiseinheit 65, insbesondere der Moduloberseite 40 zugewandt, weist die Basiseinheit 65 eine Magnetanordnung auf. Die Magnetanordnung kann ein oder mehrere Permanentmagnete umfassen. Bei Aktivierung der Statormodulanordnung 25 und Bestromung wenigstens des ersten Statormoduls 30 und/oder des zweiten Statormoduls 35 tritt die Magnetanordnung in Wechselwirkung mit dem Magnetfeld. Das Magnetfeld treibt über die Wechselwirkung mit der Magnetanordnung die erste Fördereinrichtung 55 und/oder die zweite Fördereinrichtung 60 derart an, dass die erste Fördereinrichtung 55 und/oder die zweite Fördereinrichtung 60 entlang der Moduloberseite 40 verfahren werden kann.

Auch kann die erste Fördereinrichtung 55 in Höhenrichtung (z-Richtung) von der Moduloberseite 40 weg (begrenzt) angehoben werden. Bei nachlassendem Antriebsstrom zur Erzeugung des Magnetfelds kann die Basiseinheit 65 der ersten Fördereinrichtung 55 und/oder der zweiten Fördereinrichtung 60 auf der Moduloberseite 40 abgesetzt werden. In der Bewegung ist die erste Fördereinrichtung 55 und/oder die zweite Fördereinrichtung 60 frei. Insbesondere kann die erste Fördereinrichtung 55 und/oder die zweite Fördereinrichtung 60 in x-Richtung und/oder in y-Richtung und/oder in z-Richtung zeitgleich bewegt werden. Auch kann die Basiseinheit 65 um die x-Achse oder y-Achse verkippt werden. Eine Rotation um die z-Achse ist ebenso möglich. Die einzelnen Bewegungsrichtungen der ersten Fördereinrichtung 55 und/oder der zweiten Fördereinrichtung 60 können aber auch miteinander kombiniert werden und müssen nicht seriell nacheinander durchgeführt werden. Dies kann jeweils durch eine entsprechende Ansteuerung des Spulenleiters des jeweiligen Statormoduls 30, 35 mit dem Antriebsstrom erzielt werden. Die möglichen Fahrtrichtungen der ersten Fördereinrichtung 55 und der zweiten Fördereinrichtung 60 sind mittels Pfeilen schematisch angedeutet.

Die Bearbeitungsstation 20 weist ein Gehäuse 80, wenigstens eine erste Schleuseneinheit 85, vorzugsweise eine zweite Schleuseneinheit 90 sowie wenigstens eine Bearbeitungseinheit 95 auf. Es wird darauf hingewiesen, dass die Anzahl der Schleuseneinheiten 85, 90 frei wählbar ist. So kann auch eine andere als in Figur 1 gezeigte Anzahl von Schleuseneinheiten 85, 90 vorgesehen sein. So kann die Bearbeitungsstation 20 auch nur eine einzige erste Schleuseneinheit 85 aufweisen, sodass auf die zweite Schleuseneinheit 90 verzichtet wird. Auch ist möglich, dass mehr als die in Figur 1 gezeigten Schleuseneinheiten 85, 90 vorgesehenen sind.

Das Gehäuse 80 begrenzt zusammen mit der ersten Schleuseneinheit 85, vorzugsweise der zweiten Schleuseneinheit 90, der Bearbeitungseinheit 95 und der Moduloberseite 40 gemeinsam den Arbeitsraum 50. Dabei kann das Gehäuse 80 auf der zur Moduloberseite 40 zugewandten Seite zumindest abschnittsweise offen ausgebildet sein.

In der Ausführungsform weist die Bearbeitungseinheit 95 wenigstens ein Bearbeitungsmodul 96 auf. Das Bearbeitungsmodul 96 ist ausgebildet, das Werkstück 75 jeweils zu bearbeiten. Die Bearbeitung des Werkstücks 75 kann unterschiedlich erfolgen und ist nicht limitiert.

Das Bearbeitungsmodul 96 kann als Sendemodul 100 ausgebildet sein, das ausgebildet ist, hochenergetische elektromagnetische Strahlung 105 (in Figur 1 nicht dargestellt), vorzugsweise mit einer Wellenlänge von 350 nm bis 900 nm auszusenden. Die hochenergetische Strahlung 105 kann auch als Mikrowellenstrahlung mit einer Wellenlänge von 0,3 mm bis 1 m ausgebildet sein.

Das Sendemodul 100 kann wenigstens einen Laser oder eine Anordnung von mehreren Lasern aufweisen, die ausgebildet sind, die hochenergetische elektromagnetische Strahlung 105 als Laserstrahlung bereitzustellen. Das Sendemodul 100 kann direkt oder indirekt, beispielsweise mittels optischer Elemente wie einem Spiegel und/oder einem Prisma in den Arbeitsraum 50 gerichtet sein. Auch kann die Bearbeitungseinheit 95 ein Modul zur gezielten Ablenkung der ausgesendeten hochenergetischen elektromagnetischen Strahlung 105 aufweisen.

Das Gehäuse 80 weist vorzugsweise ein für die elektromagnetische Strahlung 105 undurchlässiges Material auf. Das Gehäuse 80 kann einen Aluminiumwerkstoff aufweisen. Zusätzlich kann das Gehäuse 80 zumindest innenseitig auf der dem Arbeitsraum 50 zugewandten Seite eloxiert sein. Durch Eloxierung ist das Gehäuse 80 resistent gegenüber aggressiven Medien. Ferner wird eine ungewollte Reflexion, insbesondere der elektromagnetischen Strahlung 105, reduziert. Insbesondere ist von Vorteil, wenn das Gehäuse 80 innenseitig schwarz oder dunkel eloxiert ist.

Die erste Schleuseneinheit 85 und die zweite Schleuseneinheit 90 sind in Längsrichtung direkt nebeneinander angeordnet und trennen den Arbeitsraum 50 von dem Transportbereich 45 ab. Dabei ist die erste Schleuseneinheit 85 und/oder die zweite Schleuseneinheit 90 derart ausgebildet, dass die erste Fördereinrichtung 55 und/oder die zweite Fördereinrichtung 60 beispielhaft einzeln über die erste Schleuseneinheit 85 oder die zweite Schleuseneinheit 90 aus dem Transportbereich 45 in den Arbeitsraum 50 einfahren kann oder den Arbeitsraum 50 zum Transportbereich 45 hin verlassen kann.

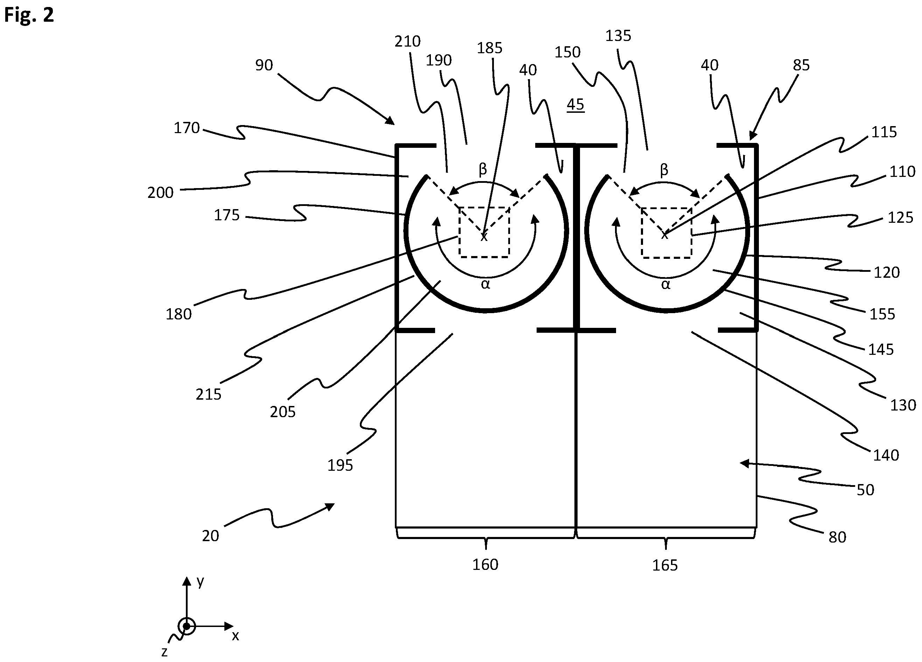

Figur 2 zeigt eine schematische Darstellung der in Figur 1 gezeigten Bearbeitungsstation 20.

Die erste Schleuseneinheit 85 weist ein erstes Schleusengehäuse 110, eine um eine erste Drehachse 115 drehbar gelagerte erste Schleusenglocke 120 und einen ersten Schleusenantrieb 125 auf. Der erste Schleusenantrieb 125 ist in Figur 2 strichliert dargestellt. Das erste Schleusengehäuse 110 kann im Wesentlichen als Quader ausgebildet sein und umschließt umfangsseitig einen ersten Gehäuseinnenraum 130.

Das erste Schleusengehäuse 110 kann an der zur Moduloberseite 40 zugewandten Seite zumindest abschnittsweise offen ausgebildet sein. Das erste Schleusengehäuse 110 weist eine dem Arbeitsraum 50 abgewandte und dem Transportbereich 45 zugewandte erste Gehäuseöffnung 135 auf. Versetzt zu der ersten Gehäuseöffnung 135 weist in Figur 2 das erste Schleusengehäuse 110 eine zweite Gehäuseöffnung 140 auf. Die zweite Gehäuseöffnung 140 kann in y-Richtung gegenüberliegend zu der ersten Gehäuseöffnung 135 angeordnet sein.

Sowohl die erste Gehäuseöffnung 135 als auch die zweite Gehäuseöffnung 140 sind im Wesentlichen in Längsrichtung breiter als eine maximale Erstreckung in x- und/oder in y-Richtung der ersten Fördereinrichtung 55 und/oder der zweiten Fördereinrichtung 60 ausgebildet.

Die erste Gehäuseöffnung 135 und die zweite Gehäuseöffnung 140 sind jeweils als Durchgangsöffnungen in dem ersten Schleusengehäuse 110 ausgeformt. Dabei verbindet die erste Gehäuseöffnung 135 den Transportbereich 45 mit dem ersten Gehäuseinnenraum 130. Der Arbeitsraum 50 ist über die zweite Gehäuseöffnung 140 mit dem ersten Gehäuseinnenraum 130 verbunden.

In dem ersten Gehäuseinnenraum 130 ist die erste Schleusenglocke 120 angeordnet. Außerhalb des ersten Gehäuseinnenraums 130 kann der erste Schleusenantrieb 125 an dem ersten Schleusengehäuse 110 auf der zur Moduloberseite 40 abgewandten Seite an dem ersten Schleusengehäuse 110 befestigt sein. Die erste Schleusenglocke 120 ist drehmomentschlüssig mit dem ersten Schleusenantrieb 125 verbunden, wobei der erste Schleusenantrieb 125 ausgebildet ist, die erste Schleusenglocke 120 in Umfangsrichtung um die erste Drehachse 115 zu verdrehen. Dabei kann der erste Schleusenantrieb 125 die erste Schleusenglocke 120 zwischen einem ersten Positionsbereich und einem in Umfangsrichtung bezogen auf die erste Drehachse 115 zum ersten Positionsbereich versetzt angeordneten zweiten Positionsbereich verdrehen.

Innerhalb des ersten Positionsbereichs weist die erste Schleusenglocke 120 wenigstens eine erste Position auf. In Figur 2 ist die Schleusenglocke 120 in der ersten Position beispielhaft dargestellt. Ferner kann die erste Schleusenglocke 120 innerhalb des zweiten Positionsbereichs eine zweite Position aufweisen.

Die erste Schleusenglocke 120 weist einen ersten Torabschnitt 145 auf, wobei der erste Torabschnitt 145 sich in Umfangsrichtung vorzugsweise über einen ersten Winkel α von etwa 230° bis 300° um die erste Drehachse 115 erstreckt. Der erste Torabschnitt 145 weist eine im Wesentlichen zylinderartige Grundform auf. Umfangsseitig umschließt der erste Torabschnitt 145 einen ersten Schleusenraum 155, der in dem ersten Gehäuseinnenraum 130 angeordnet ist.

Der erste Torabschnitt 145 ist in radialer Richtung so breit ausgebildet, dass der erste Torabschnitt 145 in radialer Richtung vollständig die erste Fördereinrichtung 55 oder die zweite Fördereinrichtung 60 umschließen kann. In z-Richtung ist der erste Torabschnitt 145 so hoch ausgebildet, dass ebenso in dem ersten Schleusenraum 155 vollständig die erste Fördereinrichtung 55 oder die zweite Fördereinrichtung 60 angeordnet werden kann.

Die erste Schleusenglocke 120 weist ferner eine einseitig an der ersten Schleusenglocke 120 angeordnete erste Schleusenöffnung 150 auf. Die erste Schleusenöffnung 150 ist als Aussparung oder Durchgangsöffnung in der ersten Schleusenglocke 120 ausgeformt. Die erste Schleusenöffnung 150 ist in Umfangsrichtung bezogen auf die erste Drehachse 115 beidseitig durch den ersten Torabschnitt 145 begrenzt. Dabei kann sich die erste Schleusenöffnung 150 über einen zweiten Winkel β erstrecken, der komplementär zu dem ersten Winkel α ausgebildet ist, sodass eine Summe aus dem ersten Winkel α und dem zweiten Winkel β 360° ergibt. So kann beispielsweise die erste Schleusenöffnung 150 einen zweiten Winkel von 60° bis 130° einschließen.

In dem ersten Positionsbereich ist die erste Schleusenöffnung 150 der ersten Gehäuseöffnung 135 zugewandt, sodass über die erste Gehäuseöffnung 135 der erste Schleusenraum 155 zumindest teilweise geöffnet ist. Dabei weisen in dem ersten Positionsbereich die erste Schleusenöffnung 150 und die erste Gehäuseöffnung 135 zumindest eine teilweise oder eine vollständige Überdeckung in y-Richtung auf. Dabei wird unter einer teilweisen Überdeckung in y-Richtung verstanden, dass bei Projektion zweier Komponenten, beispielsweise der ersten Gehäuseöffnung 135 und der ersten Schleusenöffnung 150, in y-Richtung in eine Projektionsebene, die beispielsweise als xz-Ebene ausgebildet ist, sich in der Projektionsebene die beiden Komponenten, beispielsweise die erste Schleusenöffnung 150 und die erste Gehäuseöffnung 135, teilweise überdecken.

In der ersten Position, wie in Figur 2 dargestellt ist, ist die erste Schleusenöffnung 150 derartig zu der ersten Gehäuseöffnung 135 angeordnet, dass die erste Schleusenöffnung 150 und die erste Gehäuseöffnung 135 eine maximale Überdeckung in y-Richtung aufweisen, sodass sich in der Projektionsebene die erste Schleusenöffnung 150 und die erste Gehäuseöffnung 135 maximal überdecken.

In der ersten Position ist die Überdeckung der ersten Gehäuseöffnung 135 und der ersten Schleusenöffnung 150 maximiert, sodass über die erste Gehäuseöffnung 135 und die erste Schleusenöffnung 150 die erste Fördereinrichtung 55 oder die zweite Fördereinrichtung 60 in den ersten Schleusenraum 155 einfahren oder ausfahren kann, ohne dass hierbei die erste Fördereinrichtung 55 oder die zweite Fördereinrichtung 60 mit der ersten Schleusenglocke 120 und/oder dem ersten Schleusengehäuse 110 in Berührung tritt.

Auch kann die erste Fördereinrichtung 55 oder die zweite Fördereinrichtung 60 in dem ersten Schleusenraum 155 auf der Moduloberseite 40 durch Absenken des Spulenstroms abgesenkt werden.

In dem ersten Schleusenraum 155, in dem die erste Fördereinrichtung 55 oder die zweite Fördereinrichtung 60 angeordnet ist, ist die erste Schleusenglocke 120 um die erste Drehachse 115 durch den ersten Schleusenantrieb 125 verdrehbar. Unabhängig zu der Drehbewegung der ersten Schleusenglocke 120 bleibt die magnetische Kopplung zwischen der ersten Fördereinrichtung 55 und der Statormodulanordnung 25 erhalten. Dadurch ist innerhalb der ersten Schleusenglocke 120 neben dem geradlinigen Transport als zusätzliche Option auch eine Drehung der ersten Fördereinrichtung 55 innerhalb der ersten Schleusenglocke 120 möglich.

In dem ersten Positionsbereich verschließt der erste Torabschnitt 145 die zweite Gehäuseöffnung 140 auf der zum Arbeitsraum 50 zugewandten Seite, sodass der erste Schleusenraum 155 in dem ersten Positionsbereich ausschließlich über die erste Gehäuseöffnung 135 offen ist. Dabei verhindert der erste Torabschnitt 145 einen direkten Austritt von Emissionen, beispielsweise der elektromagnetischen Strahlung 105 (welche hier nicht dargestellt ist), aus dem Arbeitsraum 50 über den ersten Schleusenraum 155 hin zur ersten Gehäuseöffnung 135.

Die erste Schleusenglocke 120 und/oder das erste Schleusengehäuse 110 ist auf der zur Moduloberseite 40 zugewandten Seite beispielsweise zumindest teilweise offen ausgebildet. Dadurch kann eine gute Durchdringung des ersten Schleusenraums 155 mit dem durch den Spulenstrom erzeugten Magnetfeld des ersten Statormoduls 30 und/oder des zweiten Statormoduls 35 zum Antrieb der in den ersten Schleusenraum 155 einfahrenden oder ausfahrenden ersten Fördereinrichtung 55 oder zweiten Fördereinrichtung 60 sichergestellt werden. Ferner ist ein Werkstoff der ersten Schleusenglocke 120 derart gewählt, dass das Magnetfeld nicht oder nur unwesentlich gestört und/oder unterbrochen wird. Dadurch ist ein sicherer Betrieb und ein sicheres Verfahren der Fördereinrichtung 55, 60 innerhalb der ersten Schleuseneinheit 85 sichergestellt.

Die zweite Schleuseneinheit 90 ist im Wesentlichen identisch zu der ersten Schleuseneinheit 85 ausgebildet. Dabei werden im Folgenden zum erleichterten Verständnis des in den nachfolgenden Figuren beschriebenen Verfahrens zum Betrieb des Planarantriebssystems 10 die Komponenten der zweiten Schleuseneinheit 90 unterschiedlich zu Komponenten der ersten Schleuseneinheit 85 bezeichnet. Auf die Bezeichnung der Komponenten der zweiten Schleuseneinheit 90 und der identischen Komponenten der ersten Schleuseneinheit 85 wird im Folgenden eingegangen.

Die zweite Schleuseneinheit 90 weist ein zweites Schleusengehäuse 170 und eine zweite Schleusenglocke 175 sowie einen zweiten Schleusenantrieb 180 auf. Das zweite Schleusengehäuse 170 ist identisch zu dem ersten Schleusengehäuse 110, die zweite Schleusenglocke 175 kann identisch zu der ersten Schleusenglocke 120 und der zweite Schleusenantrieb 180 kann identisch zu dem ersten Schleusenantrieb 125 ausgebildet sein.

Anstatt um die erste Drehachse 115 ist die zweite Schleusenglocke 175 um eine zweite Drehachse 185 drehbar gelagert und mit dem zweiten Schleusenantrieb 180 drehmomentschlüssig verbunden. Die erste Drehachse 115 und die zweite Drehachse 185 können dabei parallel zueinander ausgerichtet sein und sich jeweils parallel zur z-Achse erstrecken.

Anstatt der ersten Gehäuseöffnung 135 weist das zweite Schleusengehäuse 170 eine dritte Gehäuseöffnung 190 auf, die dem Transportbereich 45 zugewandt ist. In Querrichtung gegenüberliegend weist das zweite Schleusengehäuse 170 anstatt der zweiten Gehäuseöffnung 140 eine vierte Gehäuseöffnung 195 auf. Das zweite Schleusengehäuse 170 umschließt anstatt des ersten Gehäuseinnenraums 130 einen zweiten Gehäuseinnenraum 200, wobei im zweiten Gehäuseinnenraum 200 die zweite Schleusenglocke 175 angeordnet ist. Die zweite Schleusenglocke 175 umschließt umfangsseitig (radial innenseitig) einen zweiten Schleusenraum 205 anstatt des ersten Schleusenraums 155.

Durch den identischen Aufbau der zweiten Schleuseneinheit 90 zu der ersten Schleuseneinheit 85 ist auch die zweite Schleusenglocke 175 identisch zur ersten Schleusenglocke 120 ausgebildet und weist eine zweite Schleusenöffnung 210 anstatt der ersten Schleusenöffnung 150 und einen zweiten Torabschnitt 215 anstatt des ersten Torabschnitts 145 auf. Der zweite Torabschnitt 215 erstreckt sich ebenso über den gleichen ersten Winkel α wie der erste Torabschnitt 145 und ebenso ist die zweite Schleusenöffnung 210 in Umfangsrichtung um die zweite Drehachse 185 über einen zweiten Winkel β erstreckend ausgebildet.

Die zweite Schleusenglocke 175 kann in Umfangsrichtung um die zweite Drehachse 185 durch den zweiten Schleusenantrieb 180 zwischen einem dritten Positionsbereich und einem in Umfangsrichtung unterschiedlich zum dritten Positionsbereich angeordneten vierten Positionsbereich verdreht werden.

Der dritte Positionsbereich entspricht dabei dem ersten Positionsbereich der ersten Schleusenglocke 120 und der vierte Positionsbereich entspricht dem zweiten Positionsbereich der ersten Schleusenglocke 120. In dem dritten Positionsbereich weist die zweite Schleusenglocke 175 eine dritte Position auf, in der die zweite Schleusenglocke 175 in Figur 2 dargestellt ist.

In dem dritten Positionsbereich ist die zweite Schleusenöffnung 210 der dritten Gehäuseöffnung 190 und somit dem Transportbereich 45 zugewandt. Der zweite Schleusenraum 205 ist somit ausschließlich über die dritte Gehäuseöffnung 190 und die zweite Schleusenöffnung 210 vom Transportbereich 45 her zumindest teilweise offen. Der zweite Torabschnitt 215 ist der vierten Gehäuseöffnung 195 zugewandt und verschließt den zweiten Schleusenraum 205 gegenüber dem Arbeitsraum 50. Dadurch ist im dritten Positionsbereich der Arbeitsraum 50 gegenüber dem Transportbereich 45 abgetrennt und ausschließlich über die dritte Gehäuseöffnung 190 zugänglich.

In der dritten Position ist die zweite Schleusenöffnung 210 derartig zu der dritten Gehäuseöffnung 190 angeordnet, dass die zweite Schleusenöffnung 210 und die zweite Gehäuseöffnung 190 eine maximale Überdeckung in y-Richtung aufweisen, sodass über die dritte Gehäuseöffnung 190 und die zweite Schleusenöffnung 210 die erste Fördereinrichtung 55 oder die zweite Fördereinrichtung 60 vom Transportbereich 45 in den zweiten Schleusenraum 210 einfahren oder ausfahren kann, ohne dass hierbei die erste Fördereinrichtung 55 oder die zweite Fördereinrichtung 60 mit der zweiten Schleusenglocke 210 und/oder dem zweiten Schleusengehäuse 170 in Berührung tritt.

In der Ausführungsform unterteilt sich der Arbeitsraum 50 in einen ersten Arbeitsbereich 160 und einen ersten Wartebereich 165. Der erste Arbeitsbereich 160 schließt sich an die vierte Gehäuseöffnung 195 an. In Querrichtung erstreckt sich der erste Arbeitsbereich 160 zwischen dem Gehäuse 80 und dem zweiten Schleusengehäuse 170 angrenzend an die vierte Gehäuseöffnung 195. Sowohl der erste Arbeitsbereich 160 als auch der erste Wartebereich 165 sind oberseitig der Moduloberseite 40 angeordnet.

Der erste Wartebereich 165 schließt sich in Längsrichtung an den ersten Arbeitsbereich 160 an und ist in Querrichtung zwischen der ersten Schleuseneinheit 85 und dem Gehäuse 80 angeordnet.

Sowohl der erste Arbeitsbereich 160 als auch der erste Wartebereich 165 sind in ihrer geometrischen Ausgestaltung derart ausgebildet, dass jeweils die erste Fördereinrichtung 55 oder die zweite Fördereinrichtung 60 in dem ersten Wartebereich 165 oder in dem ersten Arbeitsbereich 160 angeordnet sein kann. Insbesondere kann zeitgleich in dem ersten Arbeitsbereich 160 die erste Fördereinrichtung 55 und dem ersten Wartebereich 165 die zweite Fördereinrichtung 60 angeordnet sein.

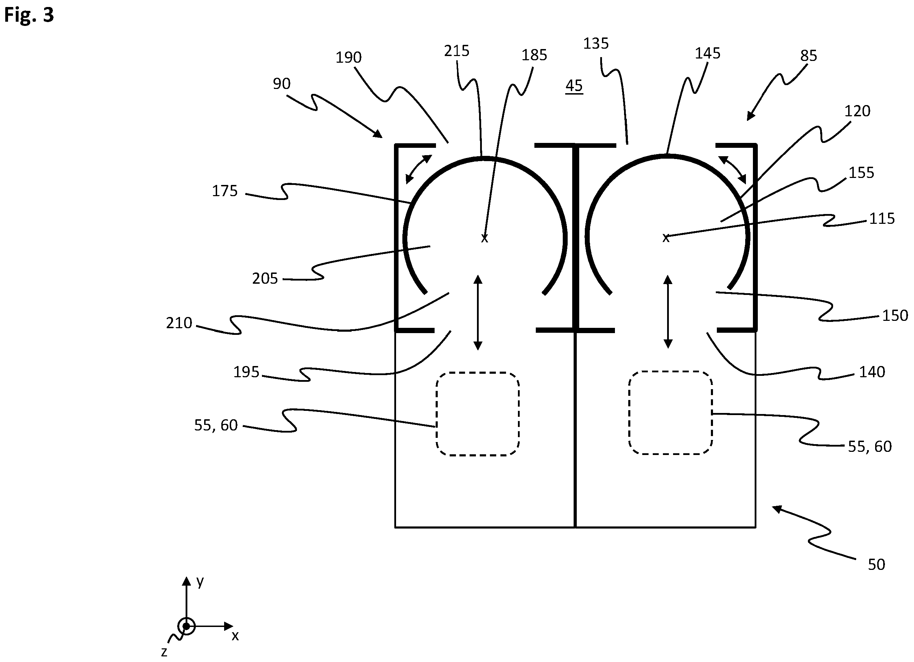

Figur 3 zeigt die in Figur 2 gezeigte Bearbeitungsstation 20.

In Figur 3 ist die erste Schleusenglocke 120 aus dem ersten Positionsbereich in den zweiten Positionsbereich gedreht. Dabei ist der erste Torabschnitt 145 auf der zur ersten Gehäuseöffnung 135 zugewandten Seite angeordnet.

In Figur 3 ist die erste Schleusenglocke 120 um die erste Drehachse 115 aus der ersten Position in die zweite Position in Umfangsrichtung verdreht, die in dem zweiten Positionsbereich liegt.

Die erste Schleusenöffnung 150 ist im zweiten Positionsbereich auf der zur zweiten Gehäuseöffnung 140 zugewandten Seite angeordnet, sodass ausschließlich über die zweite Gehäuseöffnung 140 der erste Schleusenraum 155 zumindest teilweise geöffnet ist. Dabei weisen in dem zweiten Positionsbereich die erste Schleusenöffnung 150 und die zweite Gehäuseöffnung 140 zumindest eine teilweise oder eine vollständige Überdeckung in y-Richtung auf.

In der zweiten Position ist die erste Schleusenöffnung 150 derartig zu der zweiten Gehäuseöffnung 140 angeordnet, dass die erste Schleusenöffnung 150 und die zweite Gehäuseöffnung 140 eine maximale Überdeckung in y-Richtung aufweisen, sodass über die zweite Gehäuseöffnung 140 und die erste Schleusenöffnung 150 die erste Fördereinrichtung 55 oder die zweite Fördereinrichtung 60 vom Arbeitsraum 50 in den ersten Schleusenraum 155 einfahren oder ausfahren kann, ohne dass hierbei die erste Fördereinrichtung 55 oder die zweite Fördereinrichtung 60 mit der ersten Schleusenglocke 120 und/oder dem ersten Schleusengehäuse 110 in Berührung tritt.

Der erste Schleusenraum 155 ist gegenüber der ersten Gehäuseöffnung 135 durch den ersten Torabschnitt 145 verschlossen.

Analog zur ersten Schleuseneinheit 85 ist in Figur 3 die zweite Schleusenglocke 175 aus dem in Figur 2 gezeigten dritten Positionsbereich, insbesondere der dritten Position, um die zweite Drehachse 185 in Umfangsrichtung in die im vierten Positionsbereich liegende vierte Position gedreht.

In dem vierten Positionsbereich ist der zweite Torabschnitt 215 auf der zur dritten Gehäuseöffnung 190 zugewandten Seite angeordnet und verschließt die dritte Gehäuseöffnung 190 zum zweiten Schleusenraum 205 hin. Die zweite Schleusenöffnung 210 ist auf der zur vierten Gehäuseöffnung 195 zugewandten Seite angeordnet und weist zumindest eine teilweise Überdeckung in y-Richtung mit der vierten Gehäuseöffnung 195 auf, sodass der zweite Schleusenraum 205 ausschließlich zum Arbeitsraum 50 offen und zum Transportbereich 45 geschlossen ist.

Insbesondere ist in der vierten Position die Überdeckung in y-Richtung maximiert, sodass die erste Fördereinrichtung 55 oder die zweite Fördereinrichtung 60 in den zweiten Schleusenraum 205 einfahren kann oder aus dem zweiten Schleusenraum 205 heraus in den Arbeitsraum 50 fahren kann.

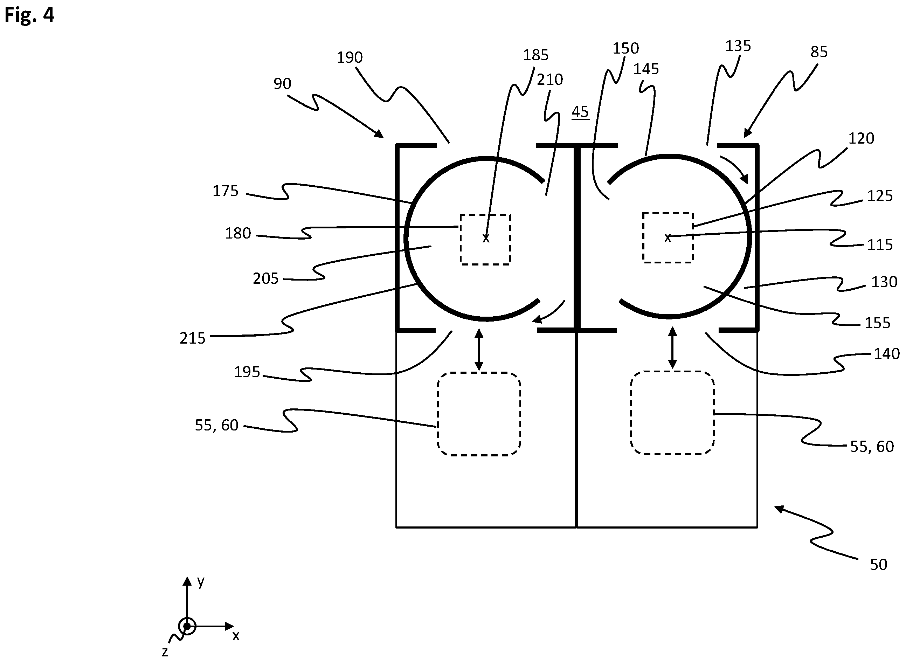

Figur 4 zeigt eine schematische Darstellung der in den Figuren 1 bis 3 gezeigten Bearbeitungsstation 20.

Zusätzlich kann je nach geometrischer Ausgestaltung die erste Schleusenglocke 120 in einen ersten Zwischenpositionsbereich um die erste Drehachse 115 verdreht werden, der in Umfangsrichtung zwischen dem ersten Positionsbereich und dem zweiten Positionsbereich liegt. Die erste Schleusenöffnung 150 weist im ersten Zwischenpositionsbereich nur eine Überdeckung mit dem ersten Schleusengehäuse 110 auf, nicht jedoch mit der ersten Gehäuseöffnung 135 und der zweiten Gehäuseöffnung 140. Der erste Zwischenpositionsbereich kann sich über beispielsweise zwei Teilbereiche erstrecken, die jeweils in Umfangsrichtung zwischen dem ersten Positionsbereich und dem zweiten Positionsbereich liegen.

In dem ersten Zwischenpositionsbereich verschließt der erste Torabschnitt 145 auf der zur ersten Gehäuseöffnung 135 zugewandten Seite die erste Gehäuseöffnung 135 und trennt den ersten Schleusenraum 155 von dem Transportbereich 45 ab. Ebenso verschließt der erste Torabschnitt 145 an der zweiten Gehäuseöffnung 140 auf der zum Arbeitsraum 50 zugewandten Seite den ersten Schleusenraum 155. In dem ersten Zwischenpositionsbereich kann beispielsweise die erste Schleusenöffnung 150 auf der zur zweiten Schleuseneinheit 90 zugewandten oder abgewandten Seite hin angeordnet sein. Der erste Schleusenraum 155 ist sowohl vom Arbeitsraum 50 als auch vom Transportbereich 45 abgetrennt.

Dadurch ist im ersten Zwischenpositionsbereich zum einen ein Einfahren oder ein Ausfahren der ersten Fördereinrichtung 55 oder der Fördereinrichtung 60 aus dem ersten Schleusenraum 155 oder dem Transportbereich 45 oder dem Arbeitsraum 50 durch den ersten Torabschnitt 145 blockiert.

Des Weiteren wird ein Austritt von Emissionen aus dem Arbeitsraum 50, resultierend aus einer Bearbeitung des Werkstücks 75, beispielsweise die elektromagnetische Strahlung 105 oder Kühlflüssigkeit, über die zweite Gehäuseöffnung 140, den ersten Gehäuseinnenraum 130 und die erste Gehäuseöffnung 135 hin zum Transportbereich 45 durch den ersten Torabschnitt 145 wirksam blockiert.

Dadurch kann eine Sicherheit der Bearbeitungsstation 20 für umstehend um das Planarantriebssystem 10 sich aufhaltende Personen, insbesondere eine Lasersicherheit, gewährleistet werden.

Auf Grund der identischen Ausgestaltung der zweiten Schleuseneinheit 90 zu der ersten Schleuseneinheit 85 kann auch die zweite Schleusenglocke 175 in einen zweiten Zwischenpositionsbereich um die zweite Drehachse 185 verdreht werden, der dem ersten Zwischenpositionsbereich entspricht. In Figur 4 ist die zweite Schleusenglocke 175 in dem zweiten Zwischenpositionsbereich dargestellt.

In dem zweiten Zwischenpositionsbereich ist die zweite Schleusenglocke 175 zwischen dem dritten Positionsbereich und dem vierten Positionsbereich um die zweite Drehachse 185 verdreht angeordnet. Dabei kann in dem zweiten Zwischenpositionsbereich beispielsweise die zweite Schleusenöffnung 210 zur ersten Schleuseneinheit 85 hin oder von der ersten Schleuseneinheit 85 abgewandt ausgerichtet sein.

In dem zweiten Zwischenpositionsbereich verschließt der zweite Torabschnitt 215 an der dritten Gehäuseöffnung 190 den zweiten Schleusenraum 205 gegenüber dem Transportbereich 45. Ebenso verschließt an der vierten Gehäuseöffnung 195 der zweite Torabschnitt 215 den zweiten Schleusenraum 205 gegenüber dem Arbeitsraum 50. In dem zweiten Zwischenpositionsbereich verhindert der zweite Torabschnitt 215 ein Einfahren oder Ausfahren der ersten Fördereinrichtung 55 oder der zweiten Fördereinrichtung 60 in den zweiten Schleusenraum 205 zwischen dem Transportbereich 45 und dem Arbeitsraum 50.

In dem zweiten Zwischenpositionsbereich stellt somit die zweite Schleusenglocke 175 sicher, dass ein Austritt von elektromagnetischer Strahlung 105 über die vierte Gehäuseöffnung 195 und den zweiten Schleusenraum 205 hin zur dritten Gehäuseöffnung 190 in den Transportbereich 45 blockiert ist.

Die erste Schleusenglocke 120 und die zweite Schleusenglocke 175 können jeweils durch den zugeordneten ersten Schleusenantrieb 125 und den zweiten Schleusenantrieb 180 unabhängig voneinander in den ersten bis vierten Positionsbereich und/oder den ersten Zwischenpositionsbereich oder zweiten Zwischenpositionsbereich verfahren werden.

Dadurch kann beispielsweise zeitgleich der erste Schleusenraum 155 vom Transportbereich 45 (vgl. Figur 2) und der zweite Schleusenraum 205 vom Arbeitsraum 50 (vgl. Figur 3) zugänglich sein. Unabhängig von der jeweiligen Verdrehung der ersten Schleusenglocke 120 und/oder der zweiten Schleusenglocke 175 ist eine direkte Verbindung zwischen dem Arbeitsraum 50 und dem Transportbereich 45 unterbrochen und der Arbeitsraum 50 vom Transportbereich 45 abgetrennt.

Auch im ersten Zwischenpositionsbereich und/oder zweiten Zwischenpositionsbereich wird ein Austritt der elektromagnetischen Strahlung 105 durch die erste Schleusenglocke 120 und die zweite Schleusenglocke 175 wirksam verhindert.

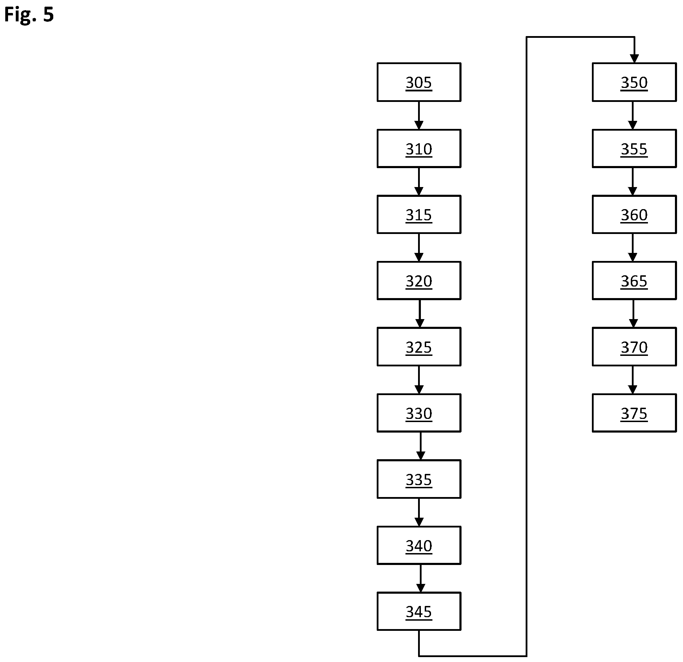

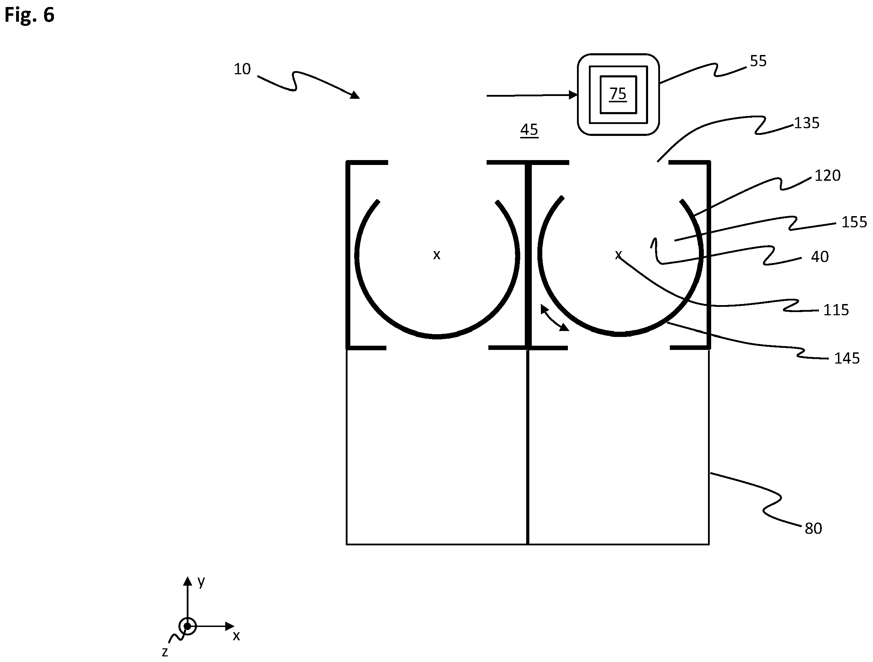

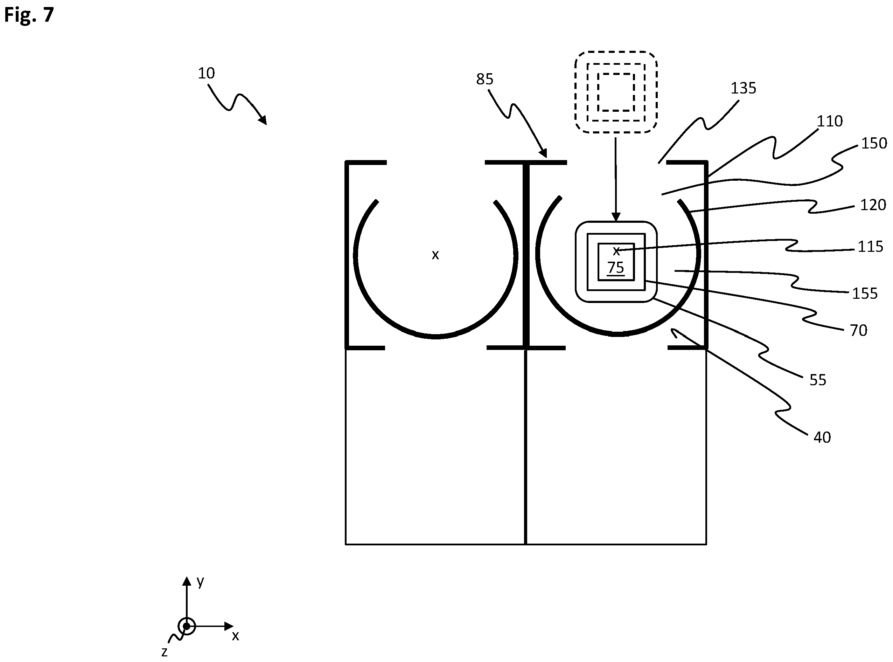

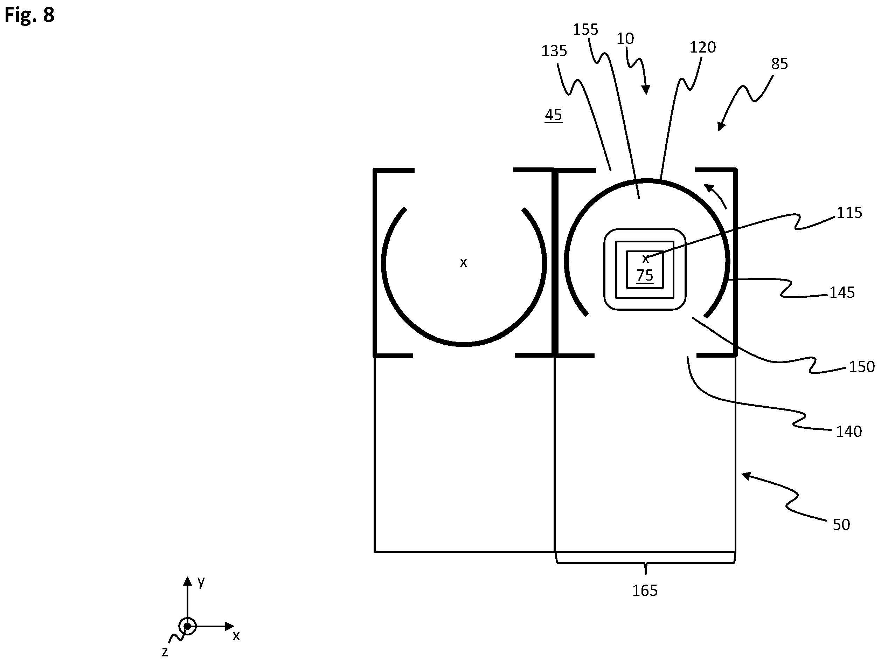

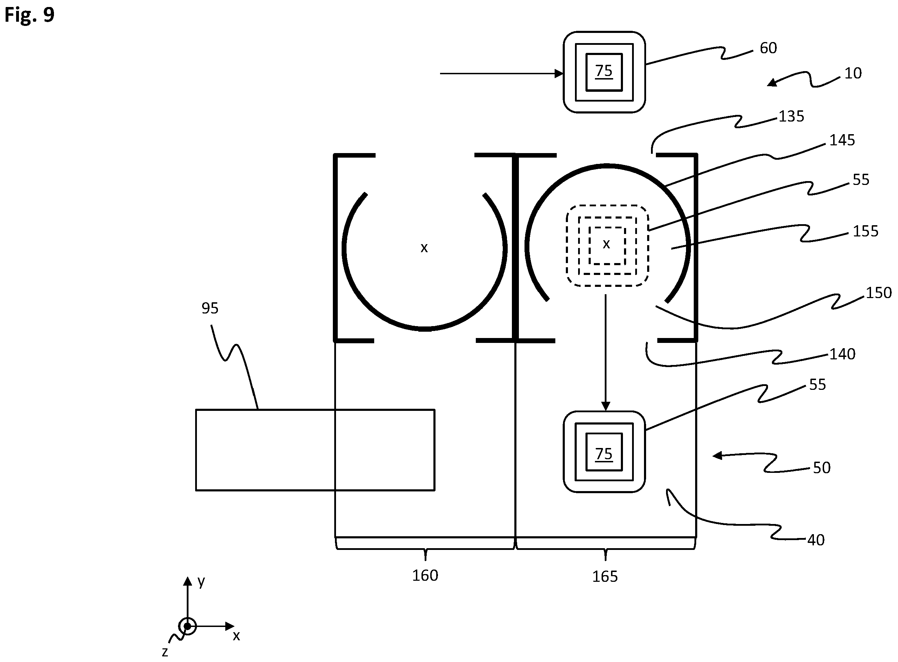

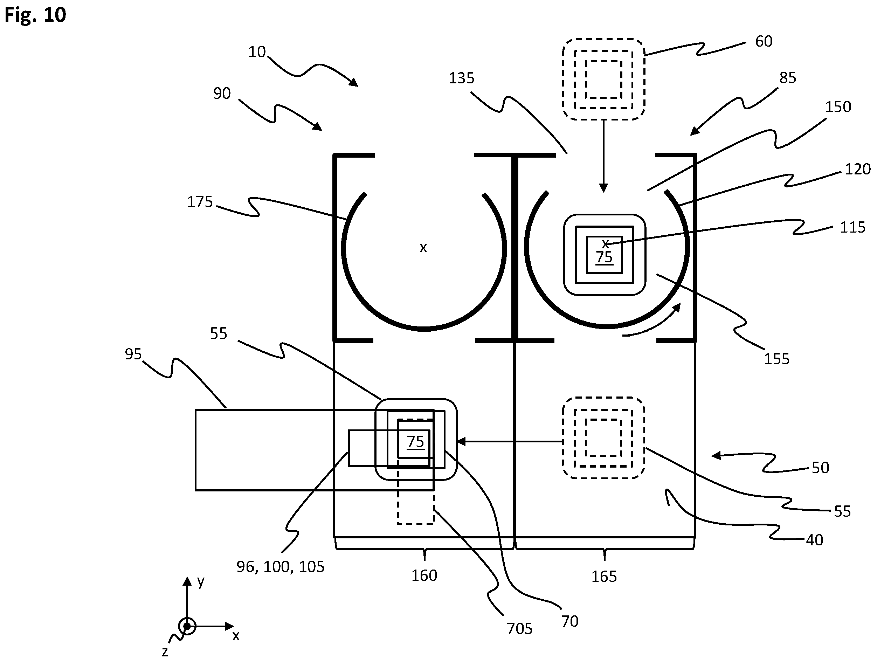

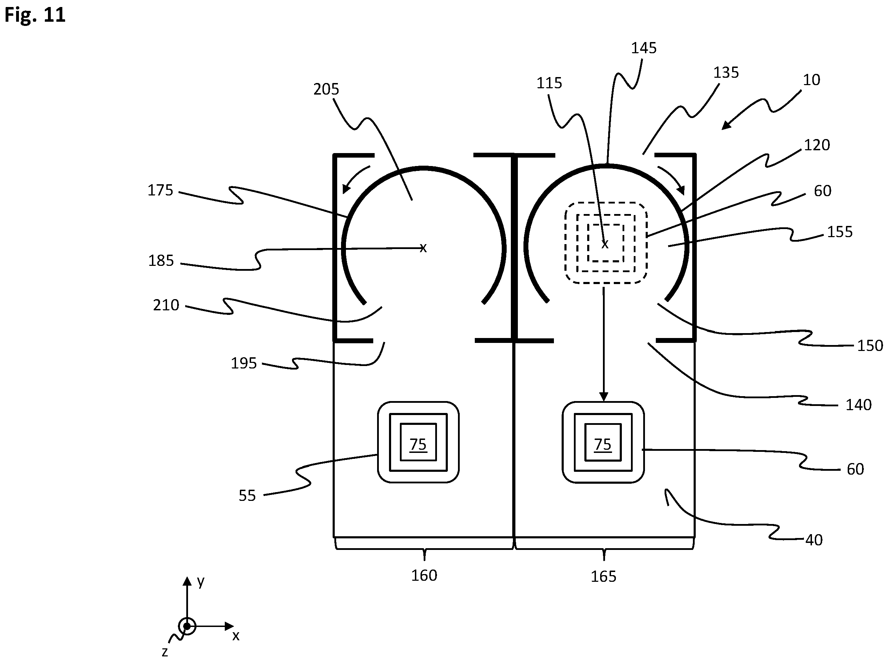

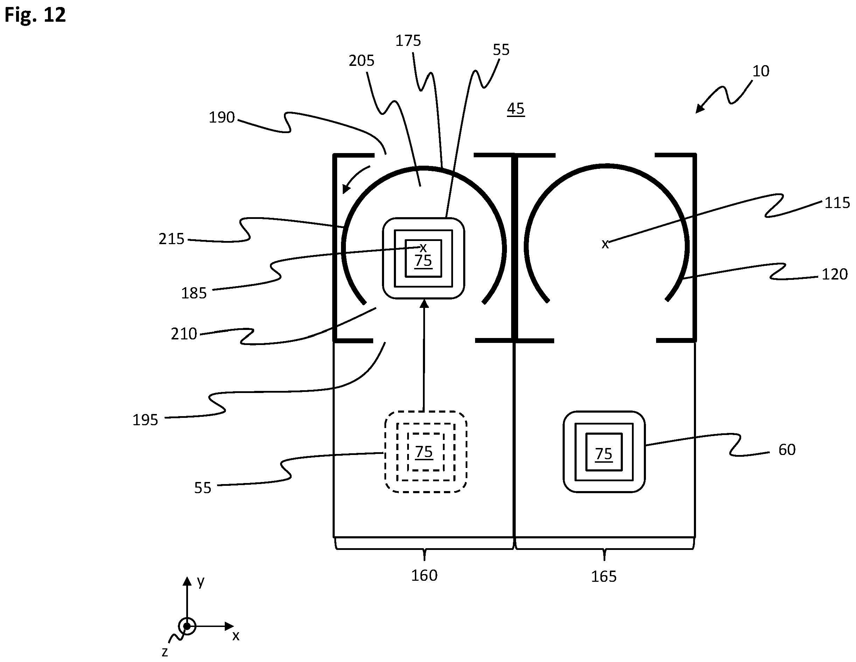

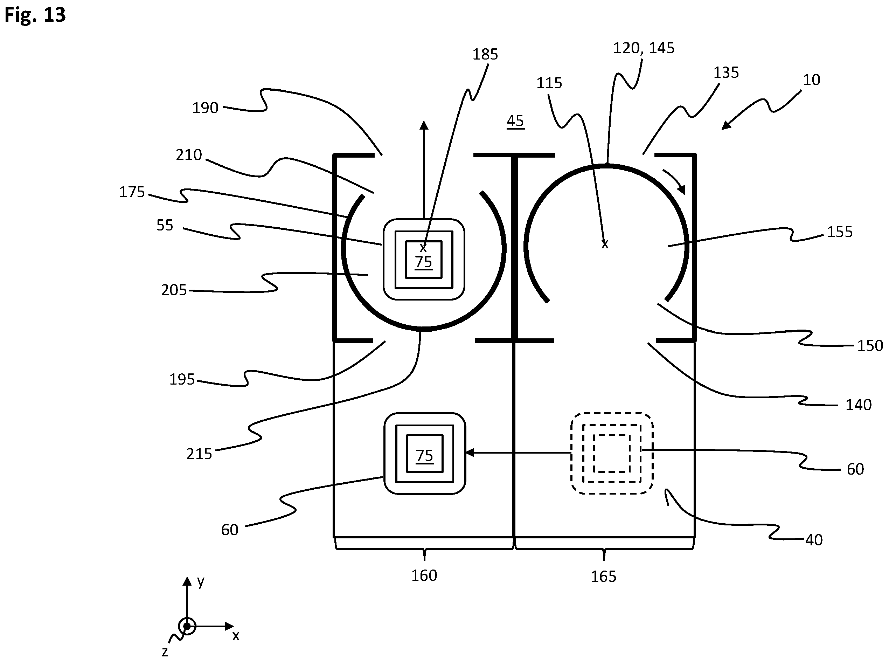

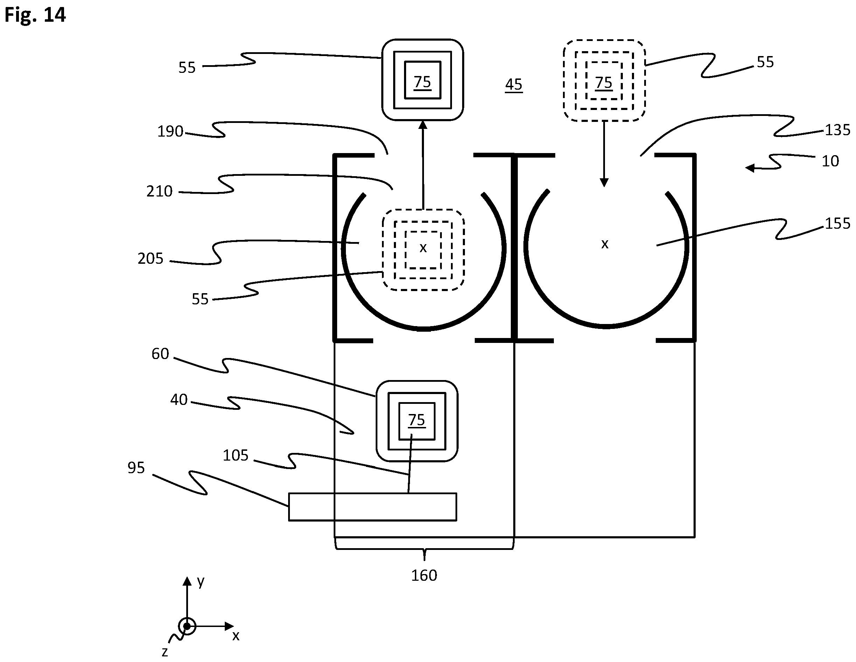

Figur 5 zeigt ein Ablaufdiagramm eines Verfahrens zum Betrieb des in Figur 1 gezeigten Planarantriebssystems 10. Figur 6 zeigt einen Ausschnitt des in Figur 1 gezeigten Planarantriebssystems 10 nach einem zweiten Verfahrensschritt 310. Figur 7 zeigt einen Ausschnitt des in Figur 1 gezeigten Planarantriebssystems 10 nach einem dritten Verfahrensschritt 315. Figur 8 zeigt einen Ausschnitt des in Figur 1 gezeigten Planarantriebssystems 10 nach einem vierten Verfahrensschritt 320. Figur 9 zeigt einen Ausschnitt des in Figur 1 gezeigten Planarantriebssystems 10 nach einem fünften Verfahrensschritt 325. Figur 10 zeigt einen Ausschnitt des in Figur 1 gezeigten Planarantriebssystems 10 nach einem sechsten Verfahrensschritt 330 und/oder während eines siebten Verfahrensschritt 335. Figur 11 zeigt einen Ausschnitt des in Figur 1 gezeigten Planarantriebssystems 10 nach einem elften Verfahrensschritt 355. Figur 12 zeigt einen Ausschnitt des in Figur 1 gezeigten Planarantriebssystems 10 nach einem dreizehnten Verfahrensschritt 365. Figur 13 zeigt das in Figur 1 gezeigte Planarantriebssystem 10 nach einem vierzehnten Verfahrensschritt 370. Figur 14 zeigt das in Figur 1 gezeigte Planarantriebssystem 10 nach einem fünfzehnten Verfahrensschritt 375.

Im Folgenden wird das Verfahren zum Betrieb des Planarantriebssystems 10 anhand der ersten Fördereinrichtung 55 und der zweiten Fördereinrichtung 60 exemplarisch für die beiden Fördereinrichtungen 55, 60 erläutert. Es wird darauf hingewiesen, dass zur Verbesserung einer Auslastung des Planarantriebssystems 10 das Planarantriebssystem 10 eine Vielzahl von Fördereinrichtungen 55, 60 aufweist, die die im Folgenden beschriebenen Verfahrensschritte seriell-parallel durchführen.

In einem ersten Verfahrensschritt 305 (vgl. Figur 1) wird die erste Fördereinrichtung 55 mit einem Werkstück 75, beispielsweise mit einer I/O-Klemme bestückt und das Werkstück 75 an dem Werkstückträger 70 angeordnet. In analoger Weise kann ebenso zusätzlich oder alternativ auch die zweite Fördereinrichtung 60 mit einem Werkstück 75 am Werkstückträger 70 bestückt werden.

Im zweiten Verfahrensschritt 310 (vgl. Figur 6) wird die erste Fördereinrichtung 55 vor die erste Gehäuseöffnung 135 bewegt. Die Bewegung kann im Wesentlichen kontaktfrei zu der Moduloberseite 40 erfolgen, sodass Erschütterungen des Werkstücks 75 vermieden werden.

Ferner wird die erste Schleusenglocke 120, sofern sie sich nicht in der ersten Position befindet, um die erste Drehachse 115 in die erste Position gedreht. Dadurch ist die erste Gehäuseöffnung 135 durch den ersten Torabschnitt 145 nicht verschlossen und der erste Schleusenraum 155 ist für die erste Fördereinrichtung 55 vom Transportbereich 45 aus geöffnet.

Die zweite Fördereinrichtung 60 (in Figur 6 nicht dargestellt) kann während des zweiten Verfahrensschritts 310 ebenso in Richtung der ersten Gehäuseöffnung 135 innerhalb des Transportbereichs 45 bewegt werden, wobei jedoch die zweite Fördereinrichtung 60 in einer Reihe hinter der ersten Fördereinrichtung 55 angeordnet ist.

Die erste Fördereinrichtung 55 wird im dritten Verfahrensschritt 315 (vgl. Figur 7) über die erste Gehäuseöffnung 135 und die erste Schleusenöffnung 150 in den ersten Schleusenraum 155 eingefahren. Durch die maximierte Überdeckung in y-Richtung der ersten Schleusenöffnung 150 und der ersten Gehäuseöffnung 135 kann ein Anschlagen der ersten Fördereinrichtung 55 an der ersten Schleusenglocke 120 und/oder an dem ersten Schleusengehäuse 110 vermieden werden.

Die erste Fördereinrichtung 55 wird im ersten Schleusenraum 155 vorzugsweise derart gestoppt, dass die erste Fördereinrichtung 55 im Wesentlichen zentriert auf der ersten Drehachse 115 angeordnet und dadurch durch die erste Schleusenglocke 120 umfangsseitig umschlossen ist.

Dadurch dass beim Verfahren der ersten Fördereinrichtung 55 das Magnetfeld des Statormoduls 30, 35 die erste Fördereinrichtung 55 über die Moduloberseite 40 schwebend bewegt wird, kann die erste Fördereinrichtung 55 mögliche kleinere Erhebungen auf der Moduloberseite 40, beispielsweise Gehäusestege 550, 560 des ersten Schleusengehäuses 110, oder Verschmutzungen berührungslos überfahren, sodass Erschütterungen des Werkstücks 75 vermieden werden und ein Verschleiß an der ersten Fördereinrichtung 55 und an dem Schleusengehäuse 110 minimiert ist.

In einem auf den dritten Verfahrensschritt 315 (vgl. Figur 7) folgenden vierten Verfahrensschritt 320 (vgl. Figur 8) wird die erste Schleusenglocke 120 um die erste Drehachse 115 aus der ersten Position in die zweite Position gedreht, sodass der erste Torabschnitt 145 die erste Gehäuseöffnung 135 auf der zum Transportbereich 45 zugewandten Seite verschließt und die erste Schleusenöffnung 150 auf der zur zweiten Gehäuseöffnung 140 zugewandten Seite ausgerichtet ist. Der erste Schleusenraum 155 ist zum Arbeitsraum 50, insbesondere zum ersten Wartebereich 165, hin geöffnet.

Während des vierten Verfahrensschritts 320 kann die erste Fördereinrichtung 55 in ihrer Position in dem ersten Schleusenraum 155 verbleiben oder durch eine entsprechende Bestromung der Spulenleiter um die erste Drehachse 115 gedreht werden oder innerhalb des ersten Schleusenraums 155 bewegt oder gekippt werden.

Im fünften Verfahrensschritt 325 (vgl. Figur 9) wird die erste Fördereinrichtung 55 zusammen mit dem an der ersten Fördereinrichtung 55 angeordneten Werkstück 75 aus dem ersten Schleusenraum 155 durch die erste Schleusenöffnung 150 und die zweite Gehäuseöffnung 140 in den ersten Wartebereich 165 verfahren.

Im ersten Wartebereich 165 kann die erste Fördereinrichtung 55 auf der Moduloberseite 40 abgesetzt werden, damit ein vordefiniertes Zeitintervall, insbesondere bis der erste Arbeitsbereich 160 (frei-)geräumt ist und die Bearbeitungseinheit 95 einsatzfähig ist, abgewartet werden kann. Auch kann die erste Fördereinrichtung 55 ohne Stopp und/oder Absetzen auf der Moduloberseite 40 den ersten Wartebereich 165 hin zu dem ersten Arbeitsbereich 160 durchschweben. Ein Absetzen der Fördereinrichtung 55, 60 kann zur Einsparung von Energie zur Bestromung der Statormodulanordnung 25 oder zur Verringerung von Abwärme der Statormodulanordnung 25 dienen.

Ferner kann während des fünften Verfahrensschritts 325 die zweite Fördereinrichtung 60 an die erste Gehäuseöffnung 135 hin gefahren werden, sodass nach dem fünften Verfahrensschritt 325 die zweite Fördereinrichtung 60 im Wesentlichen direkt vor der ersten Gehäuseöffnung 135 angeordnet ist. Die erste Gehäuseöffnung 135 ist jedoch während des fünften Verfahrensschritts 325 durch den ersten Torabschnitt 145 vollständig verschlossen.

Im sechsten Verfahrensschritt 330 (vgl. Figur 10) wird durch den ersten Schleusenantrieb 125 die erste Schleusenglocke 120 aus der zweiten Position wieder in die erste Position um die erste Drehachse 115 gedreht, sodass die erste Schleusenöffnung 150 auf der zur ersten Gehäuseöffnung 135 zugewandten Seite angeordnet ist und der erste Schleusenraum 155 über die erste Gehäuseöffnung 135 zugänglich ist.

In einem siebten Verfahrensschritt 335 (vgl. Figur 10), der im Wesentlichen zeitgleich zu dem sechsten Verfahrensschritt 330 durchgeführt werden kann, wird die erste Fördereinrichtung 55 durch das Magnetfeld gegebenenfalls wieder angehoben und aus dem ersten Wartebereich 165 in den ersten Arbeitsbereich 160 beispielsweise entlang der Längsrichtung oberhalb der Moduloberseite 40 schwebend bewegt, vorzugsweise wenn die Bearbeitungseinheit 95 einsatzbereit ist und der erste Arbeitsbereich 160 frei, das heißt nicht durch eine andere Fördereinheit 55, 60 belegt ist.

Im ersten Arbeitsbereich 160 kann die erste Fördereinrichtung 55 auf die Moduloberseite 40 abgesenkt werden. Dabei kann die erste Fördereinrichtung 55 das im Werkstückträger 70 angeordnete Werkstück 75 an der Bearbeitungseinheit 95 in einen Werkstückbearbeitungsträger 705 (in Figur 10 strichliert dargestellt) einlegen, sodass eine definierte Ausrichtung des Werkstücks 75 relativ zur Bearbeitungseinheit 95 sichergestellt ist.

Alternativ wird auf den Werkstückbearbeitungsträger 705 verzichtet und die erste Fördereinrichtung 55 trägt im ersten Arbeitsbereich 160 das zu bearbeitende Werkstück 75.

In einem achten Verfahrensschritt 340 (vgl. Figur 10), der auf den siebten Verfahrensschritt 335 folgen kann, wird die Bearbeitungseinheit 95 aktiviert. Die Bearbeitungseinheit 95 bearbeitet das Werkstück 75 mittels des Bearbeitungsmoduls 96. Bei der Bearbeitung kann beispielsweise das Bearbeitungsmodul 96 relativ zum Werkstück 75 im Werkstückbearbeitungsträger 705 bewegt werden. Bei Verzicht auf den Werkstückbearbeitungsträger 705 kann auch die erste Fördereinrichtung 55 das Werkstück 75 relativ zu dem Bearbeitungsmodul 96 bewegen.

Die Bearbeitung des Werkstücks 75 kann mechanisch und/oder chemisch erfolgen. Insbesondere ist hier eine formgebende Bearbeitung des Werkstücks 75 möglich. So ist insbesondere eine trockene oder eine nasse Bearbeitung mit Kühlflüssigkeit durch das Bearbeitungsmodul 96 möglich. Beispielsweise kann das Bearbeitungsmodul 96 das Werkstück 75 spanend, beispielsweise fräsend und/oder drehend und/oder schleifend und/oder bohrend bearbeiten. Auch ist möglich, dass beispielsweise das Bearbeitungsmodul 96 das Werkstück 75 chemisch, beispielsweise ätzend und/oder eloxierend bearbeitet. Auch ist ein Schichtauftrag in der Bearbeitung wie beispielsweise im Rahmen eines Sprühauftrags, wie beispielsweise ein Lackieren möglich.

Die im Rahmen der Bearbeitung entstehenden Emissionen, wie beispielsweise Schleifstaub, Spanabtrag, Kühlwasserspritzer, Ätzdämpfe, Dämpfe, Nebel verbleiben im Arbeitsraum 50 und ein direktes Ausdringen aus dem Arbeitsraum 50 in den Transportbereich 45 wird durch die unabhängig von der Verdrehung der ersten Schleusenglocke 120 und der zweiten Schleusenglocke 175 den Arbeitsraum 50 verschließende erste Schleuseneinheit 85 und zweite Schleuseneinheit 90 vermieden.

Um die Emissionen aus dem Arbeitsraum 50 auszufördern, kann die Bearbeitungsstation 20 an eine Absaugung (nicht dargestellt) und/oder einen Kühlmittelkreislauf angeschlossen sein. Dabei ist eine geringfügige Nachströmung von Luft aus dem Transportbereich 45 über den ersten Gehäuseinnenraum 130 und/oder den zweiten Gehäuseinnenraum 200 möglich. Dadurch kann eine Verunreinigung des Transportbereichs 45 mit Emissionen, entstehend im ersten Arbeitsbereich 160, vermieden werden.

Auch kann im achten Verfahrensschritt 340 das als Sendemodul 100 ausgebildete Bearbeitungsmodul 96 aktiviert werden. Das Sendemodul 100 sendet die elektromagnetische Strahlung 105, insbesondere die Laserstrahlung, aus. Die elektromagnetische Strahlung 105 wird auf das Werkstück 75 gerichtet und kann vorzugsweise gezielt gelenkt werden, um das Werkstück 75 zu bearbeiten. Insbesondere können hierfür beispielsweise Verstellmöglichkeiten in der Bearbeitungseinheit 95, beispielsweise Spiegel und/oder Prismen, vorgesehen sein, um die Ausrichtung der elektromagnetischen Strahlung 105 in ihrer Richtung auf das Werkstück 75 zu verändern. Alternativ ist auch möglich, dass bei Verzicht auf den Werkstückbearbeitungsträger 705 und bei dem Ablegen des Werkstücks 75 am Werkstückbearbeitungsträger 705 im sechsten Verfahrensschritt 330 die erste Fördereinrichtung 55 das Werkstück 75 unter Einwirkung der elektromagnetischen Strahlung 105 auf das Werkstück 75 bewegt.

Dabei kann beispielsweise das Werkstück 75 mittels der elektromagnetischen Strahlung 105 erwärmt, insbesondere erhitzt, beispielsweise gelötet oder geschweißt, und/oder geschnitten und/oder graviert und/oder gereinigt und/oder oder Material vom Werkstück 75 abgetragen wird.

In einem neunten Verfahrensschritt 345 (vgl. Figur 10), der im Wesentlichen auch zeitgleich zu dem achten Verfahrensschritt 340 durchgeführt werden kann, kann die zweite Fördereinrichtung 60 über die erste Gehäuseöffnung 135 und die erste Schleusenöffnung 150 in den ersten Schleusenraum 155 einfahren. Der neunte Verfahrensschritt 345 entsprich im Wesentlichen dem dritten Verfahrensschritt 315 für die erste Fördereinrichtung 55.

Dabei verhindert sowohl die erste Schleusenglocke 120 als auch die zweite Schleusenglocke 175 während der Bearbeitung des Werkstücks 75 im Arbeitsraum 50 den Austritt der Emissionen aus dem Arbeitsraum 50, insbesondere dem ersten Arbeitsbereich 160, über die erste Schleuseneinheit 85, auch wenn die erste Schleusenglocke 120 zwischen dem ersten Positionsbereich und dem zweiten Positionsbereich um die erste Drehachse 115 gedreht wird.

Nach Abschluss der Bearbeitung des Werkstücks 75 wird in einem auf den neunten Verfahrensschritt 345 folgenden zehnten Verfahrensschritt 350 die erste Fördereinrichtung 55 wieder angehoben, sodass die erste Fördereinrichtung 55 das bearbeitete Werkstück 75 wieder aufnimmt und aus der Haltevorrichtung der Bearbeitungseinheit 95 entnimmt. Der zehnte Verfahrensschritt 350 ist nicht notwendig, wenn im siebten Verfahrensschritt 335 die erste Fördereinrichtung 55 nicht auf die Moduloberseite 40 abgesenkt wird und auf den Werkstückbearbeitungsträger 705 verzichtet wird.

Im elften Verfahrensschritt 355 (vgl. Figur 11) wird die zweite Schleusenglocke 175 aus der dritten Position um die zweite Drehachse 185 in die vierte Position verdreht, sodass die zweite Schleusenöffnung 210 auf der zur vierten Gehäuseöffnung 195 zugewandten Seite angeordnet ist und der zweite Schleusenraum 205 über die vierte Gehäuseöffnung 195 und die zweite Schleusenöffnung 210, insbesondere vom ersten Arbeitsbereich 160 aus, zugänglich ist.

Ferner kann zeitgleich zu oder unabhängig von der Verdrehung der zweiten Schleusenglocke 175 die erste Schleusenglocke 120 aus der ersten Position in die zweite Position um die erste Drehachse 115 gedreht werden, sodass die erste Schleusenöffnung 150 auf der zur zweiten Gehäuseöffnung 140 zugewandten Seite angeordnet ist und der erste Schleusenraum 155 von dem ersten Wartebereich 165 aus über die zweite Gehäuseöffnung 140 und die erste Schleusenöffnung 150 frei zugänglich ist. An der ersten Gehäuseöffnung 135 wird der erste Schleusenraum 155 durch den ersten Torabschnitt 145 abgetrennt.

In einem auf den elften Verfahrensschritt 355 folgenden zwölften Verfahrensschritt 360 (vgl. Figur 11) wird die zweite Fördereinrichtung 60 analog zum fünften Verfahrensschritt 325 aus dem ersten Schleusenraum 155 über die erste Schleusenöffnung 150 und die zweite Gehäuseöffnung 140 in den ersten Wartebereich 165 bewegt. Im ersten Wartebereich 165 kann die zweite Fördereinrichtung 60 auf der Moduloberseite 40 abgesetzt werden.

In dem dreizehnten Verfahrensschritt 365 (vgl. Figur 12) wird die erste Fördereinrichtung 55 zusammen mit dem fertig bearbeiteten Werkstück 75 aus dem ersten Arbeitsbereich 160 beispielsweise entlang der y-Achse durch die vierte Gehäuseöffnung 195 und die zweite Schleusenöffnung 210 in den zweiten Schleusenraum 205 derart eingefahren, dass umfangsseitig die erste Fördereinrichtung 55 beabstandet zu dem zweiten Torabschnitt 215 angeordnet ist und dadurch eine Verdrehung der zweiten Schleusenglocke 175 um die zweite Drehachse 185 nicht blockiert ist. Dazu kann beispielsweise die erste Fördereinrichtung 55 zentriert in dem zweiten Schleusenraum 205 angeordnet sein.

Die dritte Gehäuseöffnung 190 ist durch den der dritten Gehäuseöffnung 190 zugewandten zweiten Torabschnitt 215 hin zum Transportbereich 45 verschlossen. Die zweite Fördereinrichtung 60 kann im ersten Wartebereich 165 derweil das Freimachen des ersten Arbeitsbereichs 160 abwarten.

In dem vierzehnten Verfahrensschritt 370 (vgl. Figur 13) wird die zweite Schleusenglocke 175 um die zweite Drehachse 185 aus der vierten Position zurück in die dritte Position verdreht, sodass die zweite Schleusenöffnung 210 auf der dritten Gehäuseöffnung 190 zugewandt angeordnet ist und der zweite Schleusenraum 205 über die dritte Gehäuseöffnung 190 zum Transportbereich 45 hin geöffnet ist.

Durch die unabhängige Verdrehbarkeit mittels des ersten Schleusenantriebs 125 kann die erste Schleusenglocke 120 während des vierzehnten Verfahrensschritts 370 in der zweiten Position verbleiben.

In dem fünfzehnten Verfahrensschritt 375 (vgl. Figur 14) bewegt sich die erste Fördereinrichtung 55 mit dem bearbeiteten Werkstück 75 über die zweite Schleusenöffnung 210 und die dritte Gehäuseöffnung 190 in den Transportbereich 45. Der zweite Torabschnitt 215 verschließt an der vierten Gehäuseöffnung 195 den zweiten Schleusenraum 205.

Für die zweite Fördereinrichtung 60 werden der siebte und achte Verfahrensschritt 335, 340, der zehnte und elfte Verfahrensschritt 350, 355 sowie der dreizehnte bis fünfzehnte Verfahrensschritt 365, 370, 375 wiederholt.

Im Transportbereich 45 können die erste Fördereinrichtung 55 und die zweite Fördereinrichtung 60 frei weiterbewegt werden, um beispielsweise das jeweils fertig bearbeitete Werkstück 75 in einem Magazin abzulegen oder hin zu einer weiteren Bearbeitungs- oder Verarbeitungsstation zu transportieren.

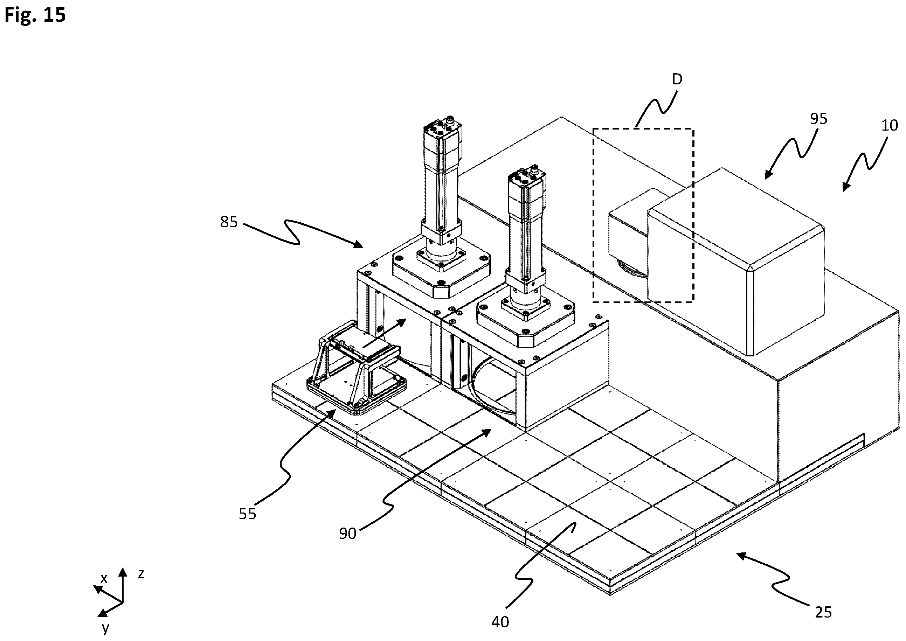

Figur 15 zeigt eine perspektivische Darstellung eines Planarantriebssystems 10 gemäß einer zweiten Ausführungsform.

Das Planarantriebssystem 10 bildet dabei im Wesentlichen die konstruktive Ausgestaltung des in den vorangegangenen Figuren gezeigten Planarantriebssystems 10 aus und ist in seiner schematischen Ausgestaltung identisch zu der in den Figuren 1 bis 4, 6 bis 14 beschriebenen ersten Ausführungsform des Planarantriebssystems 10. Ferner wird darauf hingewiesen, dass das in Figur 15 gezeigte Planarantriebssystem 10 gemäß der zweiten Ausführungsform mit dem in Figur 5 erläuterten Verfahren zum Betrieb des Planarantriebssystems 10 betrieben werden kann.

In den nachfolgenden Figuren wird zur Darstellung der zweiten Ausführungsform jeweils auf die konstruktiven Details des Planarantriebssystems 10 eingegangen. Ebenso wie in den Figuren 1 bis 4, 6 bis 14 ist auch die zweite Schleuseneinheit 90 identisch zu der ersten Schleuseneinheit 85 ausgebildet. Im Rahmen dessen werden die erste Schleuseneinheit 85 und die zweite Schleuseneinheit 90 gemeinsam beschrieben, wobei jedoch hinsichtlich der Bezugszeichen jeweils die Bezugszeichen der ersten Schleuseneinheit 85 und die Bezugszeichen der zweiten Schleuseneinheit 90 verwendet werden.

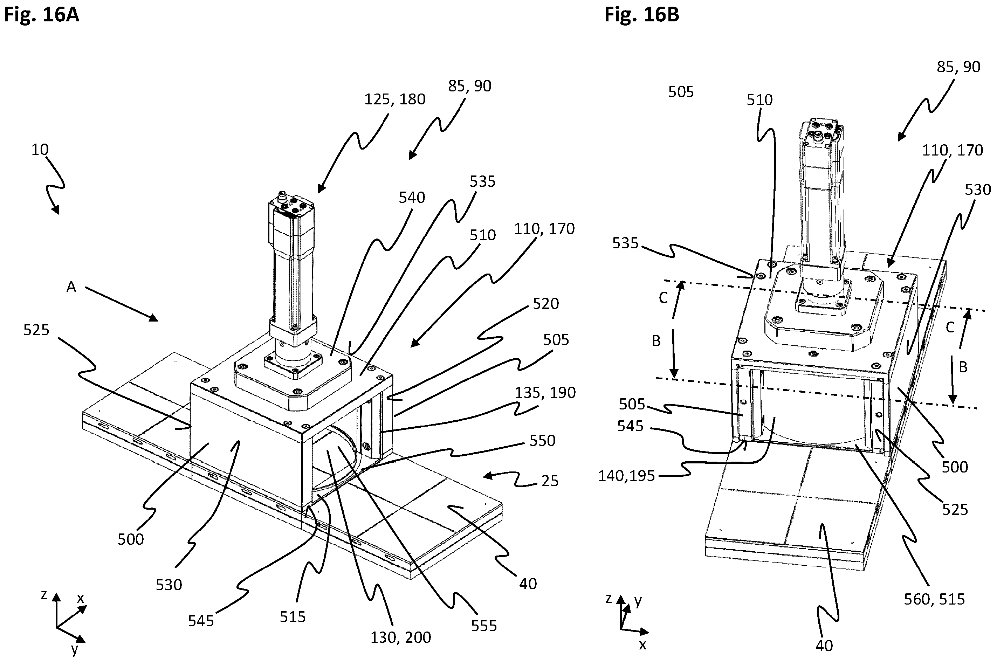

Figur 16A zeigt eine perspektivische Darstellung der ersten Schleuseneinheit 85 und der zweiten Schleuseneinheit 90 des in Figur 15 gezeigten Planarantriebssystems 10.

Das erste und zweite Schleusengehäuse 110, 170 weist jeweils ein erstes Schleusengehäuseteil 500, ein zweites Schleusengehäuseteil 505, einen Schleusengehäusedeckel 510 und einen Schleusengehäuseboden 515 auf. Der Schleusengehäusedeckel 510 kann dabei auf einer der Statormodulanordnung 25 abgewandten Seite in z-Richtung an dem ersten und zweiten Schleusengehäuseteil 500, 505 angeordnet sein. Das erste Schleusengehäuseteil 500 und das zweite Schleusengehäuseteil 505 sind in Längsrichtung gegenüberliegend angeordnet.

An einer ersten Stirnseite 520 des ersten Schleusengehäuseteils 500 und des zweiten Schleusengehäuseteils 505 ist die erste Gehäuseöffnung 135 bei der ersten Schleuseneinheit 85 und stattdessen die dritte Gehäuseöffnung 190 bei der zweiten Schleuseneinheit 90 angeordnet.

In y-Richtung gegenüberliegend ist an dem Schleusengehäuseteil 500 eine zweite Stirnseite 525 angeordnet. Sowohl die erste als auch die dritte Gehäuseöffnung 135, 190 können dabei im Wesentlichen eine rechteckförmige Ausgestaltung aufweisen.

In Querrichtung erstreckt sich an einer äußeren Umfangsseite an dem ersten Schleusengehäuseteil 500 zwischen der ersten Stirnseite 520 und der zweiten Stirnseite 525 eine erste Seitenfläche 530, die vorzugsweise plan ausgebildet ist und sich im Wesentlichen in einer yz-Ebene erstrecken kann. In Längsrichtung gegenüberliegend weist das zweite Schleusengehäuseteil 505 eine zweite Seitenfläche 535 auf, die parallel zu der ersten Seitenfläche 530 ausgerichtet ist. Auch die zweite Seitenfläche 535 kann plan ausgebildet sein und sich beispielsweise in einer yz-Ebene erstrecken. Auch die zweite Seitenfläche 535 verbindet die erste Stirnseite 520 mit der zweiten Stirnseite 525.

Das erste Schleusengehäuse 110 und/oder das zweite Schleusengehäuse 170 können in ihrer Erstreckung in x- und/oder y-Richtung an eine geometrische Ausgestaltung des ersten Statormoduls 30 und/oder des zweiten Statormoduls 35 entsprechen, sodass jeweils die erste Seitenfläche 530 und die zweite Seitenfläche 535 und/oder die erste Stirnseite 520 und/oder die zweite Stirnseite 525 bündig zu einer entsprechenden Statormodulseitenfläche des ersten Statormoduls 30 oder des zweiten Statormoduls 35 ausgebildet sind.

Der Schleusengehäusedeckel 510 ist plattenförmig ausgebildet und mit dem ersten Schleusengehäuseteil 500 und dem zweiten Schleusengehäuseteil 505 verbunden. Der Schleusengehäusedeckel 510 begrenzt in z-Richtung den ersten Gehäuseinnenraum 130 des ersten Schleusengehäuses 110 und entsprechend bei der zweiten Schleuseneinheit 90 den zweiten Gehäuseinnenraum 200 in z-Richtung. Umfangsseitig wird der erste Gehäuseinnenraum 130 und entsprechend auch der zweite Gehäuseinnenraum 200 durch das jeweilige erste und zweite Schleusengehäuseteil 500, 505 begrenzt.

Auf der zur Statormodulanordnung 25 abgewandten Seite kann auf dem Schleusengehäusedeckel 510 ein Antriebsflansch 540 befestigt sein, wobei oberseitig und somit auf der der Statormodulanordnung 25 abgewandten Seite an dem Antriebsflansch 540 der jeweilige erste Schleusenantrieb 125 der ersten Schleuseneinheit 85 oder der zweite Schleusenantrieb 180 der zweiten Schleuseneinheit 90 angeordnet und befestigt ist.

Unterseitig des ersten Schleusengehäuseteils 500 und des zweiten Schleusengehäuseteils 505 ist der Schleusengehäuseboden 515 angeordnet und mit dem ersten Schleusengehäuseteil 500 und dem zweiten Schleusengehäuseteil 505 verbunden. Der Schleusengehäuseboden 515 liegt mit einer Unterseite 545 direkt auf der Moduloberseite 40 auf. Dabei kann der Schleusengehäuseboden 515 einen ersten Gehäusesteg 550 aufweisen, der in z-Richtung zwischen der ersten Gehäuseöffnung 135 und der Unterseite 545 bzw. für die zweite Schleuseneinheit 90 zwischen der dritten Gehäuseöffnung 190 und der Unterseite 545 angeordnet ist. Der erste Gehäusesteg 550 weist eine plattenförmige, im Wesentlichen dünnwandige Ausgestaltung auf. Insbesondere ist eine Erstreckung in z-Richtung des ersten Gehäusestegs 550 kleiner als eine maximale Bewegungsfreiheit bzw. Anhebemöglichkeit der Basiseinheit 65 der jeweiligen Fördereinrichtung 55, 60 über die Moduloberseite 40.

Der Schleusengehäuseboden 515 weist an der Unterseite 545 eine Durchgangsöffnung 555 auf, wobei sich die Durchgangsöffnung 555 zwischen der Unterseite 545 und dem ersten Gehäuseinnenraum 130 bei der ersten Schleuseneinheit 85 oder bei der zweiten Schleuseneinheit 90 zwischen der Unterseite 545 und dem zweiten Gehäuseinnenraum 200 erstreckt. Die Durchgangsöffnung 555 kann im Wesentlichen eine kreisförmige Ausgestaltung aufweisen. Durch die Durchgangsöffnung 555 ist die Moduloberseite 40 zum ersten Gehäuseinnenraum 130 hin bzw. zum zweiten Gehäuseinnenraum 200 hin offen und unbedeckt.

In der Ausführungsform sind zumindest der Schleusengehäuseboden 515, vorzugsweise auch das erste und zweite Schleusengehäuseteil 500, 505 sowie der Schleusengehäusedeckel 510 aus einem Aluminiumwerkstoff gefertigt. Auch wäre möglich, das Schleusengehäuseteil 500 und/oder den Schleusengehäusedeckel 510 beispielsweise auch aus einem Kunststoff oder einem paramagnetischen Werkstoff herzustellen.

Dabei kann zumindest innenseitig das erste Schleusengehäuse 110 und/oder das zweite Schleusengehäuse 170 mit einer nicht-reflektierenden Eloxierung, insbesondere mit einer grauen oder schwarzen Eloxierung bei einem Aluminiumwerkstoff, versehen sein.

Dadurch kann eine Reflexion der elektromagnetischen Strahlung 105 im Wesentlichen vermieden werden. Ferner eignen sich der Aluminiumwerkstoff und/oder der Kunststoff und/oder das paramagnetische Material gut dazu, dass das durch die Statormodulanordnung 25 erzeugte Magnetfeld, zum Antrieb der Fördereinrichtung 55, 60, insbesondere im Bereich des ersten Gehäusestegs 550, auf die Fördereinrichtung 55, 60 wirken kann, um die Fördereinrichtung 55, 60 sowohl anzuheben als auch anzutreiben.

Figur 16B zeigt eine weitere perspektivische Darstellung des in Figur 16A gezeigten Planarantriebssystems 10 aus einer in Figur 16A gezeigten Blickrichtung A.

An der zweiten Stirnseite 525 weist das erste Schleusengehäuseteil 500 die zweite Gehäuseöffnung 140 der ersten Schleuseneinheit 85 und die vierte Gehäuseöffnung 195 der zweiten Schleuseneinheit 90 auf. Ferner weist der Schleusengehäuseboden 515 einen zweiten Gehäusesteg 560 auf, wobei der zweite Gehäusesteg 560 zwischen der Moduloberseite 40 und der zweiten Gehäuseöffnung 140 bei der ersten Schleuseneinheit 85 sowie zwischen der Unterseite 545 und der vierten Gehäuseöffnung 195 der zweiten Schleuseneinheit 90 angeordnet ist.

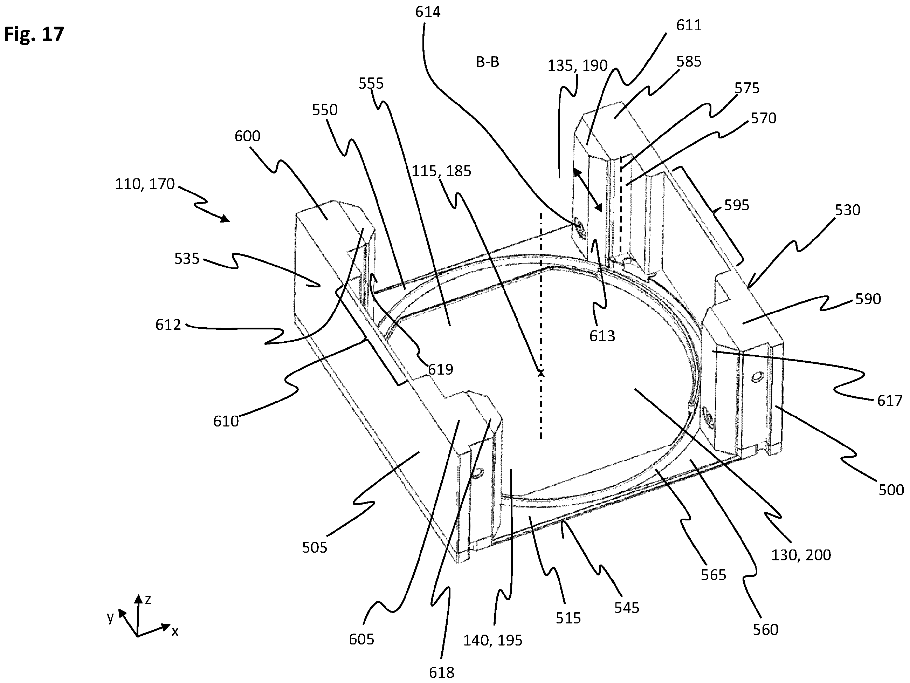

Figur 17 zeigt eine Schnittansicht entlang einer in Figur 16 gezeigten Schnittebene B-B durch das in Figur 16 gezeigte erste und zweite Schleusengehäuse 110, 170. Die Schleusenglocke 120, 175 ist zur Übersichtlichkeit nicht dargestellt.

Der Schleusengehäuseboden 515 weist eine im Wesentlichen plattenförmige Ausgestaltung auf. An einer zur Unterseite 545 abgewandten Seite sind das erste Schleusengehäuseteil 500 und das zweite Schleusengehäuseteil 505 in Längsrichtung beabstandet zueinander angeordnet.

Der Schleusengehäuseboden 515 weist eine erste Führungsnut 565 auf, wobei sich die erste Führungsnut 565 jeweils um die zugeordnete erste Drehachse 115 bzw. zweite Drehachse 185 auf einer Kreisbahn erstreckt. Die erste Führungsnut 565 ist auf der zur Unterseite 545 abgewandten Seite offen ausgebildet und kann im Wesentlichen ein rechteckförmiges Profil aufweisen. Insbesondere kann sich die erste Führungsnut 565 umfangsseitig an die Durchgangsöffnung 555 anschließen und sich jeweils über den ersten Gehäusesteg 550 und/oder den zweiten Gehäusesteg 560 des Schleusengehäusebodens 515 erstrecken.

Das erste Schleusengehäuseteil 500 und das zweite Schleusengehäuseteil 505 sind innenseitig vorzugsweise gestuft ausgebildet.

Zusätzlich kann am ersten Schleusengehäuseteil 500 und/oder an dem zweiten Schleusengehäuseteil 505 eine Dichtungsaufnahme 570 vorgesehen sein, die sich ferner in z-Richtung innenseitig an dem Schleusengehäuseteil 500 erstrecken kann.

In der Dichtungsaufnahme 570 kann eine Dichtung 575 (strichliert in Figur 17 dargestellt) angeordnet sein. Die Dichtung 575 kann insbesondere als aufblasbare Dichtung mit einem Druckraum ausgebildet sein.

Das erste Schleusengehäuseteil 500 und das zweite Schleusengehäuseteil 505 können achsensymmetrisch zu einer Symmetrieachse, die sich durch die erste Drehachse 115 oder die zweite Drehachse 185 erstreckt, ausgebildet sein.

Dabei kann das erste Schleusengehäuseteil 500 ein erstes Trägerelement 585 und ein zweites Trägerelement 590 aufweisen, die jeweils beispielsweise balkenförmig ausgeformt sind und sich in z-Richtung entlang der z-Achse vom Schleusengehäuseboden 515 in Richtung des Schleusengehäusedeckels 510 erstrecken.

Zwischen dem ersten Trägerelement 585 und dem zweiten Trägerelement 590 kann das erste Schleusengehäuseteil 500 beispielsweise einen ersten Wandungsabschnitt 595 aufweisen, der plattenförmig ausgebildet ist und sich radial außenseitig an die erste Führungsnut 565 in einem Eckbereich anschließt. Ferner erstreckt sich der erste Wandungsabschnitt 595 in z-Richtung zwischen dem Schleusengehäuseboden 515 und dem Schleusengehäusedeckel 510, sodass an der ersten Seitenfläche 530 der erste Gehäuseinnenraum 130 bzw. der zweite Gehäuseinnenraum 200 verschlossen ist.

Das zweite Schleusengehäuseteil 505 weist statt dem ersten Trägerelement 585 ein drittes Trägerelement 600 und ein in Querrichtung gegenüber zum dritten Trägerelement 600 angeordnetes viertes Trägerelement 605 auf. Auch das dritte und vierte Trägerelement 600, 605 sind jeweils radial außenseitig zu der ersten Führungsnut 565 angeordnet und bevorzugt im Eckbereich platziert.

Ausgehend von dem Schleusengehäuseboden 515 erstrecken sich das dritte Trägerelement 600 und das vierte Trägerelement 605 parallel zur ersten Drehachse 115 oder zur zweiten Drehachse 185 in z-Richtung hin bis zum Schleusengehäusedeckel 510. In Querrichtung zwischen dem dritten und vierten Trägerelement 600, 605 weist das zweite Schleusengehäuseteil 505 einen zweiten Wandungsabschnitt 610 auf, der im Wesentlichen plattenförmig ausgebildet ist und nach außen hin zur zweiten Seitenfläche 535 den ersten Gehäuseinnenraum 130 oder den zweiten Gehäuseinnenraum 200 verschließt.

An dem ersten bis vierten Trägerelement 585, 590, 600, 605 kann vorzugsweise der Schleusengehäusedeckel 510, beispielsweise mittels einer Schraubverbindung, reversibel lösbar befestigt mit dem ersten Schleusengehäuseteil 500 und dem zweiten Schleusengehäuseteil 505 verbunden sein.

Ferner kann das erste Schleusengehäuse 110 wenigstens eine erste Spaltabdeckung 611 und vorzugsweise eine zweite Spaltabdeckung 612 aufweisen. Die erste Spaltabdeckung 611 kann eine im Wesentlichen trapezförmige Grundform aufweisen, die sich entlang der z-Achse mit im Wesentlichen konstantem Querschnitt erstreckt. Auf der zur ersten Drehachse 115 zugewandten Seite weist die erste Spaltabdeckung 611 eine erste Innenfläche 613 auf. Die erste Spaltabdeckung 611 ist beispielsweise an dem ersten Trägerelement 585 auf der zur ersten Gehäuseöffnung 135 bzw. der dritten Gehäuseöffnung 190 zugewandten Seite des ersten Trägerelements 585 angeordnet und verbunden.

Beispielsweise kann die erste Spaltabdeckung 611 mittels einer Schraubverbindung 614 an dem ersten Trägerelement 585 befestigt sein. Um eine Einstellbarkeit in y-Richtung der ersten Spaltabdeckung 611 zu ermöglichen, kann in der ersten Spaltabdeckung 611 ein Langloch (in Figur 17 verdeckt) angeordnet sein. Die Verstellbarkeit der ersten Spaltabdeckung 611 ist symbolisch in Figur 17 mittels eines Pfeils dargestellt.

Die zweite Spaltabdeckung 612 ist vorzugsweise identisch zu der ersten Spaltabdeckung 611 ausgebildet, sodass das für die erste Spaltabdeckung 611 Erläuterte ebenso auch für die zweite Spaltabdeckung 612 gilt. Abweichend ist jedoch die zweite Spaltabdeckung 612 an dem dritten Trägerelement 600 mittels der Schraubverbindung 614 einstellbar befestigt. Die zweite Spaltabdeckung 612 weist anstatt der ersten Innenfläche 613 eine zweite Innenfläche 619 auf.

Ferner kann zusätzlich oder alternativ an dem zweiten Trägerelement 590 eine dritte Spaltabdeckung 617 und/oder an dem vierten Trägerelement 605 eine vierte Spaltabdeckung 618 angeordnet sein, wobei die dritte Spaltabdeckung 617 identisch zur ersten Spaltabdeckung 611 und die vierte Spaltabdeckung 618 identisch zur zweiten Spaltabdeckung 612 ausgebildet sein kann.

Ferner kann an dem zweiten Trägerelement 590 und/oder an dem vierten Trägerelement 605 das Gehäuse 80 beispielsweise angeschraubt werden. Dazu kann beispielsweise das zweite Trägerelement 590 und/oder das vierte Trägerelement 605 entsprechend ausgeformt sein.

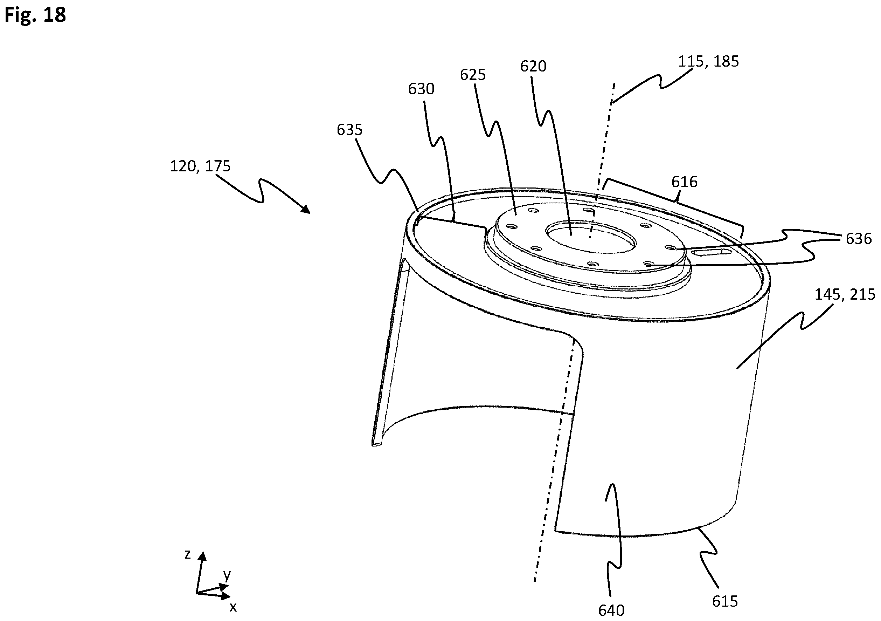

Figur 18 zeigt eine perspektivische Darstellung der ersten Schleusenglocke 120 und der zweiten Schleusenglocke 175.

Die erste Schleusenglocke 120 und die zweite Schleusenglocke 175 sind, wie bereits im Rahmen der Figuren 1 bis 14 erläutert, identisch zueinander ausgebildet. Auch in der zweiten Ausführungsform sind die erste Schleusenglocke 120 und die zweite Schleusenglocke 175 identisch zueinander ausgebildet.

Aus diesem Grund werden in der folgenden Erläuterung für die konstruktive Ausgestaltung der ersten Schleusenglocke 120 bzw. der zweiten Schleusenglocke 175 die bereits für die jeweilige Schleusenglocke 120, 175 verwendeten Bezugszeichen gemeinsam verwendet. Die erste Schleusenglocke 120 und/oder die zweite Schleusenglocke 175 weisen jeweils ein freies Ende 615 auf, das in axialer Richtung bezogen auf die Drehachse 115, 185 gegenüberliegend zu einem Scheibenabschnitt 616 der ersten Schleusenglocke 120 und/oder zweiten Schleusenglocke 175 angeordnet ist. Der Scheibenabschnitt 616 erstreckt sich im Wesentlichen in radialer Richtung und kann in einer Drehebene senkrecht zur ersten Drehachse 115 und/oder zweiten Drehachse 185 ausgerichtet sein. Radial außen ist der Scheibenabschnitt 616 mit dem ersten Torabschnitt 145 oder dem zweiten Torabschnitt 215 verbunden.

Der Scheibenabschnitt 616 weist radial innenseitig eine Kupplungsaufnahme 620 und radial außenseitig an der Kupplungsaufnahme 620 einen Sockel 625, einen Ringbereich 630 und eine Ausbuchtung 635 auf. Die Ausbuchtung 635 ist radial außenseitig anschließend an den Ringbereich 630 angeordnet, wobei sich der Ringbereich 630 ringförmig um die erste Drehachse 115 oder zweite Drehachse 185 erstreckt und sich radial außenseitig an den Sockel 625 anschließt. Stirnseitig überragt der Sockel 625 den Ringbereich 630 auf der zum freien Ende 615 abgewandten Seite. Ebenso überragt in axialer Richtung die Ausbuchtung 635 den Ringbereich 630. Radial innenseitig begrenzt der Sockel 625 die Kupplungsaufnahme 620 und überragt einen Grund der Kupplungsaufnahme 620 in axialer Richtung.

Im Sockel 625 können sich eine oder mehrere Bohrungen 636 befinden, die in Umfangsrichtung in regelmäßigem Abstand zueinander angeordnet sind.

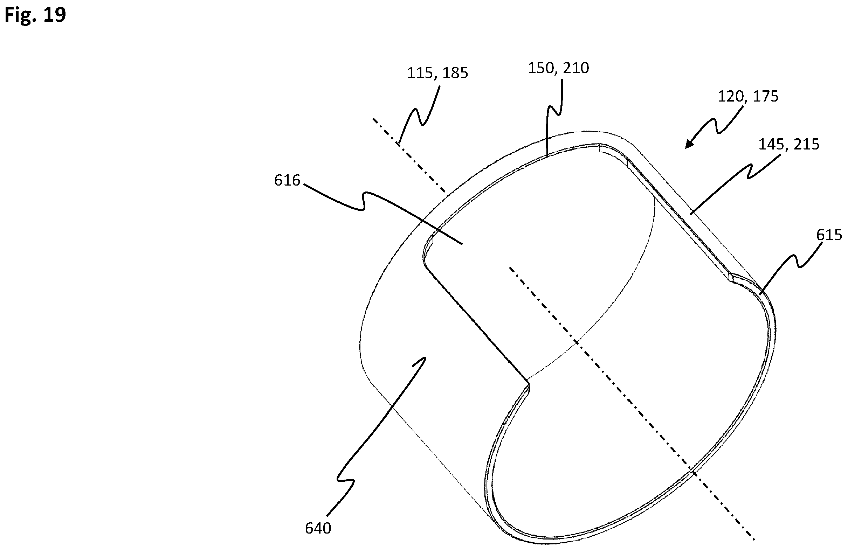

Figur 19 zeigt eine perspektivische Ansicht der in Figur 18 gezeigten ersten Schleusenglocke 120 und der zweiten Schleusenglocke 175.

Auf der zum freien Ende 615 zugewandten Seite des Scheibenabschnitts 616 kann der Scheibenabschnitt 616 im Wesentlichen plan ausgebildet sein, wobei in Figur 19 deutlich ersichtlich ist, dass sich der Torabschnitt 145, 215 direkt an den Scheibenabschnitt 616 anschließt und jeweils mit dem Scheibenabschnitt 616 verbunden ist. Vorzugsweise ist die erste Schleusenglocke 120 und/oder die zweite Schleusenglocke 175 einstückig und materialeinheitlich ausgebildet.

In axialer Richtung kann sich die erste Schleusenöffnung 150 oder die zweite Schleusenöffnung 210 ausgehend vom dem freien Ende 615 bis hin zum Scheibenabschnitt 616 in axialer Richtung erstrecken. Dabei kann die erste Schleusenöffnung 150 bzw. die zweite Schleusenöffnung 210 im Wesentlichen eine ringförmige Öffnung in dem jeweiligen Torabschnitt 145, 215 ausformen. An dem freien Ende 615 ist an der ersten Schleusenöffnung 150 und an der zweiten Schleusenöffnung 210 kein Material vorgesehen, und die erste Schleusenöffnung 150 und/oder die zweite Schleusenöffnung 210 ist am freien Ende 615 in axialer Richtung offen ausgeformt.

Umfangsseitig weisen der erste Torabschnitt 145 und der zweite Torabschnitt 215 eine äußere Umfangsseite 640 auf. Zumindest die äußere Umfangsseite 640 und die dem Schleusenraum 155, 205 zugewandten Oberflächen oder die gesamte Schleusenglocke 120, 175 kann eloxiert sein und/oder nicht-reflektierend hinsichtlich der elektromagnetischen Strahlung 105 behandelt sein.

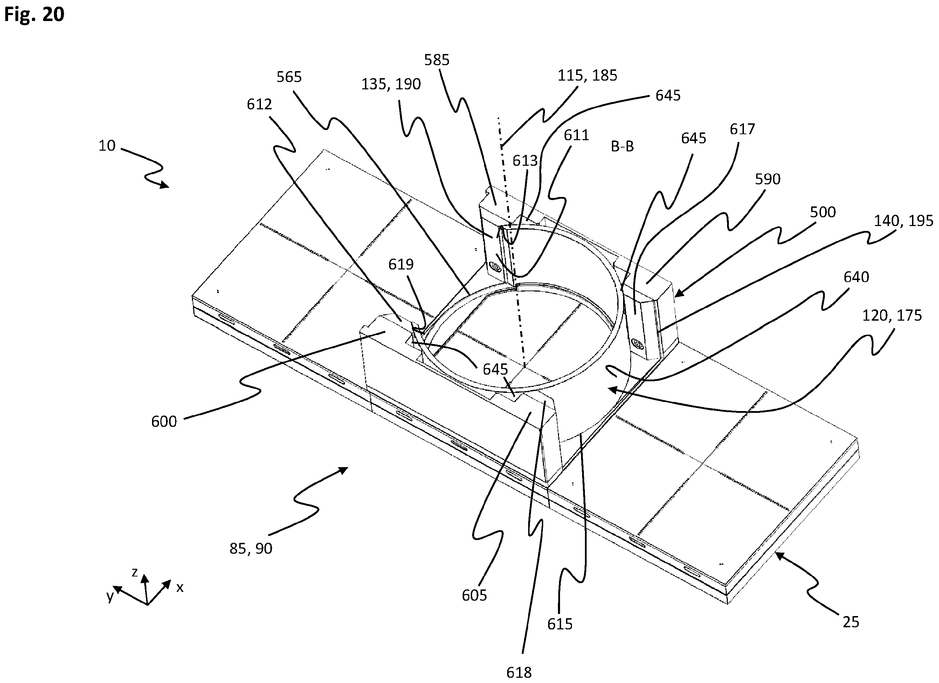

Figur 20 zeigt eine Schnittansicht entlang der in Figur 16B gezeigten Schnittebene B-B durch die erste Schleuseneinheit 85 bzw. zweite Schleuseneinheit 90.

In der Ausführungsform ist jeweils die äußere Umfangsseite 640 der ersten Schleusenglocke 120 bzw. der zweiten Schleusenglocke 175 derart zu dem ersten bis vierten Trägerelement 585, 590, 600, 605 ausgeformt, dass zwischen der äußeren Umfangsseite 640 und einem radial innenseitigen Ende des jeweiligen Trägerelements 585, 590, 600, 605 nur ein geringer Spalt 645 ausgebildet ist. Der Spalt 645 kann auch als Radialspalt bezeichnet werden.

Durch die gestufte Ausgestaltung des ersten Schleusengehäuseteils 500 und des zweiten Schleusengehäuseteils 505 innenseitig auf der zur Umfangsseite 640 zugewandten Seite kann zwar über den Spalt 645 elektromagnetische Strahlung 105 eindringen, jedoch wird diese zwischen dem ersten Schleusengehäuseteil 500 und dem zweiten Schleusengehäuseteil 505 eingefangen und eine weitere Reflexion zur gegenüberliegenden ersten Gehäuseöffnung 135 oder dritten Gehäuseöffnung 190 hin wird vermieden. Zur weiteren Verringerung der Reflexion kann auch das gesamte Schleusengehäuse 110, 170 oder zumindest die zum Gehäuseinnenraum 130, 200 gerichteten Oberflächen des Schleusengehäuses 110, 170 eloxiert sein und/oder nicht-reflektierend hinsichtlich der elektromagnetischen Strahlung 105 behandelt sein.

Ferner greift in montiertem Zustand der ersten Schleusenglocke 120 an dem zugeordneten Schleusengehäuseboden 515 das freie Ende 615 auf der zur Statormodulanordnung 25 abgewandten Seite des Schleusengehäusebodens 515 in die erste Führungsnut 565 ein. Dabei bildet der Eingriff eine Art Labyrinthdichtung beispielsweise für die elektromagnetische Strahlung 105 aus.

Die erste Innenfläche 613 und die zweite Innenfläche 619 sind verrundet beispielsweise korrespondierend zu der äußeren Umfangsseite 640 des ersten Torabschnitts 145 oder des zweiten Torabschnitts 215 ausgebildet. Dabei decken die erste Spaltabdeckung 611 und die zweite Spaltabdeckung 612 den Spalt 645 ab. Durch die Verstellbarkeit der ersten Spaltabdeckung 611 kann die erste Innenfläche 613 in minimalem Abstand oder in Berührkontakt zu der äußeren Umfangsseite 640 angeordnet sein. Ebenso kann die zweite Spaltabdeckung 612 in minimalem Abstand oder in Berührkontakt zu der äußeren Umfangsseite 640 angeordnet sein, um den Spalt 645 abzudecken. Ebenso decken die dritte und vierte Spaltabdeckung 617, 618 den Spalt 645 am dritten Trägerelement 600 und am vierten Trägerelement 605 ab.

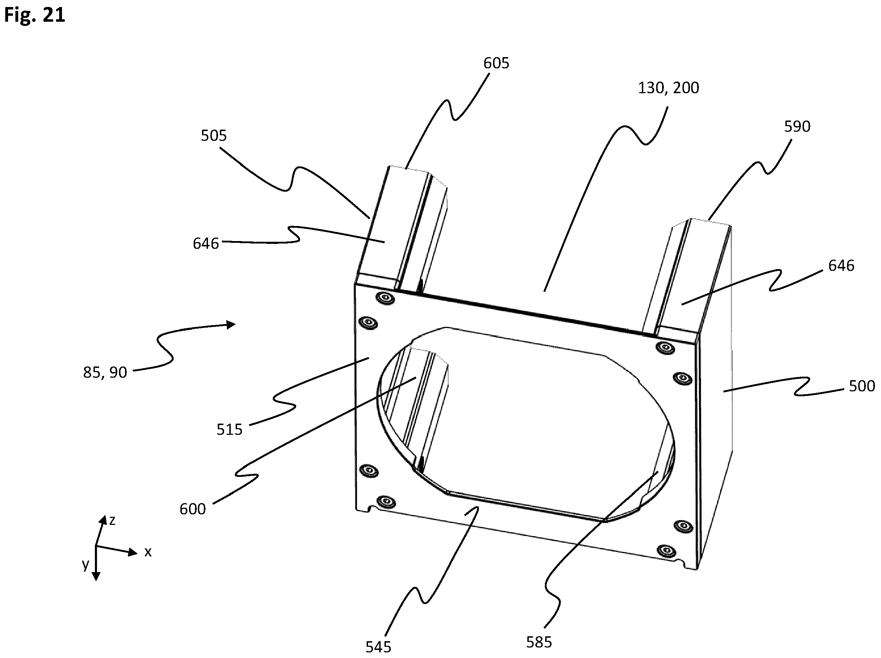

Figur 21 zeigt eine perspektivische Darstellung des Schleusengehäuseteils 500 mit Blickrichtung auf die Unterseite 545 des Schleusengehäusebodens 515 der ersten Schleuseneinheit 85 und/oder der zweiten Schleuseneinheit 90.

Der Schleusengehäuseboden 515 kann beispielsweise jeweils nahe den Ecken des Schleusengehäusebodens 515 jeweils mit einem zugeordneten Trägerelement 585, 590, 600, 605 verbunden, beispielsweise verschraubt, sein. Zusätzlich kann jeweils an dem Trägerelement 585, 590, 600, 605 auf einer dem Gehäuseinnenraum 130, 200 abgewandten Seite jeweils eine Blende 646 stirnseitig aufgesetzt sein. Durch die Blende 646 kann stirnseitig das jeweilige erste Schleusengehäuseteil 500 und/oder das zweite Schleusengehäuseteil 505 plan ausgeformt sein, sodass Schmutzanhaftungen vermieden werden.

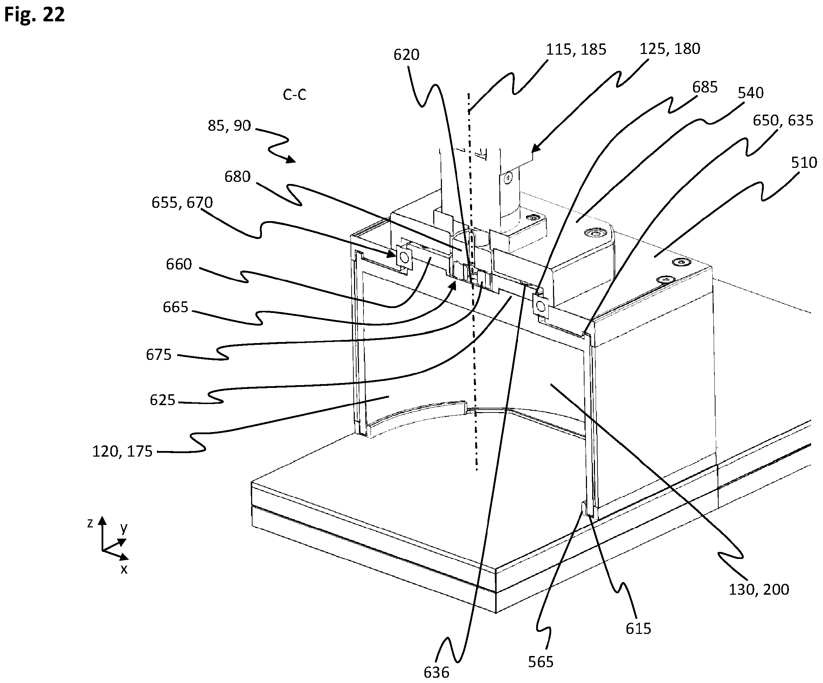

Figur 22 zeigt eine Schnittansicht entlang einer in Figur 16B gezeigten Schnittebene C-C durch die erste Schleuseneinheit 85 bzw. die zweite Schleuseneinheit 90.

Der Schleusengehäusedeckel 510 weist eine zweite Führungsnut 650 auf, die sich in Umfangsrichtung auf einer Kreisbahn um die erste Drehachse 115 oder die zweite Drehachse 185 erstreckt. Die zweite Führungsnut 650 ist auf der zum ersten Gehäuseinnenraum 130 bzw. zweiten Gehäuseinnenraum 200 zugewandten Seite des Schleusengehäusedeckels 510 angeordnet.

Der Antriebsflansch 540 begrenzt zusammen mit dem Schleusengehäusedeckel 510 radial außenseitig und in axialer Richtung eine Lageraufnahme 655. Auf der zum Schleusengehäusedeckel 510 abgewandten Seite des Antriebsflanschs 540 ist der erste Schleusenantrieb 125 bzw. der zweite Schleusenantrieb 180 befestigt.

Ferner weist die erste Schleuseneinheit 85 und/oder die zweite Schleuseneinheit 90 jeweils einen Anschlussflansch 660 und eine Kupplung 665 sowie ein Lager 670 auf.

Die Kupplung 665 kann dabei beispielsweise als Klauenkupplung ausgebildet sein und ein erstes Kupplungselement 675 sowie ein zweites Kupplungselement 680 aufweisen. Das zweite Kupplungselement 680 kann dabei beispielsweise mit einer Ausgangswelle des ersten Schleusenantriebs 125 oder des zweiten Schleusenantriebs 180 verbunden sein und beispielsweise die Klauen der Klauenkupplung aufweisen. Das zweite Kupplungselement 680 kann Öffnungen zum Eingriff der Klauen des zweiten Kupplungselements 680 aufweisen. Insbesondere kann ferner das erste Kupplungselement 675 ein Elastomer aufweisen.

Der Anschlussflansch 660 ist stirnseitig mit dem Sockel 625 drehmomentschlüssig, vorzugsweise drehfest, beispielsweise über die Bohrungen 636 verschraubt. Radial außenseitig begrenzen der Anschlussflansch 660 und der umfangsseitig gestuft ausgebildete Sockel 625 die Lageraufnahme 655. In der Lageraufnahme 655 ist ein Lager 670 angeordnet. Das Lager 670 kann beispielsweise als einreihiges Kugellager ausgebildet sein.

Das Lager 670 lagert die erste Schleusenglocke 120 oder die zweite Schleusenglocke 175 drehbar um die zugeordnete erste Drehachse 115 oder zweite Drehachse 185.

Ferner befestigt der Anschlussflansch 660, der stirnseitig zumindest teilweise die Kupplungsaufnahme 620 überdeckt, das erste Kupplungselement 675 in der Kupplungsaufnahme 620 und verbindet das erste Kupplungselement 675 drehmomentschlüssig, vorzugsweise drehfest, mit dem Anschlussflansch 660 und der ersten Schleusenglocke 120 oder der zweiten Schleusenglocke 175.

Durch die Verwendung der Klauenkupplung, insbesondere wenn zusätzlich das erste Kupplungselement 675 aus einem Elastomer gefertigt wird, kann ein Toleranzausgleich erfolgen und ferner eine Beschädigung des jeweiligen Schleusenantriebs 125, 180 beim beispielsweise Einklemmen einer Fördereinrichtung 55, 60 an der Schleusenöffnung 150, 210 vermieden werden.

In der Bewegung der Schleusenglocke 120, 175 um die jeweils zugeordnete Drehachse 115, 185 durch den Schleusenantrieb 125, 180 führt zum einen der Eingriff der Ausbuchtung 635 in die zweite Führungsnut 650 sowie der Eingriff des freien Endes 615 in die erste Führungsnut 565 zu einer stabilen Rotation der ersten Schleusenglocke 120 und der zweiten Schleusenglocke 175 um die jeweils zugeordnete Drehachse 115, 185. Dadurch kann das Lager 670 beispielsweise als einreihiges Wälzlager ausgebildet sein, sodass die Schleuseneinheit 85, 90 in axialer Richtung bezogen auf die Drehachse 115, 185 besonders kurz ausgebildet ist.

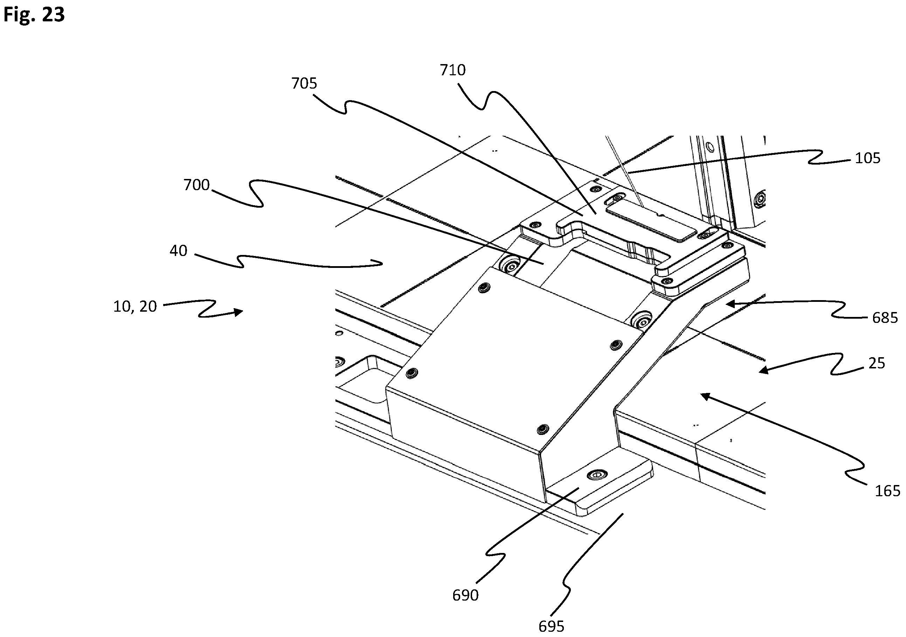

Figur 23 zeigt einen in Figur 15 markierten Ausschnitt D, wobei in Figur 23 auf die Darstellung des Gehäuses 80 verzichtet wird.

Um einen zuverlässigen, fortwährend im Wesentlichen konstanten Abstand zwischen dem Werkstück 75 (nicht in Figur 23 dargestellt) und dem Bearbeitungsmodul 96 (nicht in Figur 23 dargestellt), insbesondere dem Sendemodul 100, sicherzustellen, damit beispielsweise die elektromagnetische Strahlung 105 fokussiert auf das zu bearbeitende Werkstück 75 gerichtet werden kann, weist die Bearbeitungsstation 20 einen Halter 685 auf. Der Halter 685 kann mittels eines Befestigungsabschnitts 690 an dem Maschinenbett 695 befestigt sein. Das Maschinenbett 695 kann ferner die Statormodulanordnung 25 seitlich und/oder oberseitig tragen und befestigen.

Der Halter 685 ist vorzugsweise bügelförmig ausgebildet und erstreckt sich zumindest abschnittsweise beabstandet oberhalb der Moduloberseite 40.

Der Halter 685 weist einen Halteabschnitt 700 auf, wobei der Halteabschnitt 700 mit dem Befestigungsabschnitt 690 verbunden ist. Auf einer dem Befestigungsabschnitt 690 abgewandten Seite ist an dem Halteabschnitt 700 der Werkstückbearbeitungsträger 705 angeordnet, der sich beispielsweise beabstandet zu der Moduloberseite 40 oberhalb der Moduloberseite 40 und parallel zu der Moduloberseite 40 erstreckt. Der Halteabschnitt 700 und der Werkstückbearbeitungsträger 705 sind dabei oberhalb des ersten Arbeitsbereichs 160 der Statormodulanordnung 25 angeordnet.

Der Werkstückbearbeitungsträger 705 kann wenigstens eine erste Werkstückaufnahme 710 aufweisen, in die das zu bearbeitende Werkstück 75 zumindest abschnittsweise durch die erste Fördereinrichtung 55 oder zweite Fördereinrichtung 60 eingelegt wird und von dem Werkstückträger 70 der jeweiligen ersten Fördereinrichtung 55 oder zweiten Fördereinrichtung 60 getrennt wird.

Das Bearbeitungsmodul 96 und die Bearbeitungseinheit 95 sind in z-Richtung im Wesentlichen oberhalb gegebenenfalls mit geringfügigem Versatz in Längsrichtung und/oder y-Richtung zu der ersten Werkstückaufnahme 710 angeordnet, wobei die Anordnung des Sendemoduls 100 und der Bearbeitungseinheit 95 derart gewählt ist, dass die erste Werkstückaufnahme 710 innerhalb eines Bearbeitungs- und Aussendebereichs der elektromagnetischen Strahlung 105 angeordnet ist.

Der in Figur 23 gezeigte Halter 685 hat den Vorteil der einfachen Ausgestaltung und, dass mittels des Halters 685 das Werkstück 75 versetzt zu dem Statormodul 30, 35 ortsfest innerhalb der Bearbeitungsstation 20 positioniert ist.

Zusätzlich kann an dem ersten Arbeitsbereich 160, beispielsweise an dem Werkstückbearbeitungsträgers 705, eine Absaugung (in Figur 23 nicht dargestellt) angeordnet sein, um bei der Bearbeitung des jeweiligen Werkstücks 75 entstehende Emissionen, beispielsweise Dämpfe, nahe des Werkstücks 75 abzusaugen und eine Verunreinigung, insbesondere von einem im ersten Wartebereich 165 wartenden Werkstück 75, zu vermeiden.

Wie bereits herausgestellt, kann die in den Figuren 15 bis 23 gezeigte konstruktive Ausgestaltung des Planarantriebssystems 10 gemäß der zweiten Ausführungsform mit dem im Rahmen der Figur 5 erläuterten Verfahren zum Betrieb der Bearbeitungsstation 20 betrieben werden. Insbesondere kann nach Verdrehen der ersten Schleusenglocke 120 beispielsweise im vierten Verfahrensschritt 320 und/oder im sechsten Verfahrensschritt 330 und/oder der zweiten Schleusenglocke 175 im elften Verfahrensschritt 355 und/oder im vierzehnten Verfahrensschritt 370, sofern vorgesehen, die Dichtung 575 mit einem Druckfluid beaufschlagt werden, um den Arbeitsraum 50 vom Transportbereich 45 im Wesentlichen fluidisch abzutrennen. Durch das Druckfluid wird die Dichtung 575 gegen die Umfangsseite 640 gepresst und der Arbeitsraum 50 weiter fluidisch gegenüber dem Transportbereich 45 abgetrennt. Dies ist insbesondere bei einer hohen Emissionsbelastung im Arbeitsraum 50 von Vorteil, insbesondere beim Einsatz von einer Kühlflüssigkeit zum Kühlen einer spanenden Bearbeitung des Werkstücks durch das Bearbeitungsmodul 96.

Vor einem (erneuten) Verdrehen der ersten Schleusenglocke 120 im vierten Verfahrensschritt 320 und/oder im sechsten Verfahrensschritt 330 und/oder der zweiten Schleusenglocke 175 im elften Verfahrensschritt 355 und/oder im vierzehnten Verfahrensschritt 370 wird die Dichtung 575 druckentlastet und zumindest ein Teil des Druckfluids aus der Dichtung 575 entlassen, sodass sich die Dichtung 575 entspannt und nicht mehr an der Umfangsseite 640 anliegt. Dadurch ist die Verdrehbarkeit der ersten Schleusenglocke 120 und/oder der zweiten Schleusenglocke 175 wieder hergestellt und der ersten Schleusenglocke 120 im vierten Verfahrensschritt 320 und/oder im sechsten Verfahrensschritt 330 und/oder der zweiten Schleusenglocke 175 im elften Verfahrensschritt 355 und/oder im vierzehnten Verfahrensschritt 370 kann durchgeführt werden.

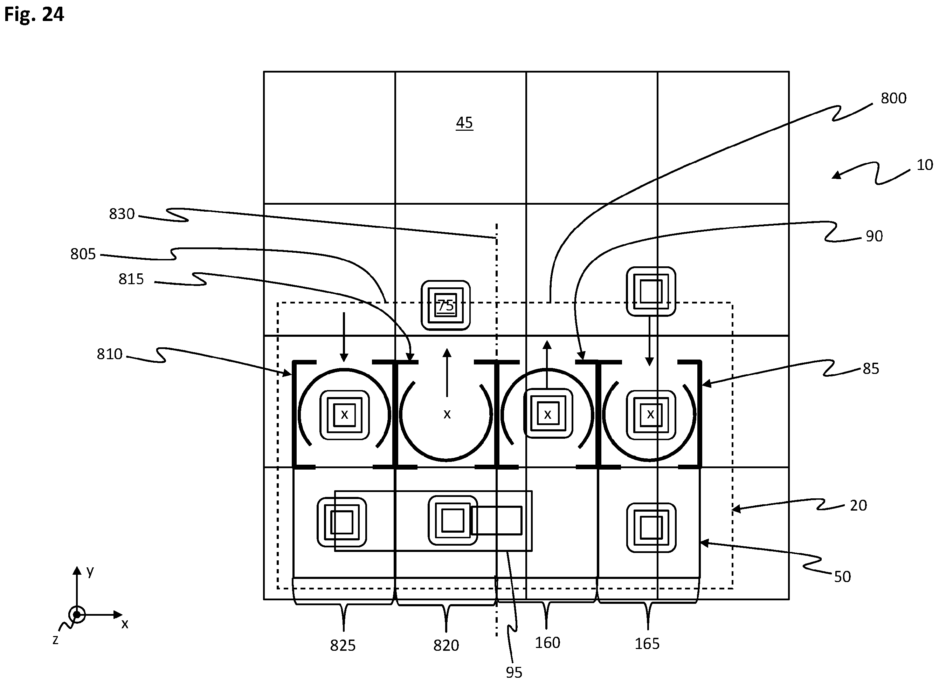

Figur 24 zeigt eine schematische Darstellung eines Planarantriebssystems 10 gemäß einer dritten Ausführungsform.

Die dritte Ausführungsform des Planarantriebssystems 10 ist im Wesentlichen eine Weiterbildung der in den Figuren 1 bis 14 erläuterten ersten Ausführungsform des Planarantriebssystems 10. Dabei ist im Wesentlichen das Planarantriebssystem 10 identisch zu der in den Figuren 1 bis 14 gezeigten ersten Ausführungsform ausgebildet. Im Folgenden wird ausschließlich auf die Unterschiede der in Figur 24 gezeigten dritten Ausführungsform des Planarantriebssystems 10 gegenüber der in den Figuren 1 bis 14 erläuterten ersten Ausführungsform des Planarantriebssystem 10 eingegangen.

Das Planarantriebssystem 10 weist einen ersten Stationsabschnitt 800 und einen zweiten Stationsabschnitt 805 auf, wobei der zweite Stationsabschnitt 805 direkt angrenzend beispielhaft an dem ersten Stationsabschnitt 800 angeordnet ist. Der erste Stationsabschnitt 800 und der zweite Stationsabschnitt 805 sind in Figur 24 jeweils mit einem strichlierten Kasten markiert.

Der erste Stationsabschnitt 800 entspricht im Wesentlichen der in den Figuren 1 bis 14 erläuterten Bearbeitungsstation 20 mit der ersten Schleuseneinheit 85, der zweiten Schleuseneinheit 90, dem ersten Arbeitsbereich 160 und dem ersten Wartebereich 165. Der zweite Stationsabschnitt 805 ist im Wesentlichen identisch zu dem ersten Stationsabschnitt 800 ausgebildet. Dabei weist jedoch zum erleichterten Verständnis der zweite Stationsabschnitt 805 eine dritte Schleuseneinheit 810 (anstatt der ersten Schleuseneinheit 85), eine vierte Schleuseneinheit 815 (anstatt der zweiten Schleuseneinheit 90), einen zweiten Arbeitsbereich 820 (anstatt des ersten Arbeitsbereichs 160) und einen zweiten Wartebereich 825 (anstatt des ersten Wartebereichs 165) auf. Die Bearbeitungseinheit 95 ist sowohl dem Stationsabschnitt 800 als auch dem zweiten Stationsabschnitt 805 zugeordnet, sodass in der in Figur 24 gezeigten dritten Ausführungsform die Bearbeitungseinheit 95 mit nur einem Bearbeitungsmodul 96, insbesondere einem Sendemodul 100, zum Bearbeiten der Werkstücke 75 auskommt.

Der erste Stationsabschnitt 800 und der zweite Stationsabschnitt 805 sind direkt angrenzend nebeneinander in Längsrichtung (x-Richtung) angeordnet und in Querrichtung im Wesentlichen auf gleicher Höhe angeordnet. Dabei ist das Gehäuse 80 der Bearbeitungsstation 20 derart ausgebildet, dass es den ersten Wartebereich 165, den zweiten Wartebereich 825, den ersten Arbeitsbereich 160 und den zweiten Arbeitsbereich 820 gegenüber dem Transportbereich 45 abdeckt und einen Austrag von Emissionen aus dem Arbeitsraum 50 in den Transportbereich 45 verhindert.

In der Ausführungsform ist die erste Schleuseneinheit 85 dem zweiten Stationsabschnitt 805 abgewandt und die zweite Schleuseneinheit 90 ist zwischen der ersten Schleuseneinheit 85 und dem zweiten Stationsabschnitt 805 angeordnet. Der zweite Stationsabschnitt 805 ist im Wesentlichen spiegelsymmetrisch bezüglich einer Symmetrieebene 830 zu dem ersten Stationsabschnitt 800 ausgebildet. Die vierte Schleuseneinheit 815 ist zwischen der zweiten Schleuseneinheit 90 und dem ersten Stationsabschnitt 800 in Längsrichtung angeordnet. Dabei sind die erste bis vierte Schleuseneinheit 85, 90, 810, 815 in einer Reihe in x-Richtung direkt nebeneinander derart angeordnet, dass der Arbeitsraum 50 an der der Schleuseneinheit 85, 90, 810, 815 zugewandten Seite durch die jeweilige Schleuseneinheit 85, 90, 810, 815 verschlossen ist und unabhängig vom Betriebszustand der Schleuseneinheit 85, 90, 810, 815 der Arbeitsraum 50 gegenüber dem Transportbereich 45 verschlossen ist. Ein Austritt von Emissionen, beispielsweise der elektromagnetischen Strahlung 105 aus dem Arbeitsraum 50 in den Transportbereich 45 ist durch die jeweilige Schleuseneinheit 85, 90, 810, 815 blockiert.

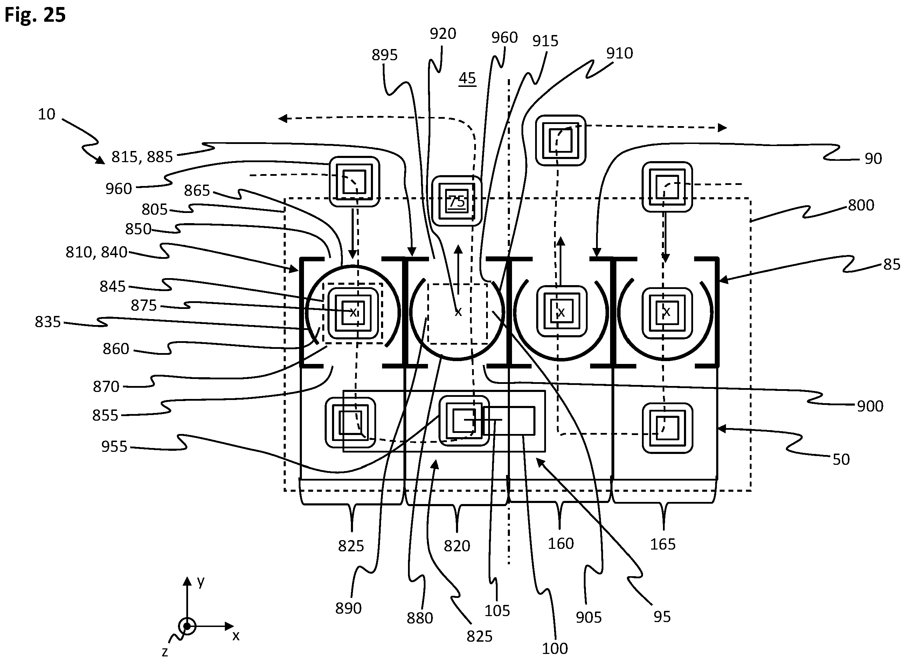

Figur 25 zeigt eine vergrößerte Darstellung der Bearbeitungsstation 20 des in Figur 24 gezeigten Planarantriebssystems 10.

Die dritte Schleuseneinheit 810 ist identisch zur ersten Schleuseneinheit 85 ausgebildet. Zu besseren Unterscheidbarkeit wird im Folgenden auf die Nomenklatur der dritten Schleuseneinheit 810 gegenüber der ersten Schleuseneinheit 85 eingegangen und zur Erläuterung dargelegt, welche Komponente der dritten Schleuseneinheit 810 der geometrischen sowie konstruktiven Ausgestaltung der ersten Schleuseneinheit 85 entspricht.

Für die dritte Schleuseneinheit 810 wird die erste Schleusenglocke 120 mit der dritten Schleusenglocke 835, das erste Schleusengehäuse 110 mit dem dritten Schleusengehäuse 840 und der erste Schleusenantrieb 125 mit dem dritten Schleusenantrieb 845 bezeichnet. Die erste Gehäuseöffnung 135 entspricht einer fünften Gehäuseöffnung 850 und die zweite Gehäuseöffnung 140 der ersten Schleuseneinheit 85 wird für die dritte Schleuseneinheit 810 als sechste Gehäuseöffnung 855 bezeichnet. Ferner entspricht der erste Schleusenraum 155 einem dritten Schleusenraum 860, der erste Torabschnitt 145 einem dritten Torabschnitt 865 und die erste Schleusenöffnung 150 einer dritten Schleusenöffnung 870. Die erste Drehachse 115 entspricht einer dritten Drehachse 875.

Für die vierte Schleuseneinheit 815 wird die zweite Schleusenglocke 75 mit der vierten Schleusenglocke 880, das zweite Schleusengehäuse 170 mit dem vierten Schleusengehäuse 885 und der zweite Schleusenantrieb 180 mit dem vierten Schleusenantrieb 890 bezeichnet. Die dritte Gehäuseöffnung 190 entspricht einer siebten Gehäuseöffnung 895 und die vierte Gehäuseöffnung 195 der zweiten Schleuseneinheit 90 wird für die vierte Schleuseneinheit 815 als achte Gehäuseöffnung 900 bezeichnet. Ferner entspricht der zweite Schleusenraum 205 einem vierten Schleusenraum 905, der zweite Torabschnitt 215 einem vierten Torabschnitt 910 und die zweite Schleusenöffnung 210 einer vierten Schleusenöffnung 915. Die zweite Drehachse 185 entspricht einer vierten Drehachse 920.

Hinsichtlich der konstruktiven Ausgestaltung der dritten Schleuseneinheit 810 und/oder der vierten Schleuseneinheit 815 wird auf die Figurenbeschreibung der zweiten Ausführungsform der dort beschriebenen ersten Schleuseneinheit 85 und der zweiten Schleuseneinheit 90 verwiesen.

Der Halter 685 kann sich in Längsrichtung über den ersten Arbeitsbereich 160 und den zweiten Arbeitsbereich 820 erstrecken, wobei zusätzlich der Halter 685 neben der ersten Werkstückaufnahme 710 eine zweite Werkstückaufnahme 715 aufweist, wobei die zweite Werkstückaufnahme 715 im zweiten Arbeitsbereich 820 angeordnet ist.

In Querrichtung schließt sich an die vierte Schleuseneinheit 815 der zweite Arbeitsbereich 820 und an die dritte Schleuseneinheit 810 der zweite Wartebereich 825 an. Mit anderen Worten sind der erste Arbeitsbereich 160 und der zweite Arbeitsbereich 820 in Längsrichtung zwischen dem ersten Wartebereich 165 und dem zweiten Wartebereich 825 angeordnet. Dabei können der erste Arbeitsbereich 160 und der zweite Arbeitsbereich 820 direkt aneinander angrenzen und/oder ineinander übergehen.

Dem zweiten Arbeitsbereich zugewandt 820 ist die achte Gehäuseöffnung 900 des vierten Schleusengehäuses 885 der vierten Schleuseneinheit 815 angeordnet. Auf der zum zweiten Arbeitsbereich 820 abgewandten Seite (in Querrichtung) und zum Transportbereich 45 hin zugewandt ist die siebte Gehäuseöffnung 895 des vierten Schleusengehäuses 885 der vierten Schleuseneinheit 815 angeordnet.

Die sechste Gehäuseöffnung 855 des dritten Schleusengehäuses 840 ist an dem zweiten Wartebereich 825 angeordnet. In Querrichtung gegenüberliegend zu der sechsten Gehäuseöffnung 855 und dem Transportbereich 45 zugewandt ist die fünfte Gehäuseöffnung 850 am dritten Schleusengehäuse 840 angeordnet.

Die dritte Schleusenglocke 835 ist durch den dritten Schleusenantrieb 845 zwischen einem fünften Positionsbereich mit einer fünften Position und einem in Umfangsrichtung um die dritte Drehachse 875 versetzt angeordneten sechsten Positionsbereich mit einer sechsten Position verdrehbar. Dabei entspricht die fünfte Position der ersten Position der ersten Schleusenglocke 120 sowie die sechste Position der zweiten Position der ersten Schleusenglocke 120.

In dem fünften Positionsbereich verschließt der dritte Torabschnitt 865 die sechste Gehäuseöffnung 855 und die dritte Schleusenöffnung 870 öffnet den dritten Schleusenraum 860 über die fünfte Gehäuseöffnung 850 hin zum Transportbereich 45, sodass ausschließlich der dritte Schleusenraum 860 von der fünften Gehäuseöffnung 850 her zugänglich ist. In dem sechsten Positionsbereich ist durch den dritten Torabschnitt 865 die fünfte Gehäuseöffnung 850 vom dritten Schleusenraum 860 abgetrennt und der dritte Schleusenraum 860 ist über die dritte Schleusenöffnung 870 sowie die sechste Gehäuseöffnung 855 ausschließlich hin zum zweiten Wartebereich 825 sowie zum Arbeitsraum 50 offen.

Analog zur zweiten Schleuseneinheit 90 ist die vierte Schleusenglocke 880 zwischen einem siebten Positionsbereich mit einer siebten Position, die der dritten Position der zweiten Schleusenglocke 175 entspricht, und einem achten Positionsbereich mit einer achten Position, die der vierten Position der zweiten Schleusenglocke 175 entspricht, um die vierte Drehachse 920 durch den vierten Schleusenantrieb 890 anstatt des zweiten Schleusenantriebs 180 verdrehbar. Dabei ist der vierte Schleusenraum 905 in dem siebten Positionsbereich ausschließlich über die siebte Gehäuseöffnung 895 vom Transportbereich 45 und die vierte Schleusenöffnung 915 her zugänglich. Der vierte Torabschnitt 910 verschließt in dem siebten Positionsbereich den Arbeitsraum 50, insbesondere den zweiten Arbeitsbereich 820 gegenüber dem Transportbereich 45 und dem dritten Schleusenraum 860.

In dem achten Positionsbereich ist in Umfangsrichtung um die vierte Drehachse 920 die vierte Schleusenglocke 880 derart verdreht, dass die vierte Schleusenöffnung 915 der achten Gehäuseöffnung 900 zugewandt ist und der vierte Schleusenraum 905 ausschließlich über die vierte Schleusenöffnung 915 und die achte Gehäuseöffnung 900 vom Arbeitsraum 50, insbesondere vom zweiten Arbeitsbereich 820 her, zugänglich ist. In dem achten Positionsbereich verschließt der vierte Torabschnitt 910 die siebte Gehäuseöffnung 895 gegenüber dem vierten Schleusenraum 905.

Das Planarantriebssystem 10 kann mittels des in Figur 5 beschriebenen Verfahrens betrieben werden, um die Werkstücke 75 zu bearbeiten. Dazu ist von Vorteil, wenn die Anzahl der Fördereinrichtungen gegenüber der in den Figuren 1 bis 14 gezeigten ersten Ausführungsform um wenigstens eine dritte Fördereinrichtung 955 und eine vierte Fördereinrichtung 960 erhöht ist.

Bei Durchführung des Verfahrens gemäß Figur 5 mittels der dritten Schleuseneinheit 810, der vierten Schleuseneinheit 815 sowie des zweiten Arbeitsbereichs 820 und des zweiten Wartebereichs 825 wird jeweils die dritte Fördereinrichtung 955 anstatt der ersten Fördereinrichtung 55 und die vierte Fördereinrichtung 960 anstatt der zweiten Fördereinrichtung 60 eingesetzt, um jeweils das entsprechende Werkstück 75 hin in den zweiten Arbeitsbereich 820 zur Bearbeitung durch das Bearbeitungsmodul 96 und aus dem zweiten Arbeitsbereich 820 abzutransportieren.

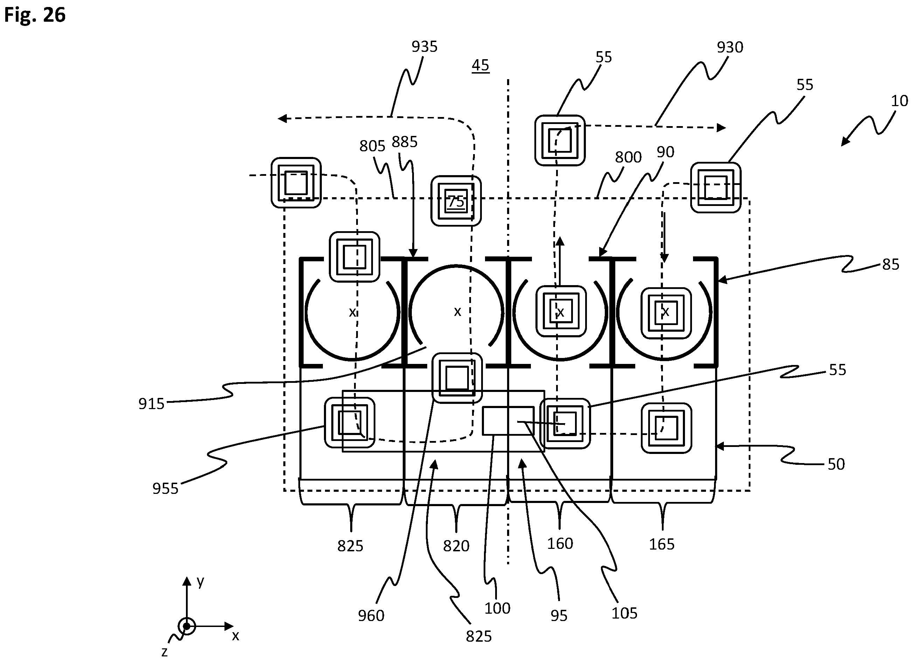

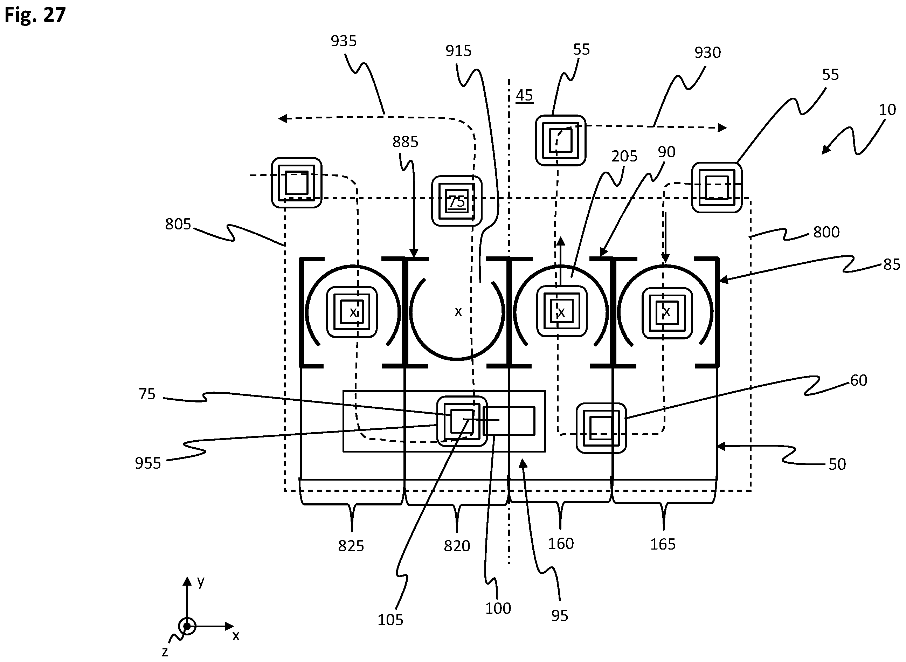

Figur 26 zeigt einen Ausschnitt des in Figur 24 gezeigten Planarantriebssystems 10. Figur 27 zeigt einen Ausschnitt des in Figur 24 gezeigten Planarantriebssystems 10 zeitlich kurz nach dem in Figur 26 gezeigten Ausschnitt.

Das in Figur 5 beschriebene Verfahren wird im Wesentlichen quasi parallel mit einem geringen zeitlichen Versatz in dem ersten Stationsabschnitt 800 und dem zweiten Stationsabschnitt 805 durchgeführt. Vorteil der quasi-parallelen Durchführung des Verfahrens in beiden Stationsabschnitten 800, 805 ist, dass das Bearbeitungsmodul 96 mit einer maximal möglichen Auslastung abwechselnd ein Werkstück 75 im ersten Arbeitsbereich 160 und ein Werkstück 75 im zweiten Arbeitsbereich 820 mit nur kurzen Unterbrechungen bearbeitet. Das Verfahren für den ersten Stationsabschnitt 800 und das Verfahren an dem zweiten Stationsabschnitt sind derart aufeinander abgestimmt, dass die Unterbrechungen des Bearbeitungsmoduls 96 möglichst kurz gehalten sind und die Bearbeitungsstation 96 im Wesentlichen unterbrechungsfrei die Werkstücke 75 bearbeiten kann.

Beispielsweise kann die elektromagnetische Strahlung 105 mittels Spiegel und/oder Prismen auf das Werkstück 75 im zweiten Arbeitsbereich 820 gerichtet werden und zeitlich danach die elektromagnetische Strahlung 105 wieder auf ein Werkstück 75 im ersten Arbeitsbereich 160 gerichtet werden.

In Figur 26 sind zahlreiche erste Fördereinrichtungen 55 und zweite Fördereinrichtungen 60 im ersten Stationsabschnitt 800 sowie im Wesentlichen im Transportbereich 45 vor dem ersten Stationsabschnitt 800 angeordnet. Insbesondere soll damit gezeigt werden, wie im Rahmen des Betriebs des Planarantriebssystems 10 die ersten und zweiten Fördereinrichtungen 55, 60 entlang eines ersten Bewegungspfads 930 über das in Figur 5 gezeigte Verfahren hinweg im Planarantriebssystem 10 entlangfahren. Der erste Bewegungspfad 930 ist dabei symbolisch im Wesentlichen mit einer strichlierten Linie in Figur 26 angedeutet. Der erste Bewegungspfad 930 weist im Wesentlichen eine U-förmige Grundform auf, die sich von der ersten Schleuseneinheit 85 über den ersten Wartebereich 165, dem ersten Arbeitsbereich 160 zu der zweiten Schleuseneinheit 90 wieder in den Transportbereich 45 erstreckt.

Ferner sind zahlreiche dritte und vierte Fördereinrichtungen 955, 960 in Figur 26 im Wesentlichen im zweiten Stationsabschnitt 805 dargestellt, die bei Durchführung des in Figur 5 beschriebenen Verfahrens im Wesentlichen im Bereich des zweiten Stationsabschnitts 805 entlang eines zweiten Bewegungspfads 935 bewegt werden. Dabei sind beispielhaft die dritte und vierte Fördereinrichtung 955, 960 abwechselnd entlang des zweiten Bewegungspfads 935 angeordnet.

Dabei wird im zweiten Verfahrensschritt 310 im zweiten Stationsabschnitt 805 die dritte Schleusenglocke 835 in die fünfte Position gedreht und im dritten Verfahrensschritt 315 die dritte Fördereinrichtung 955 mit dem Werkstück 75 in den dritten Schleusenraum 860 eingefahren. Im vierten Verfahrensschritt 320 wird die dritte Schleusenglocke 835 aus der fünften Position in die sechste Position verdreht (vgl. Figur 26) und im fünften Verfahrensschritt 325 wird die dritte Fördereinrichtung 955 aus dem dritten Schleusenraum 860 in den zweiten Wartebereich 825 bewegt. Dort kann die dritte Fördereinrichtung 955 durch Deaktivierung des Magnetfelds auf der Moduloberseite 40 abgestellt werden. Im sechsten Verfahrensschritt 330 wird die dritte Schleusenglocke 835 aus der sechsten Position wieder zurück in die fünfte Position mittels des dritten Schleusenantriebs 845 verdreht. Im siebten Verfahrensschritt 335 wird die dritte Fördereinrichtung 955 aus dem zweiten Wartebereich 825 in den zweiten Arbeitsbereich 820 bewegt und das Werkstück 75 beispielsweise in der zweiten Werkstückaufnahme 715 platziert. Im achten Verfahrensschritt 340 wird das Werkstück 75, angeliefert von der dritten Fördereinrichtung 955, bearbeitet (vgl. Figur 27).

Im neunten Verfahrensschritt 345 wird die vierte Fördereinrichtung 960 über die fünfte Gehäuseöffnung 850 in den dritten Schleusenraum 860 eingefahren. Im zehnten Verfahrensschritt 350 nimmt die dritte Fördereinrichtung 955 das fertig bearbeitete Werkstück 75 aus der zweiten Werkstückaufnahme 710 durch Anheben der dritten Fördereinrichtung 955 auf. Im elften Verfahrensschritt 355 wird die vierte Schleusenglocke 880 aus der siebten Position in die achte Position verdreht. Im zwölften Verfahrensschritt 360 wird die vierte Fördereinrichtung 960 aus dem dritten Schleusenraum 860 in den zweiten Wartebereich 825 bewegt, wobei zum Abwarten der Bearbeitung des Werkstücks 75 an der zweiten Werkstückaufnahme 715 die vierte Fördereinrichtung 960 auf der Moduloberseite 40 abgesetzt werden kann. Im dreizehnten Verfahrensschritt 365 wird die dritte Fördereinrichtung 955 mit dem bearbeiteten Werkstück 75 aus dem zweiten Arbeitsbereich 820 in den vierten Schleusenraum 905 eingefahren. Während des Einfahrens in den vierten Schleusenraum 905 und/oder dem Warten im zweiten Wartebereich 825 (vgl. Figur 26) kann mittels des Bearbeitungsmoduls 96, beispielsweise des Sendemoduls 100, in dem ersten Arbeitsbereich 160 das Werkstück 75 im achten Verfahrensschritt 340 bearbeitet werden. Im vierzehnten Verfahrensschritt 370 wird mittels des vierten Schleusenantriebs 890 die vierte Schleusenglocke 880 um die vierte Drehachse 920 verdreht und im fünfzehnten Verfahrensschritt 375 wird über die vierte Schleusenöffnung 915 die dritte Fördereinrichtung 955 und die siebte Gehäuseöffnung 895 in den Transportbereich 45 verfahren.

In Figur 26 und Figur 27 ist deutlich der zeitliche Versatz bei Durchführung des Verfahrens gemäß Figur 5 der dritten und vierten Fördereinrichtung 955, 960 entlang des zweiten Bewegungspfads 935 gegenüber der ersten und zweiten Fördereinrichtung 55, 60 erkennbar. Dabei ist in Figur 26 der achte Verfahrensschritt 340 gemäß Figur 5 im Bereich des ersten Stationsabschnitts 800 dargestellt, während hingegen im zweiten Stationsabschnitt 805 gerade im Wesentlichen für die vierte Fördereinrichtung 960 der dreizehnte Verfahrensschritt 365 gemäß Figur 5 und der siebte Verfahrensschritt 335 für die dritte Fördereinrichtung 955 durchgeführt werden.

Dabei bearbeitet somit das Bearbeitungsmodul 96, beispielsweise das Sendemodul 100 mittels der elektromagnetischen Strahlung 105, das an/mittels der ersten Fördereinrichtung 55 angelieferte Werkstück 75, während hingegen die vierte Fördereinrichtung 960 vom zweiten Arbeitsbereich 820 wegbewegt wird und die dritte Fördereinrichtung 955 aus dem zweiten Wartebereich 825 in Richtung des ersten zweiten Arbeitsbereichs 820 bewegt wird.

In Figur 27 wird im achten Verfahrensschritt 340 das Werkstück 75, angeliefert mit der dritten Fördereinrichtung 955, im zweiten Stationsabschnitt 805 bearbeitet, beispielsweise mittels der elektromagnetischen Strahlung 105. Im ersten Stationsabschnitt 800 räumt die erste Fördereinrichtung 55 den ersten Arbeitsbereich 160 und fährt in den zweiten Schleusenraum 205 ein. Die zweite Fördereinrichtung 60 kann sich gerade auf dem Weg aus dem ersten Wartebereich 165 hin in den ersten Arbeitsbereich 160 bewegen.

Die in den Figuren dargestellte Ausgestaltung hat den Vorteil, dass das Bearbeitungsmodul 96, insbesondere der Laser des Sendemoduls 10, durch die hohe Abfolge an zu- und abgeführten Werkstücken 75 nahezu fortwährend in Betrieb ist und die Werkstücke 75 im Wesentlichen mit voller Leistung bearbeiten kann.

Ferner wird durch die erste bis vierte Schleuseneinheit 85, 90, 810, 815 sichergestellt, dass Emissionen, beispielsweise auch die elektromagnetische Strahlung 105, durch die geometrische Ausgestaltung hin zum Transportbereich 45 blockiert sind und ein direkter Austritt der Emissionen verhindert wird. Insbesondere ist sichergestellt, dass bei keinem der in Figur 5 beschriebenen Verfahrensschritte die elektromagnetische Strahlung 105, insbesondere Laserstrahlung, aus dem Arbeitsraum 50 austreten kann.

Dadurch dass in der Ausführungsform zur Fortbewegung der Werkstücke 75 die Planarmotorantriebseinrichtung 15 eingesetzt wird, kann zusätzlich eine Ausrichtung des Werkstücks 75, beispielsweise im ersten Schleusenraum 155 oder im dritten Schleusenraum 860, erfolgen. Alternativ ist auch möglich, dass im ersten Wartebereich 165 und/oder zweiten Wartebereich 825 die Fördereinrichtung 55, 60, 955, 960 gedreht wird, um das Werkstück 75 definiert für die Bearbeitung im ersten und/oder zweiten Arbeitsbereich 160, 820 zuzuführen.

Durch die Verwendung der Planarmotorantriebseinrichtung 15 ergibt sich ferner der Vorteil, dass ein Verschleiß an der Fördereinrichtung 55, 60, 955, 960 durch die berührungslose, über der Moduloberseite 40 schwebende Bewegung der Fördereinrichtung 55, 60, 955, 960 vermieden wird.

Dadurch dass beim Eintritt der Fördereinrichtung 55, 60, 955, 960 und/oder beim Austritt diese auch berührungslos über das jeweilige Schleusengehäuse 110, 170, 840, 885 angehoben und berührungslos schwebend vorbeibewegt wird, kann ein weiterer Verschleiß an dem Schleusengehäuse 110, 170, 840, 885 vermieden werden. Ferner kann zusätzlich die Entstehung von kleinen Abriebpartikeln am Schleusengehäuse 110, 170, 840, 885 und/oder der Fördereinrichtung 55, 60, 955, 960 vermieden werden. Dadurch eignet sich das Planarantriebssystem 10 zum Einsatz in Bereichen mit besonders hoher Anforderung an Sauberkeit, wie beispielsweise einem Reinraum oder beim Einsatz und der Herstellung beispielsweise von Medikamenten.

Ferner wird auch durch den ersten Zwischenpositionsbereich und/oder zweiten Zwischenpositionsbereich der Schleusenglocke 120, 175, 835, 880 ein Austritt der elektromagnetischen Strahlung 105 aus dem Arbeitsraum 50 hin zum Transportbereich 45 verhindert.

Des Weiteren hat die Planarmotorantriebseinrichtung 15 den Vorteil, dass dadurch, dass im ersten und/oder zweiten Arbeitsbereich 160, 820 die Fördereinrichtung 55, 60, 955, 960 gegenüber der Moduloberseite 40 angehoben sein kann, ein unterseitiges Anhaften von Schmutzpartikeln an der Fördereinrichtung 55, 60, 955, 960 vermieden wird. Dadurch kann ferner ein Austrag von Schmutzpartikeln aus dem Arbeitsraum 50 in den Transportbereich 45 vermieden werden. Ebenso wird vermieden, dass die Schmutzpartikel in die Führungsnut 565, 650 eingebracht werden und dadurch eine Bewegung der Schleusenglocke 120, 175, 835, 880 in Umfangsrichtung zwischen den jeweiligen Positionen blockiert und/oder Reibung zwischen der Schleusenglocke 120, 175, 835, 880 und der Führungsnut 565, 650 aufgebaut werden würde. Dadurch kann insbesondere ein besonders wartungsarmes Planarantriebssystem 10 bereitgestellt werden.

Durch den Eingriff der Schleusenglocke 120, 175, 835, 880 in die Führungsnut 565, 650 wird ferner vermieden, dass auch Reflexionen des Laserstrahls über einen Axialspalt an der Schleusenglocke 120, 175, 835, 880, insbesondere im Bereich des freien Endes 615 der Schleusenglocke 120, 175, 835, 880 aus dem Arbeitsraum 50 ausdringen können.

Des Weiteren bildet die Führungsnut 565, 650 zusammen mit dem Eingriff der Schleusenglocke 120, 175, 835, 880 in die Führungsnut 565, 650 eine Art Labyrinthdichtung aus, die ferner fluidisch den Transportbereich 45 vom Arbeitsraum 50 abtrennt. Insbesondere kann dadurch in Kombination mit einer Absaugung sichergestellt werden, dass ein Partikeleintrag aus dem Arbeitsraum 50 hin in den Transportbereich 45 vermieden oder gering gehalten wird.

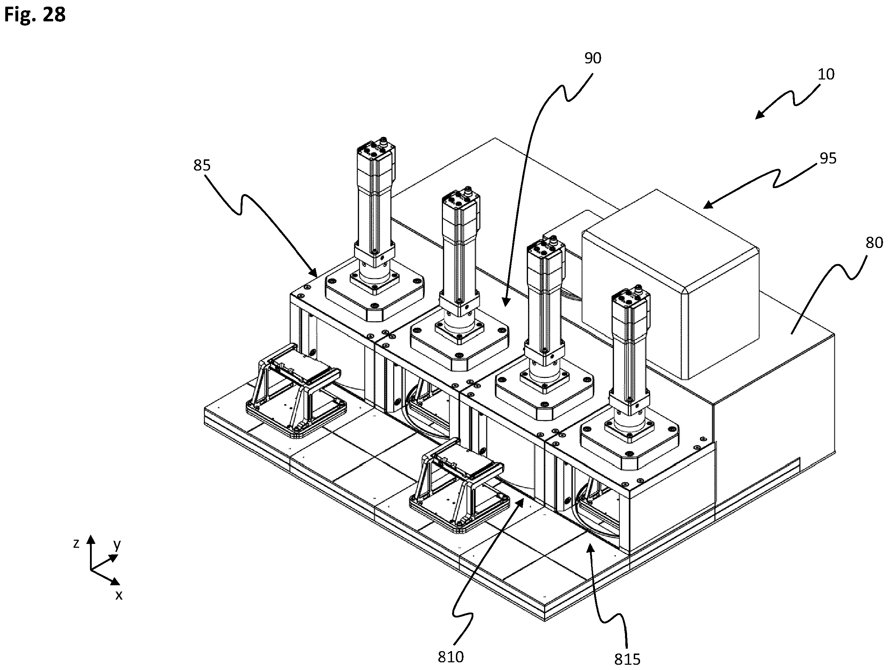

Figur 28 zeigt eine perspektivische Darstellung eines Planarantriebssystems 10 gemäß einer vierten Ausführungsform.

Das Planarantriebssystem 10 ist im Wesentlichen eine Kombination aus dem in den Figuren 24 bis 27 gezeigten Planarantriebssystem 10 mit dem in den Figuren 15 bis 23 gezeigten Planarantriebssystem 10 gemäß der zweiten Ausführungsform. Dabei ist jede der ersten bis vierten Schleuseneinheiten 85, 90, 810, 815 im Wesentlichen identisch zu der in den Figuren 14 bis 23 erläuterten konstruktiven Ausgestaltung der ersten Schleuseneinheit 85 ausgebildet.

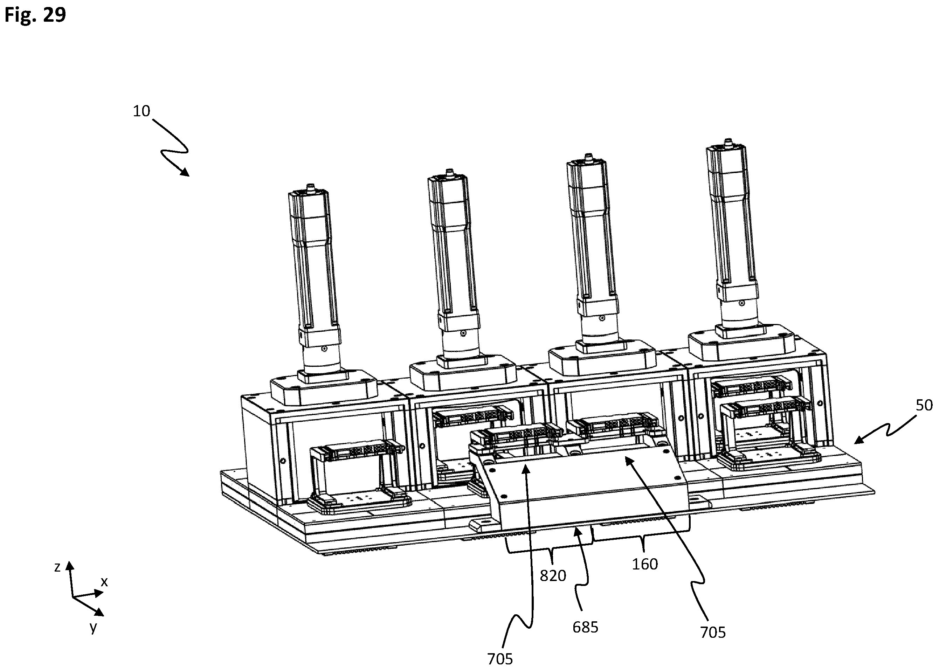

Figur 29 zeigt eine perspektivische Darstellung des in Figur 28 gezeigten Planarantriebssystems 10, wobei jedoch das Gehäuse 80 sowie die Bearbeitungseinheit 95 von Figur 28 ausgeblendet sind, um einen Blick in den Arbeitsraum 50 zu haben.

Gegenüber der in den Figuren 15 bis 23 gezeigten zweiten Ausführungsform ist in Figur 29 der Halter 685 in Längsrichtung breiter ausgestaltet und erstreckt sich im Wesentlichen sowohl über den ersten Arbeitsbereich 160 als auch über den zweiten Arbeitsbereich 820. Durch die verbreiterte Ausgestaltung in Längsrichtung des Halters 685 ist ferner der Halter 685 besonders stabil und steif.

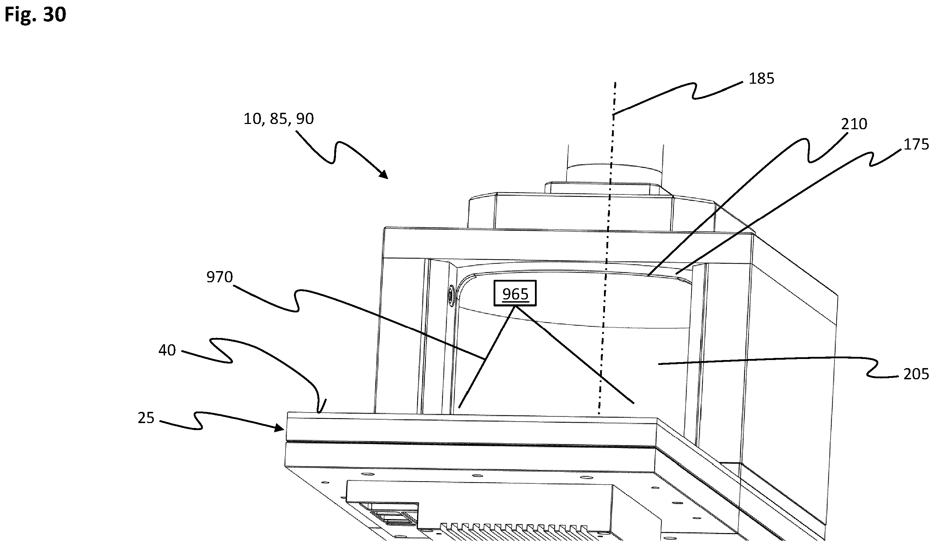

Figur 30 zeigt einen Ausschnitt einer zweiten Schleuseneinheit 90 eines Planarantriebssystems 10 gemäß einer fünften Ausführungsform.

Die zweite Schleuseneinheit 90 ist im Wesentlichen identisch zu der in den Figuren 15 bis 23 gezeigten zweiten Schleuseneinheit 90 ausgebildet. Im Folgenden wird im Wesentlichen ausschließlich auf die Unterschiede der in Figur 30 gezeigten zweiten Schleuseneinheit 90 gegenüber der in den Figuren 15 bis 23 gezeigten zweiten Schleuseneinheit 90 eingegangen.

Zusätzlich weist die zweite Schleuseneinheit 90 eine Kamera 965 auf, wobei die Kamera 965 an der zweiten Schleusenglocke 175 beispielsweise auf einer dem zweiten Schleusenraum 205 zugewandten Seite der zweiten Schleusenglocke 175 angeordnet ist. Die Kamera 965 ist vorzugsweise beabstandet zu der zweiten Drehachse 185 angeordnet. Ferner kann die Kamera 965 beabstandet zu der zweiten Schleusenöffnung 210 angeordnet sein. Die Kamera 965 weist einen Erfassungsbereich 970 auf, wobei der Erfassungsbereich 970 in Richtung der Moduloberseite 40 gerichtet ist. Insbesondere kann der Erfassungsbereich 970 schräg geneigt in Richtung der zweiten Drehachse 185 und der Moduloberseite 40 ausgerichtet sein.

Datentechnisch kann die Kamera 965 mit einer Auswerteeinrichtung (nicht dargestellt) verbunden sein. Die Verbindung kann dabei drahtlos oder drahtgestützt ausgebildet sein. Die Kamera 965 ist vorzugsweise beispielsweise im dreizehnten Verfahrensschritt 365 aktiviert und erfasst zumindest das Werkstück 75 auf der ersten Fördereinrichtung 55 oder der zweiten Fördereinrichtung 60. Wird die zweite Schleusenglocke 175 aus der vierten Position in die dritte Position verdreht, so kann fortwährend die Kamera 965 das Werkstück 75 aus verschiedenen Blickwinkeln aufnehmen. Dabei ist von Vorteil, wenn beispielsweise 1,5-mal, beispielsweise 540°, um die zweite Drehachse 185 gedreht wird, sodass beispielsweise aus allen Blickrichtungen die Kamera 965 mit dem Erfassungsbereich 970 auf das bearbeitete Werkstück 75 gerichtet wurde und das Werkstück 75 erfassen konnte.

Die Kamera 965 kann die erfassten Informationen über das Werkstück 75 der Auswerteeinrichtung bereitstellen, wobei beispielsweise automatisiert das Werkstück 75 im Rahmen einer Mustererkennung ausgewertet werden kann.

Diese Ausgestaltung hat den Vorteil, dass auf einen separaten Bereich oder auf eine Station zur Überprüfung der im achten Verfahrensschritt 340 durchgeführten Bearbeitung des Werkstücks 75 verzichtet werden kann und die Überprüfung beim Ausschleusen des bearbeiteten Werkstücks 75 zusammen mit der Fördereinrichtung 55, 60 erfasst werden kann. Zusätzlich kann durch die Aufnahme aus unterschiedlichen Blickwinkeln durch die Kamera 965 ein besonders gutes, insbesondere teilräumliches Bild des Werkstücks 75 aufgenommen werden.

### Bezugszeichenliste

- 10: Planarantriebssystem
- 15: Planarmotorantriebseinrichtung
- 20: Bearbeitungsstation
- 25: Statormodulanordnung
- 30: erstes Statormodul
- 35: zweites Statormodul
- 40: Moduloberseite
- 45: Transportbereich
- 50: Arbeitsraum
- 55: erste Fördereinrichtung
- 60: zweite Fördereinrichtung
- 65: Basiseinheit
- 70: Werkstückträger
- 75: Werkstück
- 80: Gehäuse
- 85: erste Schleuseneinheit
- 90: zweite Schleuseneinheit
- 95: Bearbeitungseinheit
- 96: Bearbeitungsmodul

- 100: Sendemodul
- 105: elektromagnetische Strahlung
- 110: erstes Schleusengehäuse
- 115: erste Drehachse
- 120: erste Schleusenglocke
- 125: erster Schleusenantrieb
- 130: erster Gehäuseinnenraum
- 135: erste Gehäuseöffnung
- 140: zweite Gehäuseöffnung
- 145: erster Torabschnitt
- 150: erste Schleusenöffnung
- 155: erster Schleusenraum
- 160: erster Arbeitsbereich
- 165: erster Wartebereich
- 170: zweites Schleusengehäuse
- 175: zweite Schleusenglocke
- 180: zweiter Schleusenantrieb
- 185: zweite Drehachse
- 190: dritte Gehäuseöffnung
- 195: vierte Gehäuseöffnung

- 200: zweiter Gehäuseinnenraum
- 205: zweiter Schleusenraum
- 210: zweite Schleusenöffnung
- 215: zweiter Torabschnitt
- 220: weitere Fördereinrichtung

- 305: erster Verfahrensschritt
- 310: zweiter Verfahrensschritt
- 315: dritter Verfahrensschritt
- 320: vierter Verfahrensschritt
- 325: fünfter Verfahrensschritt
- 330: sechster Verfahrensschritt
- 335: siebter Verfahrensschritt
- 340: achter Verfahrensschritt
- 345: neunter Verfahrensschritt
- 350: zehnter Verfahrensschritt
- 355: elfter Verfahrensschritt
- 360: zwölfter Verfahrensschritt
- 365: dreizehnter Verfahrensschritt
- 370: vierzehnter Verfahrensschritt
- 375: fünfzehnter Verfahrensschritt

- 500: erstes Schleusengehäuseteil
- 505: zweites Schleusengehäuseteil
- 510: Schleusengehäusedeckel
- 515: Schleusengehäuseboden
- 520: erste Stirnseite
- 525: zweite Stirnseite
- 530: erste Seitenfläche
- 535: zweite Seitenfläche
- 540: Antriebsflansch
- 545: Unterseite
- 550: erster Gehäusesteg
- 555: Durchgangsöffnung
- 560: zweiter Gehäuseteg
- 565: erste Führungsnut
- 570: Dichtungsaufnahme
- 575: Dichtung
- 576: erste Wandung
- 580: zweite Wandung
- 585: erstes Trägerelement
- 590: zweites Trägerelement
- 595: erster Wandungsabschnitt

- 600: drittes Trägerelement
- 605: viertes Trägerelement
- 610: zweiter Wandungsabschnitt
- 611: erste Spaltabdeckung
- 612: zweite Spaltabdeckung
- 613: erste Innenfläche
- 614: Schraubverbindung
- 615: freies Ende (der Schleusenglocke)
- 616: Scheibenabschnitt
- 617: dritte Spaltabdeckung
- 618: vierte Spaltabdeckung
- 619: zweite Innenfläche
- 620: Kupplungsaufnahme
- 625: Sockel
- 630: Ringbereich
- 635: Ausbuchtung
- 636: Bohrung
- 640: äußere Umfangsseite
- 645: Spalt
- 646: Blende
- 650: zweite Führungsnut
- 655: Lageraufnahme
- 660: Anschlussflansch
- 665: Kupplung
- 670: Lager
- 675: erstes Kupplungselement
- 680: zweites Kupplungselement
- 685: Halter
- 690: Befestigungsabschnitt
- 695: Maschinenbett

- 700: Halteabschnitt
- 705: Werkstückbearbeitungsträger
- 710: erste Werkstückaufnahme
- 715: zweite Werkstückaufnahme

- 800: erster Stationsabschnitt
- 805: zweiter Stationsabschnitt
- 810: dritte Schleuseneinheit
- 815: vierte Schleuseneinheit
- 820: zweiter Arbeitsbereich
- 825: zweiter Wartebereich
- 830: Symmetrieebene
- 835: dritte Schleusenglocke
- 840: drittes Schleusengehäuse
- 845: dritter Schleusenantrieb
- 850: fünfte Gehäuseöffnung
- 855: sechste Gehäuseöffnung
- 860: dritter Schleusenraum
- 865: dritter Torabschnitt
- 870: dritte Schleusenöffnung
- 875: dritte Drehachse
- 880: vierte Schleusenglocke
- 885: viertes Schleusengehäuse
- 890: vierter Schleusenantrieb
- 895: siebte Gehäuseöffnung

- 900: achte Gehäuseöffnung
- 905: vierter Schleusenraum
- 910: vierter Torabschnitt
- 915: vierte Schleusenöffnung
- 920: vierte Drehachse
- 930: erster Bewegungspfad
- 935: zweiter Bewegungspfad
- 955: dritte Fördereinrichtung
- 960: vierte Fördereinrichtung
- 965: Kamera
- 970: Erfassungsbereich
- α: erster Winkel
- β: zweiter Winkel

## Patentansprüche

1. Planarantriebssystem (10)
- aufweisend wenigstens eine Planarmotorantriebseinrichtung (15) und eine Bearbeitungsstation (20),
- wobei die Planarmotorantriebseinrichtung (15) eine Statormodulanordnung (25) mit wenigstens einem ersten Statormodul (30) und wenigstens einer an der Statormodulanordnung (25) angeordneten und durch die Statormodulanordnung (25) antreibbaren ersten Fördereinrichtung (55) aufweist,
- wobei die Bearbeitungsstation (20) wenigstens ein Gehäuse (80), wenigstens eine erste Schleuseneinheit (85) sowie eine Bearbeitungseinheit (95) aufweist,
- wobei die Bearbeitungsstation (20) an der Statormodulanordnung (25) angeordnet ist und die Statormodulanordnung (25) und die Bearbeitungsstation (20) einen gegenüber einem Transportbereich (45) abgetrennten Arbeitsraum (50) umschließen,
- wobei die erste Schleuseneinheit (85) ein erstes Schleusengehäuse (110) aufweist,
- wobei das erste Schleusengehäuse (110) eine dem Transportbereich (45) zugewandte erste Gehäuseöffnung (135) und eine dem Arbeitsraum (50) zugewandte und beabstandet zu der ersten Gehäuseöffnung (135) angeordnete zweite Gehäuseöffnung (140) aufweist,
**dadurch gekennzeichnet, dass**
- die erste Schleuseneinheit (85) eine in dem ersten Schleusengehäuse (110) um eine erste Drehachse (115) drehbar gelagerte erste Schleusenglocke (120) aufweist,
- wobei die erste Schleusenglocke (120) innenseitig einen ersten Schleusenraum (155) zumindest abschnittsweise umschließt, in dem die Fördereinrichtung (55) vollständig anordenbar ist, und eine einseitig angeordnete erste Schleusenöffnung (150) aufweist,
- wobei die erste Schleusenglocke (120) zwischen einem ersten Positionsbereich und einem in Umfangsrichtung um die erste Drehachse (115) verdrehten zweiten Positionsbereich verdrehbar ist,
- wobei in dem ersten Positionsbereich der ersten Schleusenglocke (120) die erste Schleusenöffnung (150) der ersten Gehäuseöffnung (135) zugewandt ist und der erste Schleusenraum (155) ausschließlich über die erste Gehäuseöffnung (135) zum Transportbereich (45) hin geöffnet ist,
- wobei in dem zweiten Positionsbereich der ersten Schleusenglocke (120) die erste Schleusenöffnung (150) der zweiten Gehäuseöffnung (140) zugewandt ist und der erste Schleusenraum (155) ausschließlich über die zweite Gehäuseöffnung (140) zum Arbeitsraum (50) hin geöffnet ist,
- wobei eine erste Position innerhalb des ersten Positionsbereichs und eine zweite Position innerhalb des zweiten Positionsbereich angeordnet ist,
- wobei in der ersten Position die erste Fördereinrichtung (55) zwischen dem ersten Schleusenraum (155) und dem Transportbereich (45) bewegbar ist,
- wobei in der zweiten Position die erste Fördereinrichtung (55) zwischen dem ersten Schleusenraum (155) und dem Arbeitsraum (50) bewegbar ist,
- wobei unabhängig von einer Ausrichtung der ersten Schleusenglocke (120) in Umfangsrichtung um die erste Drehachse (115) die erste Schleusenglocke (120) den Arbeitsraum (50) vom Transportbereich (45) abtrennt.

2. Planarantriebssystem (10) nach Anspruch 1,
- wobei die Bearbeitungseinheit (95) wenigstens ein Bearbeitungsmodul (96) aufweist, das zumindest abschnittsweise in dem Arbeitsraum (50) angeordnet ist,
- wobei das Bearbeitungsmodul (96) ausgebildet ist, ein mittels der ersten Fördereinrichtung (55) transportiertes Werkstück (75) zu bearbeiten,
- wobei die erste Schleuseneinheit (85) und das Gehäuse (80) ausgebildet sind, bei der Bearbeitung entstehende Emissionen zumindest teilweise in dem Arbeitsraum (50) unabhängig von der Ausrichtung der ersten Schleusenglocke (120) um die erste Drehachse (115) zu halten.

3. Planarantriebssystem (10) nach einem der vorhergehenden Ansprüche,
- wobei das erste Schleusengehäuse (110) eine Unterseite (545) aufweist,
- wobei die Unterseite (545) an der Statormodulanordnung (25) anliegt,
- wobei zwischen der Unterseite (545) und der ersten Gehäuseöffnung (135) das Gehäuse (80) einen ersten Gehäusesteg (550) aufweist,
- wobei der erste Gehäusesteg (550) auf der zur Unterseite (545) zugewandten Seite die erste Gehäuseöffnung (135) begrenzt,
- und/oder
- wobei zwischen der Unterseite (545) und der zweiten Gehäuseöffnung (140) das Gehäuse (80) einen zweiten Gehäusesteg (560) aufweist,
- wobei der zweite Gehäusesteg (560) auf der zur Unterseite (545) zugewandten Seite die zweite Gehäuseöffnung (140) begrenzt.

4. Planarantriebssystem (10) nach einem der vorhergehenden Ansprüche,
- wobei das erste Schleusengehäuse (110) eine erste Führungsnut (565) aufweist,
- wobei sich die erste Führungsnut (565) auf einer Kreisbahn um die erste Drehachse (115) erstreckt,
- wobei die erste Führungsnut (565) auf der der ersten Schleusenglocke (120) zugewandten Seite offen ausgebildet ist,
- wobei die erste Schleusenglocke (120) abschnittsweise in die erste Führungsnut (565) eingreift.

5. Planarantriebssystem (10) nach Anspruch 3 und Anspruch 4,
- wobei sich die erste Führungsnut (565) zumindest abschnittweise entlang des ersten Gehäusestegs (550) auf einer zur ersten Gehäuseöffnung (135) zugewandten Seite des ersten Gehäusestegs (550) und/oder des zweiten Gehäusestegs (560) auf einer der zweiten Gehäuseöffnung (140) zugewandten Seite des zweiten Gehäusestegs (550) erstreckt.

6. Planarantriebssystem (10) nach einem der vorhergehenden Ansprüche,
- wobei die Bearbeitungsstation (20) eine zweite Schleuseneinheit (90) aufweist,
- wobei die zweite Schleuseneinheit (90) versetzt zu der ersten Schleuseneinheit (85) angeordnet ist,
- wobei die zweite Schleuseneinheit (90) ein zweites Schleusengehäuse (170) und eine in dem zweiten Schleusengehäuse (170) um eine zweite Drehachse (185) drehbar gelagerte zweite Schleusenglocke (175) aufweist,
- wobei das zweite Schleusengehäuse (170) eine dem Transportbereich (45) zugewandte dritte Gehäuseöffnung (190) und eine dem Arbeitsraum (50) zugewandte und beabstandet zu der dritten Gehäuseöffnung (190) angeordnete vierte Gehäuseöffnung (195) aufweist,
- wobei die zweite Schleusenglocke (175) innenseitig einen zweiten Schleusenraum (205) zumindest abschnittsweise umschließt, in dem die erste Fördereinrichtung (55) vollständig anordenbar ist, und eine einseitig angeordnete zweite Schleusenöffnung (210) aufweist,
- wobei die zweite Schleusenglocke (175) zwischen einem dritten Positionsbereich und einem in Umfangsrichtung um die zweite Drehachse (185) verdrehten vierten Positionsbereich verdrehbar ist,
- wobei in dem dritten Positionsbereich der zweiten Schleusenglocke (175) die zweite Schleusenöffnung (210) der dritten Gehäuseöffnung (190) zugewandt ist und der zweite Schleusenraum (205) ausschließlich über die dritte Gehäuseöffnung (190) zum Transportbereich (45) hin geöffnet ist,
- wobei in dem vierten Positionsbereich der zweiten Schleusenglocke (175) die zweite Schleusenöffnung (210) der vierten Gehäuseöffnung (195) zugewandt ist und der zweite Schleusenraum (205) ausschließlich über die vierte Gehäuseöffnung (195) zum Arbeitsraum (50) hin geöffnet ist,
- wobei eine dritte Position innerhalb des dritten Positionsbereichs und eine vierte Position innerhalb des vierten Positionsbereichs angeordnet ist,
- wobei in der dritten Position die erste Fördereinrichtung (55) zwischen dem zweiten Schleusenraum (205) und dem Transportbereich (45) bewegbar ist,
- wobei in der vierten Position die erste Fördereinrichtung (55) zwischen dem zweiten Schleusenraum (205) und dem Arbeitsraum (50) bewegbar ist,
- wobei unabhängig von einer Ausrichtung der zweiten Schleusenglocke (175) in Umfangsrichtung um die zweite Drehachse (185) die zweite Schleusenglocke (175) den Arbeitsraum (50) vom Transportbereich (45) abtrennt.

7. Planarantriebssystem (10) nach Anspruch 6,
- wobei die erste Schleuseneinheit (85) und die zweite Schleuseneinheit (90) nebeneinander angeordnet sind,
- wobei der Arbeitsraum (50) in einen ersten Wartebereich (165) und einen versetzt zu dem ersten Wartebereich (165) angeordneten ersten Arbeitsbereich (160) unterteilt ist,
- wobei der erste Wartebereich (165) an der erste Schleuseneinheit (85) und der erste Arbeitsbereich (160) anschließend an die Bearbeitungseinheit (95) angeordnet ist.

8. Planarantriebssystem (10) nach einem der vorhergehenden Ansprüche,
- wobei die erste Schleuseneinheit (85) eine Kamera (965) aufweist,
- wobei ein Erfassungsbereich (970) der Kamera (965) in Richtung des ersten Schleusenraums (155) gerichtet ist.

9. Planarantriebssystem (10) nach einem der vorhergehenden Ansprüche,
- wobei die erste Schleuseneinheit (85) wenigstens eine Dichtung (575) aufweist,
- wobei die Dichtung (575) in einem Spalt (645) zwischen der ersten Schleusenglocke (120) und dem ersten Schleusengehäuse (110) angeordnet ist,
- wobei die Dichtung (575) ausgebildet ist, den Arbeitsraum (50) gegenüber dem Transportbereich (45) zumindest abschnittsweise fluidisch abzutrennen,
- wobei vorzugsweise die Dichtung (575) aufblasbar ausgebildet ist.

10. Planarantriebssystem (10) nach einem der vorhergehenden Ansprüche,
- wobei die erste Schleusenglocke (120) in einen Zwischenpositionsbereich zwischen dem ersten Positionsbereich und dem zweiten Positionsbereich um die erste Drehachse (115) verdrehbar ist,
- wobei in dem Zwischenpositionsbereich die erste Schleusenglocke (120) auf der zum Arbeitsraum (50) zugewandten Seite den ersten Schleusenraum (155) gegenüber dem Arbeitsraum (50) und auf der zum Transportbereich (45) zugewandten Seite den ersten Schleusenraum (155) gegenüber dem Transportbereich (45) verschließt.

11. Verfahren zum Betrieb eines Planarantriebssystems (10) nach einem der vorhergehenden Ansprüche,
- wobei das erste Statormodul (30) bestromt wird und magnetisch mit der ersten Fördereinrichtung (55) zum Antrieb der ersten Fördereinrichtung (55) gekoppelt wird,
- wobei die erste Fördereinrichtung (55) im Transportbereich (45) angeordnet ist und mit einem Werkstück (75) bestückt wird,
- wobei die erste Schleusenglocke (120) um die erste Drehachse (115) in die erste Position gedreht wird,
- wobei die erste Fördereinrichtung (55) in der ersten Position aus dem Transportbereich (45) in den ersten Schleusenraum (155) bewegt wird,
- wobei die erste Schleusenglocke (120) um die erste Drehachse (115) in die zweite Position gedreht wird,
- wobei die erste Fördereinrichtung (55) aus dem ersten Schleusenraum (155) in den Arbeitsraum (50) und an die Bearbeitungseinheit (95) bewegt wird,
- wobei die Bearbeitungseinheit (95) das Werkstück (75) bearbeitet.

12. Verfahren nach Anspruch 11 zum Betrieb eines Planarantriebssystems (10) nach Anspruch 2,
- wobei das Bearbeitungsmodul (96) aktiviert wird und das Werkstück (75) bearbeitet,
- wobei die erste Schleuseneinheit (85) unabhängig von der Verdrehung der ersten Schleusenglocke (120) um die erste Drehachse (115) bei der Bearbeitung des Werkstücks (75) anfallende Emissionen zumindest teilweise an einem Austreten, insbesondere einem direkten Austreten, aus dem Arbeitsraum (50) in den Transportbereich (45) hindert.

13. Verfahren nach Anspruch 11 oder 12,
- wobei die magnetische Kopplung zwischen dem ersten Statormodul (30) und der ersten Fördereinrichtung (55) derart ausgebildet wird, dass die erste Fördereinrichtung (55) berührungslos an der Statormodulanordnung (25) schwebend bewegt wird,
- wobei beim Eintritt der ersten Fördereinrichtung (55) in den ersten Schleusenraum (155) die erste Fördereinrichtung (55) an dem ersten Gehäusesteg (550) oder dem zweiten Gehäusesteg (560) berührungslos schwebend vorbeibewegt wird.

14. Verfahren nach einem der Ansprüche 11 bis 13 zum Betrieb des Planarantriebssystems (10) gemäß Anspruch 7,
- wobei die erste Fördereinrichtung (55) nach Ausfahrt aus dem ersten Schleusenraum (155) entlang einer ersten Richtung in den ersten Wartebereich (165) bewegt wird,
- wobei die erste Fördereinrichtung (55) in dem ersten Wartebereich (165) bewegt wird, vorzugsweise gestoppt wird, und/oder eine Bewegungsrichtung der ersten Fördereinrichtung (55) in dem ersten Wartebereich (165) geändert wird und/oder die erste Fördereinrichtung (55) gedreht wird,
- wobei die erste Fördereinrichtung (55) von dem ersten Wartebereich (165) zu dem ersten Arbeitsbereich (160) bewegt wird,
- wobei in dem ersten Arbeitsbereich (160) das Werkstück (75) bearbeitet wird,
- wobei die zweite Schleusenglocke (175) um die zweite Drehachse (185) in die vierte Position gedreht wird,
- wobei die erste Fördereinrichtung (55) nach Abschluss der Bearbeitung des Werkstücks (75) in den zweiten Schleusenraum (205) bewegt wird,
- wobei die zweite Schleusenglocke (175) um die zweite Drehachse (185) aus der vierten Position in die dritte Position gedreht wird,
- wobei die erste Fördereinrichtung (55) aus dem zweiten Schleusenraum (205) über die dritte Gehäuseöffnung (190) in den Transportbereich (45) bewegt wird.

15. Verfahren nach einem der Ansprüche 11 bis 14 zum Betrieb des Planarantriebssystems (10) nach Anspruch 8,
- wobei die Dichtung (575) mit einem Druckfluid druckbeaufschlagt befüllt wird, sodass die Dichtung (575) an der ersten Schleusenglocke (120) anliegt,
- wobei zeitlich vor Verdrehen der ersten Schleusenglocke (120) das Druckfluid zumindest teilweise aus der Dichtung (575) entlassen wird, sodass die Dichtung (575) entlastet ist,
- wobei vorzugweise in entlastetem Zustand ein Spalt (645) zwischen der ersten Schleusenglocke (120) und der Dichtung (575) ausgebildet wird,
- wobei zeitlich nach Entlastung der Dichtung (575) die erste Schleusenglocke (120) zwischen der ersten Position und der zweiten Position verdreht wird,
- wobei nach Erreichen der ersten Position oder der zweiten Position die Dichtung (575) erneut mit dem Druckfluid druckbeaufschlagt befüllt wird, sodass die Dichtung (575) an der ersten Schleusenglocke (120) anliegt.

## Claims

1. A planar drive system (10)
- comprising at least a planar motor drive device (15) and a processing station (20),
- wherein the planar motor drive device (15) comprises a stator module arrangement (25) having at least a first stator module (30) and at least a first conveyor device (55) arranged on the stator module arrangement (25) and drivable by the stator module arrangement (25),
- wherein the processing station (20) comprises at least a housing (80), at least a first lock unit (85), and a processing unit (95),
- wherein the processing station (20) is arranged on the stator module assembly (25) and the stator module assembly (25) and the processing station (20) enclose a working space (50) separated from a transport area (45),
- wherein the first lock unit (85) comprises a first lock housing (110),
- wherein the first lock housing (110) comprises a first housing opening (135) facing the transport area (45) and a second housing opening (140) facing the working space (50) and arranged at a distance from the first housing opening (135),
**characterized in that**
- wherein the first lock unit (85) comprises a first lock bell (120) mounted in the first lock housing (110) so as to be rotatable about a first axis of rotation (115),
- wherein the first lock bell (120) encloses, at least in sections, a first lock chamber (155) on the inside, in which the conveyor device (55) may be arranged in its entirety, and comprises a first lock opening (150) arranged on one side,
- wherein the first lock bell (120) may be rotated between a first position range and a second position range rotated in the circumferential direction about the first axis of rotation (115),
- wherein, in the first position range of the first lock bell (120), the first lock opening (150) faces the first housing opening (135) and the first lock chamber (155) is opened towards the transport area (45) exclusively via the first housing opening (135),
- wherein, in the second position range of the first lock bell (120), the first lock opening (150) faces the second housing opening (140) and the first lock chamber (155) is opened towards the working space (50) exclusively via the second housing opening (140),
- wherein a first position is arranged within the first position range and a second position is arranged within the second position range,
- wherein, in the first position, the first conveyor device (55) is movable between the first lock chamber (155) and the transport area (45),
- wherein, in the second position, the first conveyor device (55) is movable between the first lock chamber (155) and the working space (50),
- wherein, regardless of the orientation of the first lock bell (120) in the circumferential direction around the first axis of rotation (115), the first lock bell (120) separates the working space (50) from the transport area (45).

2. The planar drive system (10) according to claim 1,
- wherein the processing unit (95) comprises at least a processing module (96) which is at least in sections arranged in the working space (50),
- wherein the processing module (96) is embodied to process a workpiece (75) transported by the first conveyor device (55),
- wherein the first lock unit (85) and the housing (80) are embodied to keep emissions generated during processing at least partially in the working space (50) regardless of the orientation of the first lock bell (120) around the first axis of rotation (115).

3. The planar drive system (10) according to any one of the preceding claims,
- wherein the first lock housing (110) comprises an underside (545),
- wherein the underside (545) abuts on the stator module assembly (25),
- wherein between the underside (545) and the first housing opening (135), the housing (80) comprises a first housing bridge (550),
- wherein the first housing bridge (550) defines the first housing opening (135) on the side facing the underside (545),
- and/or
- wherein the housing (80) comprises a second housing bridge (560) between the underside (545) and the second housing opening (140),
- wherein the second housing bridge (560) defines the second housing opening (140) on the side facing the underside (545).

4. The planar drive system (10) according to any one of the preceding claims,
- wherein the first lock housing (110) comprises a first guide groove (565),
- wherein the first guide groove (565) extends on a circular path around the first axis of rotation (115),
- wherein the first guide groove (565) is open on the side facing the first lock bell (120),
- wherein the first lock bell (120) engages the first guide groove (565) in sections.

5. The planar drive system (10) according to claim 3 and claim 4,
- wherein the first guide groove (565) extends at least in sections along the first housing bridge (550) on a side of the first housing bridge (550) facing the first housing opening (135) and/or along the second housing bridge (560) on a side of the second housing bridge (560) facing the second housing opening (140).

6. The planar drive system (10) according to any one of the preceding claims,
- wherein the processing station (20) comprises a second lock unit (90),
- wherein the second lock unit (90) is arranged at an offset with regard to the first lock unit (85),
- wherein the second lock unit (90) comprises a second lock housing (170) and a second lock bell (175) rotatably mounted in the second lock housing (170) about a second axis of rotation (185),
- wherein the second lock housing (170) comprises a third housing opening (190) facing the transport area (45) and a fourth housing opening (195) facing the working space (50) and arranged at a distance from the third housing opening (190),
- wherein the second lock bell (175) encloses a second lock chamber (205) at least in sections on the inside, in which the first conveyor device (55) may be arranged completely, and comprises a second lock opening (210) arranged on one side,
- wherein the second lock bell (175) may be rotated between a third position range and a fourth position range rotated in the circumferential direction about the second axis of rotation (185),
- wherein, in the third position range of the second lock bell (175), the second lock opening (210) faces the third housing opening (190) and the second lock chamber (205) is opened towards the transport area (45) exclusively via the third housing opening (190),
- wherein, in the fourth position range of the second lock bell (175), the second lock opening (210) faces the fourth housing opening (195) and the second lock chamber (205) is opened towards the working space (50) exclusively via the fourth housing opening (195),
- wherein a third position is arranged within the third position range and a fourth position is arranged within the fourth position range,
- wherein, in the third position, the first conveyor device (55) is movable between the second lock chamber (205) and the transport area (45),
- wherein, in the fourth position, the first conveyor device (55) is movable between the second lock chamber (205) and the working space (50),
- wherein, regardless of the orientation of the second lock bell (175) in the circumferential direction around the second axis of rotation (185), the second lock bell (175) separates the working space (50) from the transport area (45).

7. The planar drive system (10) according to claim 6,
- wherein the first lock unit (85) and the second lock unit (90) are arranged next to each other,
- wherein the working space (50) is divided up into a first waiting area (165) and a first working space (160) arranged at an offset with regard to the first waiting area (165),
- wherein the first waiting area (165) is arranged at the first lock unit (85) and the first working space (160) is arranged adjacent to the processing unit (95).

8. The planar drive system (10) according to any one of the preceding claims,
- wherein the first lock unit (85) comprises a camera (965),
- wherein a detection area (970) of the camera (965) is directed toward the first airlock chamber (155).

9. The planar drive system (10) according to any one of the preceding claims,
- wherein the first lock unit (85) comprises at least a seal (575),
- wherein the seal (575) is arranged in a gap (645) between the first lock bell (120) and the first lock housing (110),
- wherein the seal (575) is at least in sections embodied to fluidically separate the working space (50) from the transport area (45),
- wherein the seal (575) is preferably inflatable.

10. The planar drive system (10) according to any one of the preceding claims,
- wherein the first lock bell (120) may be rotated around the first axis of rotation (115) into an intermediate position range between the first position range and the second position range,
- wherein, in the intermediate position range, the first lock bell (120) closes the first lock chamber (155) off from the working space (50) on the side facing the working space (50) and closes the first lock chamber (155) off from the transport area (45) on the side facing the transport area (45).

11. A method for operating a planar drive system (10) according to any one of the preceding claims,
- wherein the first stator module (30) is energized and magnetically coupled to the first conveyor device (55) for driving the first conveyor device (55),
- wherein the first conveyor device (55) is arranged in the transport area (45) and is loaded with a workpiece (75),
- wherein the first lock bell (120) is rotated about the first axis of rotation (115) into the first position,
- wherein the first conveyor device (55) is moved from the transport area (45) into the first lock chamber (155) in the first position,
- wherein the first lock bell (120) is rotated about the first axis of rotation (115) into the second position,
- wherein the first conveyor device (55) is moved from the first lock chamber (155) into the working space (50) and to the processing unit (95),
- wherein the processing unit (95) processes the workpiece (75).

12. The method according to claim 11 for operating a planar drive system (10) according to claim 2,
- wherein the processing module (96) is activated and processes the workpiece (75),
- wherein the first lock unit (85) prevents emissions arising during the processing of the workpiece (75) at least partially from escaping, in particular directly escaping, from the working space (50) into the transport area (45) independently of the rotation of the first lock bell (120) about the first axis of rotation (115).

13. The method according to claim 11 or 12,
- wherein the magnetic coupling between the first stator module (30) and the first conveyor device (55) is embodied in such a way that the first conveyor device (55) is moved in a contactless manner, floating on the stator module arrangement (25),
- wherein, upon entry of the first conveyor device (55) into the first lock chamber (155), the first conveyor device (55) is moved past the first housing bridge (550) or the second housing bridge (560) in a contactless, floating manner.

14. The method according to any one of claims 11 to 13 for operating the planar drive system (10) according to claim 7,
- wherein the first conveyor device (55) is moved along a first direction into the first waiting area (165) after exiting the first lock chamber (155),
- wherein the first conveyor device (55) is moved in the first waiting area (165), is preferably stopped, and/or a direction of movement of the first conveyor device (55) is changed in the first waiting area (165) and/or the first conveyor device (55) is rotated,
- wherein the first conveyor device (55) is moved from the first waiting area (165) to the first working space (160),
- wherein the workpiece (75) is processed in the first working space (160),
- wherein the second lock bell (175) is rotated about the second axis of rotation (185) into the fourth position,
- wherein the first conveyor device (55) is moved into the second lock chamber (205) after completion of the processing of the workpiece (75),
- wherein the second lock bell (175) is rotated about the second axis of rotation (185) from the fourth position into the third position,
- wherein the first conveyor device (55) is moved from the second lock chamber (205) via the third housing opening (190) into the transport area (45).

15. The method according to any one of claims 11 to 14 for operating the planar drive system (10) according to claim 8,
- wherein the seal (575) is pressure-charged with a pressure fluid so that the seal (575) rests against the first lock bell (120),
- wherein, prior to rotating the first lock bell (120), the pressure fluid is at least partially released from the seal (575) so that the seal (575) is relieved,
- wherein, preferably in the relieved state, a gap (645) is embodied between the first lock bell (120) and the seal (575),
- wherein, after the seal (575) has been relieved in a timely manner, the first lock bell (120) is rotated between the first position and the second position,
- wherein, after reaching the first position or the second position, the seal (575) is again pressure-charged with the pressure fluid so that the seal (575) rests against the first lock bell (120).

## Revendications

1. Système d'entraînement planaire (10)
- possédant au moins un dispositif d'entraînement à moteur planaire (15) et une station d'usinage (20),
- le dispositif d'entraînement à moteur planaire (15) possédant un arrangement de modules statoriques (25) comprenant au moins un premier module statorique (30) et au moins un premier dispositif de transport (55) disposé sur l'arrangement de modules statoriques (25) et pouvant être entraîné par l'arrangement de modules statoriques (25),
- la station d'usinage (20) possédant au moins un boîtier (80), au moins une première unité de sas (85) ainsi qu'une unité d'usinage (95),
- la station d'usinage (20) étant disposé sur l'arrangement de modules statoriques (25) et l'arrangement de modules statoriques (25) et la station d'usinage (20) entourant un espace de travail (50) séparé d'une zone de transport (45),
- la première unité de sas (85) possédant un premier boîtier de sas (110),
- le premier boîtier de sas (110) possédant une première ouverture de boîtier (135) qui fait face à la zone de transport (45) et une deuxième ouverture de boîtier (140) qui fait face à l'espace de travail (50) et est disposée à distance de la première ouverture de boîtier (135),
**caractérisé en ce que**
- la première unité de sas (85) possède une première cloche de sas (120) montée dans le premier boîtier de sas (110) de manière à pouvoir tourner autour d'un premier axe de rotation (115),
- la première cloche de sas (120) entourant du côté intérieur, au moins par portions, un premier espace de sas (155) dans lequel le dispositif de transport (55) peut être entièrement disposé, et possédant une première ouverture de sas (150) disposée d'un côté,
- la première cloche de sas (120) pouvant effectuer une torsion entre une première plage de positions et une deuxième plage de positions, décalée dans la direction circonférentielle autour du premier axe de rotation (115),
- dans la première plage de positions de la première cloche de sas (120), la première ouverture de sas (150) faisant face à la première ouverture de boîtier (135) et le premier espace de sas (155) étant ouvert vers la zone de transport (45) exclusivement par le biais de la première ouverture de boîtier (135),
- dans la deuxième plage de positions de la première cloche de sas (120), la première ouverture de sas (150) faisant face à la deuxième ouverture de boîtier (140) et le premier espace de sas (155) étant ouvert vers l'espace de travail (50) exclusivement par le biais de la deuxième ouverture de boîtier (140),
- une première position étant située à l'intérieur de la première plage de positions et une deuxième position à l'intérieur de la deuxième plage de positions,
- dans la première position, le premier dispositif de transport (55) pouvant se déplacer entre le premier espace de sas (155) et la zone de transport (45),
- dans la deuxième position, le premier dispositif de transport (55) pouvant se déplacer entre le premier espace de sas (155) et l'espace de travail (50),
- indépendamment d'une orientation de la première cloche de sas (120) dans la direction circonférentielle autour du premier axe de rotation (115), la première cloche de sas (120) séparant l'espace de travail (50) de la zone de transport (45).

2. Système d'entraînement planaire (10) selon la revendication 1,
- l'unité d'usinage (95) possédant au moins un module d'usinage (96) qui est disposé au moins par portions dans l'espace de travail (50),
- le module d'usinage (96) étant configuré pour usiner une pièce ouvrée (75) transportée au moyen du premier dispositif de transport (55),
- la première unité de sas (85) et le boîtier (80) étant configurés pour maintenir les émissions produites lors de l'usinage au moins partiellement dans l'espace de travail (50) indépendamment de l'orientation de la première cloche de sas (120) autour du premier axe de rotation (115).

3. Système d'entraînement planaire (10) selon l'une des revendications précédentes,
- le premier boîtier de sas (110) présentant un côté inférieur (545),
- le côté inférieur (545) étant en appui contre l'arrangement de modules statoriques (25)
- le boîtier (80) possédant une première nervure de boîtier (550) entre le côté inférieur (545) et la première ouverture de boîtier (135),
- la première nervure de boîtier (550) délimitant la première ouverture de boîtier (135) sur le côté qui fait face au côté inférieur (545),
et/ou
- le boîtier (80) possédant une deuxième nervure de boîtier (560) entre le côté inférieur (545) et la deuxième ouverture de boîtier (140),
- la deuxième nervure de boîtier (560) délimitant la deuxième ouverture de boîtier (140) sur le côté qui fait face au côté inférieur (545).

4. Système d'entraînement planaire (10) selon l'une des revendications précédentes,
- le premier boîtier de sas (110) possédant une première rainure de guidage (565),
- la première rainure de guidage (565) s'étendant sur une trajectoire circulaire autour du premier axe de rotation (115),
- la première rainure de guidage (565) étant réalisée ouverte sur le côté qui fait face à la première cloche de sas (120),
- la première cloche de sas (120) venant en prise par portions dans la première rainure de guidage (565).

5. Système d'entraînement planaire (10) selon la revendication 3 et la revendication 4,
- la première rainure de guidage (565) s'étendant au moins par portions le long de la première nervure de boîtier (550) sur un côté de la première nervure de boîtier (550) qui fait face à la première ouverture de boîtier (135) et/ou de la deuxième nervure de boîtier (560) sur un côté de la deuxième nervure de boîtier (560) qui fait face à la deuxième ouverture de boîtier (140).

6. Système d'entraînement planaire (10) selon l'une des revendications précédentes,
- la station d'usinage (20) possédant une deuxième unité de sas (90),
- la deuxième unité de sas (90) étant disposée décalée par rapport à la première unité de sas (85),
- la deuxième unité de sas (90) possédant un deuxième boîtier de sas (170) et une deuxième cloche de sas (175) montée dans le deuxième boîtier de sas (170) de manière à pouvoir tourner autour d'un deuxième axe de rotation (185),
- le deuxième boîtier de sas (170) possédant une troisième ouverture de boîtier (190) qui fait face à la zone de transport (45) et une quatrième ouverture de boîtier (195) qui fait face à l'espace de travail (50) et est disposée à distance de la troisième ouverture de boîtier (190),
- la deuxième cloche de sas (175) entourant du côté intérieur, au moins par portions, un deuxième espace de sas (205) dans lequel le premier dispositif de transport (55) peut être entièrement disposé, et possédant une deuxième ouverture de sas (210) disposée d'un côté,
- la deuxième cloche de sas (175) pouvant effectuer une torsion entre une troisième plage de positions et une quatrième plage de positions, décalée dans la direction circonférentielle autour du deuxième axe de rotation (185),
- dans la troisième plage de positions de la deuxième cloche de sas (175), la deuxième ouverture de sas (210) faisant face à la troisième ouverture de boîtier (190) et le deuxième espace de sas (205) étant ouvert vers la zone de transport (45) exclusivement par le biais de la troisième ouverture de boîtier (190),
- dans la quatrième plage de positions de la deuxième cloche de sas (175), la deuxième ouverture de sas (210) faisant face à la quatrième ouverture de boîtier (195) et le deuxième espace de sas (205) étant ouvert vers l'espace de travail (50) exclusivement par le biais de la quatrième ouverture de boîtier (195),
- une troisième position étant située à l'intérieur de la troisième plage de positions et une quatrième position à l'intérieur de la quatrième plage de positions,
- dans la troisième position, le premier dispositif de transport (55) pouvant se déplacer entre le deuxième espace de sas (205) et la zone de transport (45),
- dans la quatrième position, le premier dispositif de transport (55) pouvant se déplacer entre le deuxième espace de sas (205) et l'espace de travail (50),
- indépendamment d'une orientation de la deuxième cloche de sas (175) dans la direction circonférentielle autour du deuxième axe de rotation (185), la deuxième cloche de sas (175) séparant l'espace de travail (50) de la zone de transport (45).

7. Système d'entraînement planaire (10) selon la revendication 6,
- la première unité de sas (85) et la deuxième unité de sas (90) étant disposées l'une à côté de l'autre,
- l'espace de travail (50) étant subdivisé en une première zone d'attente (165) et une première zone de travail (160) décalée par rapport à la première zone d'attente (165),
- la première zone d'attente (165) étant disposée au niveau de la première unité de sas (85) et la première zone de travail (160) étant disposée rattachée à l'unité d'usinage (95).

8. Système d'entraînement planaire (10) selon l'une des revendications précédentes,
- la première unité de sas (85) possédant une caméra (965),
- une zone de capture (970) de la caméra (965) étant dirigée dans la direction du premier espace de sas (155).

9. Système d'entraînement planaire (10) selon l'une des revendications précédentes,
- la première unité de sas (85) possédant au moins une garniture d'étanchéité (575),
- la garniture d'étanchéité (575) étant disposée dans un interstice (645) entre la première cloche de sas (120) et le premier boîtier de sas (110),
- la garniture d'étanchéité (575) étant configurée pour séparer fluidiquement l'espace de travail (50) par rapport à la zone de transport (45) au moins par portions,
- la garniture d'étanchéité (575) étant de préférence configurée pour être gonflable.

10. Système d'entraînement planaire (10) selon l'une des revendications précédentes,
- la première cloche de sas (120) pouvant effectuer une torsion autour du premier axe de rotation (115) dans une plage de positions intermédiaire entre la première plage de positions et la deuxième plage de positions,
- dans la plage de positions intermédiaire, la première cloche de sas (120) fermant, du côté qui fait face à l'espace de travail (50), le premier espace de sas (155) par rapport à l'espace de travail (50) et, du côté qui fait face à la zone de transport (45), le premier espace de sas (155) par rapport à la zone de transport (45).

11. Procédé pour faire fonctionner un système d'entraînement planaire (10) selon l'une des revendications précédentes,
- le premier module statorique (30) étant alimenté électriquement et couplé magnétiquement au premier dispositif de transport (55) afin d'entraîner le premier dispositif de transport (55),
- le premier dispositif de transport (55) étant disposé dans la zone de transport (45) et équipé d'une pièce ouvrée (75),
- la première cloche de sas (120) étant tournée autour du premier axe de rotation (115) dans la première position,
- le premier dispositif de transport (55) dans la première position étant déplacé depuis la zone de transport (45) dans le premier espace de sas (155),
- la première cloche de sas (120) étant tournée autour du premier axe de rotation (115) dans la deuxième position,
- le premier dispositif de transport (55) étant déplacé du premier espace de sas (155) dans l'espace de travail (50) et vers l'unité d'usinage (95),
- l'unité d'usinage (95) usinant la pièce ouvrée (75).

12. Procédé selon la revendication 11 pour faire fonctionner un système d'entraînement planaire (10) selon la revendication 2,
- le module d'usinage (96) étant activé et la pièce ouvrée (75) étant usinée,
- la première unité de sas (85) empêchant au moins partiellement les émissions produites lors de l'usinage de la pièce ouvrée (75) de s'échapper, en particulier de s'échapper directement, hors de l'espace de travail (50) dans la zone de transport (45), indépendamment du décalage de la première cloche de sas (120) autour du premier axe de rotation (115).

13. Procédé selon la revendication 11 ou 12,
- le couplage magnétique entre le premier module statorique (30) et le premier dispositif de transport (55) étant configuré de telle sorte que le premier dispositif de transport (55) est déplacé de manière flottante vers l'arrangement de modules statoriques (25) sans contact,
- lors de la pénétration du premier dispositif de transport (55) dans le premier espace de sas (155), le premier dispositif de transport (55) état déplacé de manière flottante sans contact devant la première nervure de boîtier (550) ou la deuxième nervure de boîtier (560).

14. Procédé selon l'une des revendications 11 à 13 pour faire fonctionner le système d'entraînement planaire (10) selon la revendication 7,
- le premier dispositif de transport (55), après être sorti du premier espace de sas (155), étant déplacé le long d'une première direction dans la première zone d'attente (165),
- le premier dispositif de transport (55) étant déplacé, de préférence arrêté, dans la première zone d'attente (165) et/ou une direction de déplacement du premier dispositif de transport (55) dans la première zone d'attente (165) étant modifiée et/ou le premier dispositif de transport (55) étant tourné,
- le premier dispositif de transport (55) étant déplacé de la première zone d'attente (165) à la première zone de travail (160),
- la pièce ouvrée (75) étant usinée dans la première zone de travail (160),
- la deuxième cloche de sas (175) étant tournée autour du deuxième axe de rotation (185) dans la quatrième position,
- le premier dispositif de transport (55) étant déplacé dans le deuxième espace de sas (205) après l'achèvement de l'usinage de la pièce ouvrée (75),
- la deuxième cloche de sas (175) étant tournée autour du deuxième axe de rotation (185) de la quatrième position à la troisième position,
- le premier dispositif de transport (55) étant déplacé hors du deuxième espace de sas (205) par le biais de la troisième ouverture de boîtier (190) dans la zone de transport (45).

15. Procédé selon l'une des revendications 11 à 14 pour faire fonctionner le système d'entraînement planaire (10) selon la revendication 8,
- la garniture d'étanchéité (575) étant remplie d'un fluide sous pression avec mise en pression, de telle sorte que la garniture d'étanchéité (575) vienne en appui contre la première cloche de sas (120),
- le fluide sous pression étant libéré au moins partiellement de la garniture d'étanchéité (575) temporellement avant la torsion de la première cloche de sas (120), de sorte que la garniture d'étanchéité (575) est soulagée,
- un interstice (645) étant formé entre la première cloche de sas (120) et la garniture d'étanchéité (575), de préférence à l'état soulagé,
- la première cloche de sas (120) effectuant une torsion entre la première position et la deuxième position temporellement après le soulagement de la garniture d'étanchéité (575),
- après avoir atteint la première position ou la deuxième position, la garniture d'étanchéité (575) étant à nouveau remplie avec le fluide sous pression avec mise en pression, de sorte que la garniture d'étanchéité (575) vienne en appui contre la première cloche de sas (120).
